# EUROPEAN PATENT APPLICATION

(11) **EP 4 190 561 A1**
(43) Date of publication of application: **07.06.2023**
(21) Application number: 21849237.9
(22) Date of filing: 09.07.2021
(51) Int. Cl.: B41C 1/00, G03F 7/00, G03F 7/30

(54) **WASHING-OUT DEVICE AND WASHING-OUT METHOD**

(30) Priority: 31.07.2020 JP 2020130470; 28.01.2021 JP 2021012355
(71) Applicant: FUJIFILM Corporation, Tokyo 106-8620 (JP)
(72) Inventor: SONE Nobuyuki, Haibara-gun, Shizuoka 421-0396 (JP); HASHIGAYA Manabu, Haibara-gun, Shizuoka 421-0396 (JP); OSHIMA Atsushi, Haibara-gun, Shizuoka 421-0396 (JP); MOGI Fumio, Haibara-gun, Shizuoka 421-0396 (JP)
(74) Representative: HGF
(86) International application number: PCT/JP2021/025998
(87) International publication number: WO 2022/024724

(57) **Abstract**

Provided are a washout processor and a washing method in which a device configuration is small and processing such as development can be stably performed on a flexographic printing plate precursor. There is provided a washout processor that performs development using a washing solution while transporting an imagewise exposed flexographic printing plate precursor, the washout processor having a leader that fixes both of a leading end and a trailing end of the flexographic printing plate precursor and a tension applying unit that applies tension to the flexographic printing plate precursor.

## Description

### BACKGROUND OF THE INVENTION

### 1. Field of the Invention

The present invention relates to a washout processor and a washing method in which a flexographic printing plate precursor after imagewise exposure is developed using a washing solution.

### 2. Description of the Related Art

Currently, various types of methods are known as a developing method for a printing plate formed of a photosensitive resin plate. Examples of the developing method for a printing plate include a processing method of fixing the printing plate to a flat plate called a setter with a gluing agent or the like and a processing method of fixing the printing plate to a rotating drum. During development of the printing plate, it is necessary to fix the printing plate to a support fixing the printing plate such that wrinkles and loosening do not occur.

In a case of fixing the printing plate to the setter to which the gluing agent is applied, a roller is applied such that wrinkles on the printing plate are spread after temporarily fixing the printing plate to a glued surface, and air between the gluing agent and the printing plate is extruded and fixed.

In a case of fixing the printing plate to the rotating drum, for example, as in JP2012-63774A and JP2012-66584A, a leading end of the printing plate is fixed using a pin or a clamping mechanism provided on the surface of a drum and is fixed to be wound around the rotating drum so as to be closely attached while the printing plate is nipped at the rotating drum between a roller (laydown roller) and the rotating drum. In a state of being closely attached to the support, development treatment is performed on the printing plate.

In addition, for example, in JP2015-114558A, there is described a flexographic photosensitive resin plate manufacturing device comprising a washing section that consists of a cleaning zone for removing an unhardened portion of a photosensitive resin plate and a rinsing zone which is provided adjacent to the cleaning zone and cleans the surface of the photosensitive resin plate from which the unhardened portion is removed in the cleaning zone and a transporting unit that is provided below the washing section and is for transporting the photosensitive resin plate, in which a cleaning brush unit that has one or more cleaning brushes and a cleaning brush unit drive mechanism that drives the cleaning brush unit in a horizontal direction are included in the cleaning zone, a rotary brush unit that has one or more rotary brushes is included in the rinsing zone, and the transporting unit comprises an endless belt that has a fixing portion fixing the photosensitive resin plate and an endless belt drive mechanism that moves an endless belt in the horizontal direction below the washing section. The photosensitive resin plate is fixed to the endless belt by a pressure-sensitive adhesive layer as the fixing portion.

### SUMMARY OF THE INVENTION

As in JP2012-63774A and JP2012-66584A, in a device that fixes the printing plate to the rotating drum, the size of the drum depends on the size of the printing plate to be developed. For this reason, in order to develop a large printing plate, it is necessary to make the circumference of the drum long, and as a result, it is necessary to make the diameter of the drum large. In a case where the drum is large, a large amount of power is necessary to drive the drum as well, a motor to be driven or the like also increases in size, and the device increases in size.

In addition, since each of the steps is arranged in series in a horizontal transport type in the flexographic photosensitive resin plate manufacturing device described in JP2015-114558A, the device increases in size.

Further, in JP2015-114558A, the pressure-sensitive adhesive layer is used as the fixing portion, and in a case of detaching and attaching the photosensitive resin plate with respect to a transport belt after processing, there is a problem that the photosensitive resin plate buckles. In addition, in a case where the pressure-sensitive adhesive layer is used and is immersed in a cleaning liquid in the cleaning zone so as to be cleaned, there is also a possibility that the immersed photosensitive resin plate is detached from the adhesive layer. As described above, the photosensitive resin plate cannot be stably cleaned or the like.

An object of the present invention is to provide a washout processor and a washing method in which a device configuration is small and processing such as development can be stably performed on a flexographic printing plate precursor.

In order to achieve the object described above, according to an aspect of the present invention, there is provided a washout processor that performs development using a washing solution while transporting an imagewise exposed flexographic printing plate precursor, the washout processor comprising a leader that fixes both of a leading end and a trailing end of the flexographic printing plate precursor and a tension applying unit that applies tension to the flexographic printing plate precursor.

It is preferable that a developing portion that performs the development by removing a non-exposed portion of the flexographic printing plate precursor using the washing solution is further included. It is preferable that the developing portion has at least one cup brush that is used in the development and a driving unit that moves the cup brush in a width direction of the flexographic printing plate precursor with respect to a transport direction of the flexographic printing plate precursor.

It is preferable that the developing portion has at least two types of brushes used in the development, and among the at least two types of brushes, one type is a brush disposed in a direction perpendicular to a rotation axis with respect to the flexographic printing plate precursor.

It is preferable that the driving unit moves the cup brush in the width direction of the flexographic printing plate precursor by a distance of one third or more of a diameter of the cup brush.

It is preferable that bristles of the cup brush are bundled on a substrate, and the bristles are provided in a region other than a region where a radius is within 10 mm with respect to a center of the substrate.

It is preferable that wherein the bristles of the cup brush are provided in a region of 30% or more of the substrate.

It is preferable that a length of bristles of the cup brush or a brush is 5 to 25 mm.

It is preferable that a rinsing unit that supplies a rinsing liquid to the developed flexographic printing plate precursor taken out from the developing portion is further included, and the rinsing unit is provided on a downstream side of the developing portion in a traveling direction of the flexographic printing plate precursor.

It is preferable that a prerinsing unit that supplies the washing solution to the developed flexographic printing plate precursor, between the rinsing unit and the developing portion is further included.

It is preferable that the rinsing unit has a jetting type spray nozzle that supplies the rinsing liquid to the developed flexographic printing plate precursor, and the jetting type spray nozzle has a rinsing liquid supply amount of 0.3 to 7 kg/m² per unit area of the developed flexographic printing plate precursor to which the rinsing liquid is supplied.

It is preferable that the rinsing unit is provided such that the rinsing liquid is supplied to a liquid film generated by the washing solution remaining on the developed flexographic printing plate precursor taken out from the developing portion.

For a reason that the liquid film generated by the washing solution is likely to flow into the developing tank together with the rinsing liquid, a position to which the rinsing liquid is supplied is preferably 50 cm or lower, is more preferably 30 cm or lower, and is even more preferably 15 cm or lower from the liquid level of the washing solution.

It is preferable that the developing portion performs development using the washing solution stored in a developing tank, and the rinsing liquid supplied from the rinsing unit to the developed flexographic printing plate precursor flows into the developing tank of the developing portion.

It is preferable that the developing portion performs development using the washing solution stored in a developing tank, and the rinsing liquid supplied from the rinsing unit to the developed flexographic printing plate precursor and the washing solution supplied from the prerinsing unit to the developed flexographic printing plate precursor flow into the developing tank of the developing portion.

It is preferable that a developing portion that performs the development by removing a non-exposed portion of the flexographic printing plate precursor using the washing solution and a rinsing unit that supplies a rinsing liquid to the developed flexographic printing plate precursor taken out from the developing portion are further included. It is preferable that the rinsing unit is provided on a downstream side of the developing portion in a traveling direction of the flexographic printing plate precursor.

It is preferable that a prerinsing unit that supplies the washing solution to the developed flexographic printing plate precursor, between the rinsing unit and the developing portion is further included.

It is preferable that the rinsing unit has a jetting type spray nozzle that supplies the rinsing liquid to the developed flexographic printing plate precursor, and the jetting type spray nozzle has a rinsing liquid supply amount of 0.3 to 7 kg/m² per unit area of the developed flexographic printing plate precursor to which the rinsing liquid is supplied.

For example, the developing portion performs development using the washing solution stored in a developing tank, and the rinsing liquid supplied from the rinsing unit to the developed flexographic printing plate precursor flows into the developing tank of the developing portion.

In addition, for example, the developing portion performs development using the washing solution stored in a developing tank, and the rinsing liquid supplied from the rinsing unit to the developed flexographic printing plate precursor and the washing solution supplied from the prerinsing unit to the developed flexographic printing plate precursor flow into the developing tank of the developing portion.

It is preferable that the tension applying unit makes tension applied to the flexographic printing plate precursor after fixing the flexographic printing plate precursor to the leader higher than tension applied to the flexographic printing plate precursor in a case of fixing the flexographic printing plate precursor.

It is preferable that a curved transport passage through which the flexographic printing plate precursor is transported is further included. It is preferable that a turn bar that comes into contact with the flexographic printing plate precursor is provided at a bending part composed of the curved transport passage.

It is preferable that an attachment and detachment unit that fixes both of the leading end and the trailing end of the flexographic printing plate precursor to the leader and releases the fixing of the flexographic printing plate precursor by the leader is further included.

It is preferable that the turn bar provided at the curved transport passage moves forward and backward with respect to the curved transport passage.

It is preferable that the flexographic printing plate precursor is developed by being immersed in the washing solution.

It is preferable that a transport path for the flexographic printing plate precursor that includes a curved transport passage and a linear transport passage is further included. It is preferable that a transport direction of the flexographic printing plate precursor includes an upward direction and a downward direction.

It is preferable that the flexographic printing plate precursor is fixed to the leader using a pin.

It is preferable that the flexographic printing plate precursor is fixed using a plurality of pins, and the attachment and detachment unit has an extrusion portion that removes the pins by pressing a space between the pins of the flexographic printing plate precursor and removes the flexographic printing plate precursor.

It is preferable that the pin has a barb.

It is preferable that in the pin, a surface brought into contact with the flexographic printing plate precursor has a resin layer, a plating layer, or a diamond-like carbon layer or a plurality of uneven portions are formed in the surface brought into contact with the flexographic printing plate precursor.

It is preferable that a back plate portion is provided on a back surface side of the flexographic printing plate precursor, and in a state where the back plate portion is disposed on the back surface side of the flexographic printing plate precursor, the leading end and the trailing end of the flexographic printing plate precursor are fixed to the leader by the attachment and detachment unit.

It is preferable that a sensor that detects the leader is further included. It is preferable that the leader is positioned based on detection of the leader by the sensor.

In addition, according to another aspect of the present invention, there is provided a washing method of performing development using a washing solution while transporting an imagewise exposed flexographic printing plate precursor, the washing method comprising performing the development by fixing both of a leading end and a trailing end of the flexographic printing plate precursor and applying tension to the flexographic printing plate precursor.

It is preferable that tension applied to the flexographic printing plate precursor after fixing the flexographic printing plate precursor is made higher than tension applied to the flexographic printing plate precursor in a case of fixing the flexographic printing plate precursor.

It is preferable that the flexographic printing plate precursor is transported through a transport path including a curved transport passage and a linear transport passage, and a transport direction of the flexographic printing plate precursor includes an upward direction and a downward direction.

It is preferable that the flexographic printing plate precursor is developed by being immersed in the washing solution.

It is preferable that the flexographic printing plate precursor is fixed to the leader using a pin.

It is preferable that a rinsing step of supplying a rinsing liquid to the developed flexographic printing plate precursor after a developing step of performing the development is further included.

It is preferable that a prerinsing step of supplying the washing solution to the developed flexographic printing plate precursor, between the developing step and the rinsing step is further included.

It is preferable that the rinsing step is a step of supplying the rinsing liquid to the developed flexographic printing plate precursor using a jetting type spray nozzle, and the jetting type spray nozzle has a rinsing liquid supply amount of 0.3 to 7 kg/m² per unit area of the developed flexographic printing plate precursor to which the rinsing liquid is supplied.

For example, in the developing step, the washing solution stored in a developing tank is used, and in the rinsing step, the rinsing liquid supplied to the developed flexographic printing plate precursor flows into the developing tank.

In addition, for example, in the developing step, the washing solution stored in a developing tank is used, and the rinsing liquid supplied to the developed flexographic printing plate precursor in the rinsing step and the washing solution supplied to the developed flexographic printing plate precursor in the prerinsing step flow into the developing tank.

In the present invention, the washout processor and the washing method in which a device configuration is small and processing such as development can be stably performed on the flexographic printing plate precursor can be provided.

### BRIEF DESCRIPTION OF THE DRAWINGS

Fig. 1 is a schematic side view showing an example of a washout processor according to an embodiment of the present invention.
Fig. 2 is a schematic perspective view showing main portions of an example of the washout processor according to the embodiment of the present invention.
Fig. 3 is a schematic plan view showing the main portions of the example of the washout processor according to the embodiment of the present invention.
Fig. 4 is a schematic plan view showing a transporting form of a flexographic printing plate precursor according to the embodiment of the present invention.
Fig. 5 is a schematic view showing an example of a leading end leader used in transporting the flexographic printing plate precursor according to the embodiment of the present invention.
Fig. 6 is a schematic view showing an example of a trailing end of a leader mechanism portion used in transporting the flexographic printing plate precursor according to the embodiment of the present invention.
Fig. 7 is a schematic plan view showing another example of the transporting form of the flexographic printing plate precursor according to the embodiment of the present invention.
Fig. 8 is a schematic view showing an example of attachment of the flexographic printing plate precursor by a detachment and attachment unit of the washout processor according to the embodiment of the present invention.
Fig. 9 is a schematic view showing an example of removal of the flexographic printing plate precursor by the detachment and attachment unit of the washout processor according to the embodiment of the present invention.
Fig. 10 is a schematic view showing another example of attachment of the flexographic printing plate precursor by the detachment and attachment unit of the washout processor according to the embodiment of the present invention.
Fig. 11 is a schematic view showing another example of removal of the flexographic printing plate precursor by the detachment and attachment unit of the washout processor according to the embodiment of the present invention.
Fig. 12 is a schematic view showing an example of a back plate portion of the washout processor according to the embodiment of the present invention.
Fig. 13 is a schematic plan view showing an example of a developing portion of the washout processor according to the embodiment of the present invention.
Fig. 14 is a schematic side view showing the example of the developing portion of the washout processor according to the embodiment of the present invention.
Fig. 15 is a schematic perspective view showing a configuration of a brush of the washout processor according to the embodiment of the present invention.
Fig. 16 is a schematic plan view showing a configuration of a bristle side of the brush of the washout processor according to the embodiment of the present invention.
Fig. 17 is a schematic view showing the configuration of the brush of the washout processor according to the embodiment of the present invention.
Fig. 18 is a schematic view showing an example of a step of development treatment by the washout processor according to the embodiment of the present invention.
Fig. 19 is a schematic view showing the example of the step of the development treatment by the washout processor according to the embodiment of the present invention.
Fig. 20 is a schematic view showing the example of the step of the development treatment by the washout processor according to the embodiment of the present invention.
Fig. 21 is a schematic view showing the example of the step of the development treatment by the washout processor according to the embodiment of the present invention.
Fig. 22 is a schematic view showing the example of the step of the development treatment by the washout processor according to the embodiment of the present invention.
Fig. 23 is a schematic view showing the example of the step of the development treatment by the washout processor according to the embodiment of the present invention.
Fig. 24 is a schematic view showing an example of an attachment method of the flexographic printing plate precursor to the washout processor according to the embodiment of the present invention.
Fig. 25 is a schematic view showing another example of the developing portion of the washout processor according to the embodiment of the present invention.
Fig. 26 is a schematic plan view showing still another example of the developing portion of the washout processor according to the embodiment of the present invention.
Fig. 27 is a schematic view showing still another example of the developing portion of the washout processor according to the embodiment of the present invention.
Fig. 28 is a schematic view showing still another example of the developing portion of the washout processor according to the embodiment of the present invention.
Fig. 29 is a schematic view showing still another example of the developing portion of the washout processor according to the embodiment of the present invention.
Fig. 30 is a schematic cross-sectional view showing the brush used in the developing portion of the washout processor according to the embodiment of the present invention.
Fig. 31 is a schematic view showing an example of a supply form of a washing solution of the washout processor according to the embodiment of the present invention.
Fig. 32 is a schematic plan view showing another example of a developing unit of the washout processor according to the embodiment of the present invention.
Fig. 33 is a schematic view showing still another example of the developing unit of the washout processor according to the embodiment of the present invention.
Fig. 34 is a schematic view showing still another example of the developing unit of the washout processor according to the embodiment of the present invention.
Fig. 35 is a schematic view showing still another example of the developing unit of the washout processor according to the embodiment of the present invention.
Fig. 36 is a schematic side view showing another example of the washout processor according to the embodiment of the present invention.
Fig. 37 is a schematic perspective view showing an example of a heater used in the washout processor according to the embodiment of the present invention.
Fig. 38 is a schematic view showing a first example of a rinsing unit of the washout processor according to the embodiment of the present invention.
Fig. 39 is a schematic view showing a second example of the rinsing unit of the washout processor according to the embodiment of the present invention.
Fig. 40 is a schematic view showing a third example of the rinsing unit of the washout processor according to the embodiment of the present invention.
Fig. 41 is a schematic view showing a fourth example of the rinsing unit of the washout processor according to the embodiment of the present invention.
Fig. 42 is a schematic view showing a fifth example of the rinsing unit of the washout processor according to the embodiment of the present invention.
Fig. 43 is a schematic view showing a sixth example of the rinsing unit of the washout processor according to the embodiment of the present invention.
Fig. 44 is a schematic view showing a seventh example of the rinsing unit of the washout processor according to the embodiment of the present invention.
Fig. 45 is a schematic view showing an eighth example of the rinsing unit of the washout processor according to the embodiment of the present invention.
Fig. 46 is a schematic side view showing still another example of the washout processor according to the embodiment of the present invention.
Fig. 47 is a schematic side view showing still another example of the washout processor according to the embodiment of the present invention.

### DESCRIPTION OF THE PREFERRED EMBODIMENTS

Hereinafter, a washout processor and a washing method according to an embodiment of the present invention will be described in detail based on suitable embodiments shown in the accompanying drawings.

The drawings to be described below are exemplary for describing the present invention, and the present invention is not limited to the drawings shown below.

In the following, "to" indicating a numerical range includes numerical values described on both sides. For example, in a case where ε is a numerical value α to a numerical value β, the range of ε is a range including the numerical value α and the numerical value β and is α ≦ ε ≦ β in mathematical symbols.

In addition, "orthogonal" and a specific angle include a range of errors generally acceptable in the corresponding technical field unless particularly stated otherwise. Further, a numerical value or the like includes a range of errors generally acceptable in the corresponding technical field unless particularly stated otherwise.

### (Washout Processor)

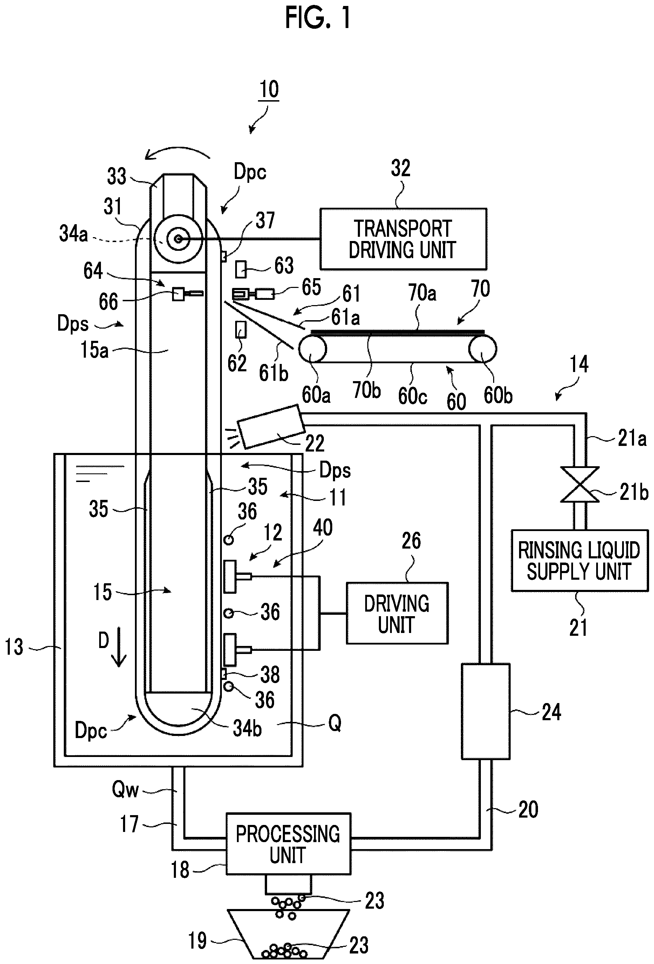

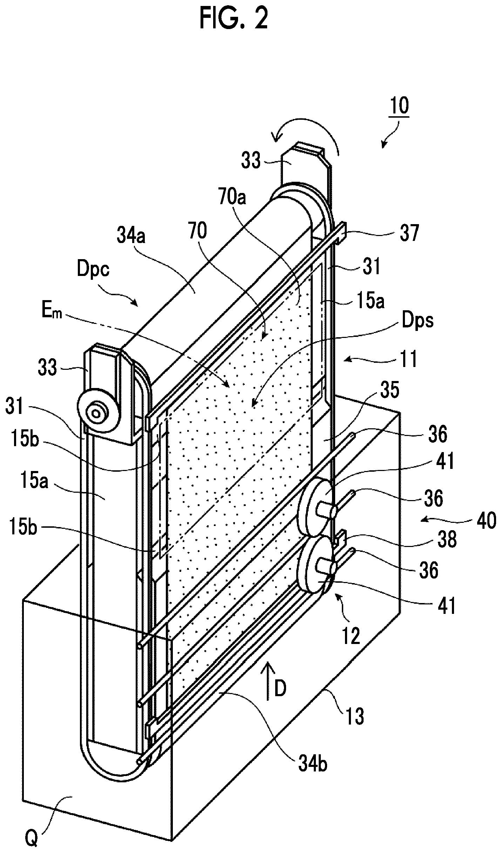

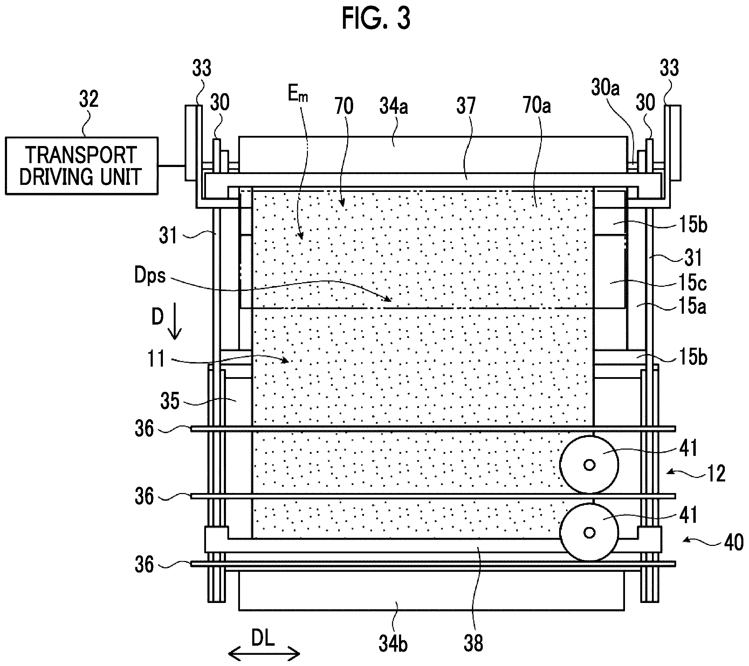

Fig. 1 is a schematic side view showing an example of the washout processor according to the embodiment of the present invention, Fig. 2 is a schematic perspective view showing main portions of the example of the washout processor according to the embodiment of the present invention, and Fig. 3 is a schematic plan view showing main portions of the example of the washout processor according to the embodiment of the present invention. Figs. 2 and 3 partially omit a configuration of a washout processor 10 compared to Fig. 1.

The washout processor 10 shown in Fig. 1 is a device that develops an imagewise exposed flexographic printing plate precursor 70, of which a front surface 70a is imagewise exposed, using a washing solution Q, while transporting the flexographic printing plate precursor and is a transporting type washout processor that develops the flexographic printing plate precursor 70 in a state of being transported along a determined transport path Dp. Performing development using the washing solution Q described above is called a developing step. As shown in Fig. 1, the transport path Dp for the flexographic printing plate precursor 70 has a curved transport passage Dpc and linear transport passages Dps. A transport direction D of the flexographic printing plate precursor 70 includes an upward direction and a downward direction. The upward direction is a direction from a developing tank 13 toward a turn bar 34a, and the downward direction is a direction from the turn bar 34a toward the developing tank 13. In addition, the curved transport passage Dpc is also called a turn portion.

The transport path Dp shown in Fig. 1 is a go-around transport path having the curved transport passage Dpc, the linear transport passage Dps, and the curved transport passage Dpc. For this reason, as will be described later, the flexographic printing plate precursor 70 can be developed by making the flexographic printing plate precursor go around a plurality of times.

As will be described later, the flexographic printing plate precursor 70 has a small thickness of approximately several millimeters and is flexible enough to be curved and transported in the developing tank 13. In addition, for example, an exposure device (not shown) imagewise exposes the front surface 70a of the flexographic printing plate precursor 70. The imagewise exposed front surface 70a of the flexographic printing plate precursor 70 becomes a printing surface.

In the washout processor 10, the imagewise exposed flexographic printing plate precursor 70, which is in a state of being immersed in the washing solution Q and being transported, is developed with a non-exposed portion (not shown) of the flexographic printing plate precursor 70 removed. The washout processor 10 is a single-sheet type device that performs development while transporting the flexographic printing plate precursor 70 along a determined transport path. In a washing method using the washout processor 10, the flexographic printing plate precursor 70 is developed while being transported along the determined transport path Dp. The washing method means a developing method.

The expression that while transporting the flexographic printing plate precursor 70 described above and a state where the flexographic printing plate precursor 70 is transported mean moving the flexographic printing plate precursor 70 along the transport path Dp.

The washout processor 10 has a transporting unit 11, a developing portion 12, and a rinsing unit 14. Although not shown, the washout processor 10 has a control unit that controls an operation of each unit, and the control unit controls an operation of each unit of the washout processor 10 unless stated otherwise.

Although the transporting unit 11 and the developing portion 12 are provided at a frame 15 in the washout processor 10, the invention is not limited to the configuration.

The washout processor 10 has a feeding device 60 that feeds the flexographic printing plate precursor 70 to an attachment and detachment station Eₘ and transports the flexographic printing plate precursor 70 sent from the attachment and detachment station Eₘ to the outside of the washout processor 10.

The attachment and detachment station Eₘ is a region where the flexographic printing plate precursor 70 is fixed to a leading end leader 37 and a trailing end leader 38 and the fixing is released. It is preferable that the attachment and detachment station Eₘ is set in a region of the linear transport passage Dps for easy handling.

The feeding device 60 feeds the flexographic printing plate precursor 70 to the attachment and detachment station Eₘ, and a configuration thereof is not particularly limited insofar as the flexographic printing plate precursor 70 can be transported to the outside of the washout processor 10. As the feeding device 60, for example, a belt conveyor or a roller conveyor can be used, and a belt conveyor or a roller conveyor having a general configuration can be used.

The feeding device 60 has, for example, a drive roller 60a and a driven roller 60b, and an endless conveyor belt 60c is hung on the drive roller 60a and the driven roller 60b. Power generated by a driving unit such as a motor (not shown) is transmitted to the drive roller 60a to rotate the drive roller 60a. Accordingly, the conveyor belt 60c moves rotationally. The conveyor belt 60c sends the flexographic printing plate precursor 70 to the attachment and detachment station Eₘ, but the feeding device 60 is provided with a guide 61 that guides the flexographic printing plate precursor 70 to the leading end leader 37 or the trailing end leader 38 in the attachment and detachment station Eₘ. In the guide 61, for example, a guide plate 61a disposed on a front surface 70a side of the flexographic printing plate precursor 70 and a guide plate 61b disposed on a back surface 70b side are disposed to face each other with a gap.

The guide plate 61a and the guide plate 61b may be configured such that the guide plate 61a and the guide plate 61b themselves have good lubricity or are made of, for example, stainless steel. In addition thereto, for example, a resin layer, a glass layer, or a plating layer is provided on each of surfaces of the guide plate 61a and the guide plate 61b facing the flexographic printing plate precursor 70 in order to reduce friction with the flexographic printing plate precursor 70 and to efficiently guide to the attachment and detachment station Eₘ.

For example, although portions of the guide plates 61a and 61b which are formed of a metal such as stainless steel and come into contact with the flexographic printing plate precursor in a case where the flexographic printing plate precursor 70 is transported may be coated with a fluorine-based resin as resin layers, a plurality of high molecular weight polyethylene resins or a plurality of members made of a fluororesin such as polytetrafluoroethylene (PTFE) may be disposed along the transport direction in the portions of the guide plates 61a and 61b which are formed of a metal such as stainless steel and come into contact with the flexographic printing plate precursor in a case where the flexographic printing plate precursor 70 is transported.

In addition, the washout processor 10 has a sensor 62 that detects the trailing end leader 38 and a sensor 63 that detects the leading end leader 37. By detecting the trailing end leader 38 with the sensor 62 and detecting the leading end leader 37 with the sensor 63, positions of the leading end leader 37 and the trailing end leader 38 can be identified and positioned. For this reason, the leading end leader 37 and the trailing end leader 38 can be disposed at the attachment and detachment station Eₘ, and the flexographic printing plate precursor 70 can be fixed or released at an attachment and detachment position. In a case where the sensors 62 and 63 detect the leading end leader 37 and the trailing end leader 38, for example, a detection signal is output to a transport driving unit 32. Based on the detection signal, the transport driving unit 32 stops driving of a transport chain 31 and stops the leading end leader 37 and the trailing end leader 38 at the attachment and detachment station Eₘ. The transport driving unit 32 and the transport chain 31 will be described later.

The sensors 62 and 63 are not particularly limited insofar as the leading end leader 37 and the trailing end leader 38 can be detected, and for example, a proximity sensor, a limit switch, an area sensor, and the like can be used.

The positions where two sensors 62 and 63 are provided are not particularly limited and, for example, may be the same positions in a direction DL (see Fig. 3) orthogonal to the transport direction D, or may be different positions. The sensor 62 may detect the leading end leader 37, the sensor 63 may detect the trailing end leader 38, and it is preferable to provide the sensors at different positions in the direction DL (see Fig. 3) in consideration of a space where the sensor 62 and the sensor 63 are disposed or the like.

Although a configuration where the two sensors 62 and 63 are provided is adopted, the number of sensors is not particularly limited, and there may be one sensor insofar as the leading end leader 37 and the trailing end leader 38 can be detected.

Further, the washout processor 10 has an attachment and detachment unit 64 that has a plate attachment portion 65 which fixes the flexographic printing plate precursor 70 to the leading end leader 37 and the trailing end leader 38 and a plate detachment portion 66 which releases the fixing of the flexographic printing plate precursor 70 by the leading end leader 37 and the trailing end leader 38. The attachment and detachment unit 64 is disposed at the attachment and detachment station Eₘ. As will be described later, a position where the attachment and detachment unit 64 fixes the flexographic printing plate precursor 70 and releases the fixing and the attachment and detachment unit 64 is disposed is called the attachment and detachment position.

The outer shape of the frame 15 is, for example, a rectangular shape. Two members 15a of the frame 15 extending in one direction as shown in Fig. 2 are disposed in parallel. In a direction orthogonal to a longitudinal direction of the members 15a, beam members 15b are disposed at both ends and the center of the members 15a in the longitudinal direction. Between the beam members 15b provided at both ends of the member 15a of the frame 15 in the longitudinal direction is the linear transport passage Dps. For example, up to the center of the members 15a of the frame 15, that is, up to the beam member 15b at the center, the linear transport passage is disposed in the developing tank 13. The developing tank 13 is a container in which the washing solution Q is stored. The developing portion 12 is disposed in the linear transport passage Dps in the developing tank 13.

As shown in Fig. 3, for example, gears 30 are rotatably provided at both ends of each member 15a in the longitudinal direction. The gears 30 facing each other in the longitudinal direction of the beam members 15b are connected by a shaft 30a. In each member 15a, the transport chain 31 is hung on a pair of gears 30 facing each other in the longitudinal direction. The pair of transport chains 31 are disposed to face each other in the longitudinal direction of the beam members 15b of the frame 15.

For example, the transport driving unit 32 is connected to one of the plurality of gears 30. The gears 30 are rotated by the transport driving unit 32, and the transport chains 31 move in a specific direction. A method of connecting between the gears 30 and the transport driving unit 32 is not particularly limited, the gears and the transport driving unit may be connected to each other by a shaft or the like or may be connected to each other using a chain or a belt.

The transporting unit 11 is composed of the gears 30, the transport chains 31, and the transport driving unit 32. The transporting unit 11 uses a winding transmission method using the gears 30 and the transport chains 31. The flexographic printing plate precursor 70 is transported by the transporting unit 11 in a state of being immersed in the washing solution Q in the developing tank 13.

The transporting unit 11 preferably has a tension adjusting unit 33 (see Fig. 1) that adjusts the tension of the flexographic printing plate precursor 70 during transporting. In a case where the tension of the transport chain 31 is low, the tension of the flexographic printing plate precursor 70 during transporting is low, the flexographic printing plate precursor 70 is loosened during transporting, and the flexographic printing plate precursor 70 is not stably transported. In addition, in a case where the tension of the transport chain 31 is low, the transport chain 31 is disengaged from the gear 30 in some cases. For this reason, the tension adjusting unit 33 that adjusts the tension of the transport chain 31 is provided at an end part of the member 15a in order to adjust the tension of the flexographic printing plate precursor 70 during transporting. The tension of the flexographic printing plate precursor 70 during transporting can be adjusted by the tension adjusting unit 33, and the flexographic printing plate precursor 70 is prevented from being loosened during transporting.

Insofar as the tension of the flexographic printing plate precursor 70 during transporting can be adjusted, a position where the tension adjusting unit 33 is disposed and a configuration thereof are not particularly limited, and a known unit can be used as appropriate. For example, it is possible to use a unit that changes a distance between the gears 30 on which the transport chains 31 are hung, a unit that applies tension by pressing the gears against the transport chain 31, or the like as appropriate.

The transporting unit 11 may have a guide mechanism that guides the transport chain 31. The guide mechanism can prevent meandering of the transport chain 31 or the like. The guide mechanism is composed of, for example, a member that is provided on an opposite side of the transport chain 31 where the flexographic printing plate precursor 70 is disposed and is inserted between rollers (not shown) of the transport chains 31. This member is formed of, for example, high molecular weight polyethylene or a fluororesin such as polytetrafluoroethylene (PTFE).

The turn bar 34a and a turn bar 34b (see Fig. 2) are provided at the beam members 15b at ends of the members 15a respectively in the longitudinal direction. The turn bars 34a and 34b are composed of a semi-cylindrical member, and the semi-cylindrical member is provided with a plane portion facing a beam member 15b side.

The semi-cylindrical turn bars 34a and 34b are provided at bending parts composed of the curved transport passages. That is, the curved transport passages Dpc are composed of the semi-cylindrical turn bars 34a and 34b, and the flexographic printing plate precursor 70 is transported along the surfaces of the turn bars 34a and 34b. In this case, a back surface 70b of the flexographic printing plate precursor 70 comes into contact with the turn bars 34a and 34b. The turn bars 34a and 34b each are composed of a semi-cylindrical member having a size corresponding to the curvature of the curved transport passage Dpc or the like.

Since the turn bars 34a and 34b are brought into contact with the flexographic printing plate precursor 70, at least, surfaces brought into contact with the flexographic printing plate precursor 70 preferably have a low frictional resistance. As the frictional resistance is low, the flexographic printing plate precursor 70 can be smoothly transported without damaging the back surface 70b. The turn bars 34a and 34b prevent tension fluctuations in the curved transport passages Dpc during transporting of the flexographic printing plate precursor 70.

The turn bar 34a and the turn bar 34b are provided at the ends of the members 15a in the longitudinal direction, and the turn bar 34b is immersed in the developing tank 13 storing the washing solution Q.

In addition, the flexographic printing plate precursor 70 is attached to the trailing end leader 38 in a state where the flexographic printing plate precursor 70 is hung on the turn bar 34a among the turn bar 34a and the turn bar 34b. The turn bar 34a moves forward and backward with respect to the curved transport passage Dpc. In a case where the turn bar 34a has entered the curved transport passage Dpc, the turn bar is brought into contact with the flexographic printing plate precursor 70. On the other hand, in a case where the turn bar 34a has moved backward with respect to the curved transport passage Dpc, a transport length of the flexographic printing plate precursor 70 is shortened, and a short pass state to be described later is caused. Specifically, as the turn bar 34a moves up and down with respect to the beam members 15b, the turn bar moves forward and backward with respect to the curved transport passage Dpc. For example, a linear motion mechanism using a solenoid is provided, for example, between the turn bar 34a and the beam member 15b. For example, a configuration where the turn bar 34a is lowered in a state where the solenoid is turned off and the turn bar 34a is raised in a state where the solenoid is turned on is adopted. Accordingly, in a case of fixing the flexographic printing plate precursor 70, the turn bar 34a can be lowered.

By raising and lowering the turn bar 34a, tension applied to the flexographic printing plate precursor 70 can be changed. The turn bar 34a functions as a tension applying unit. With the tension applying unit, by raising the turn bar 34a after fixing the flexographic printing plate precursor 70 to the leader, a force is applied in a direction in which the length of the flexographic printing plate precursor 70 extends in a state where the flexographic printing plate precursor 70 is fixed to the leader, and the tension of the flexographic printing plate precursor 70, that is, tension after fixing the flexographic printing plate precursor 70 to the leader can be made higher than tension in a case of fixing the flexographic printing plate precursor 70.

The tension in a case of fixing the flexographic printing plate precursor 70 is the tension of the flexographic printing plate precursor 70 in a state where the turn bar 34a is lowered. The tension after fixing the flexographic printing plate precursor is the tension of the flexographic printing plate precursor 70 in a state where the turn bar 34a is raised.

The magnitude of the tension of the flexographic printing plate precursor 70 can be identified by the tension of the flexographic printing plate precursor 70.

In a case where the tension of the flexographic printing plate precursor 70 is high, that is, the flexographic printing plate precursor 70 extends, vertical creases are generated in the flexographic printing plate precursor 70. On the other hand, in a case where the tension of the flexographic printing plate precursor 70 is low, that is, the flexographic printing plate precursor 70 loosens, horizontal creases are generated. Both of the vertical creases and the horizontal creases cause development defects. An operator visually checks the vertical creases and the horizontal creases and can start transport with a state where none of the creases are generated as appropriate tension. It is preferable to provide a device that measures the tension of the flexographic printing plate precursor 70 in the tension applying unit or the transport path and to adjust the tension of the flexographic printing plate precursor 70 such that the tension is within a certain range.

Next, the device that measures the tension of the flexographic printing plate precursor 70 or the like will be described.

In a state where the flexographic printing plate precursor 70 is fixed to the leader, a state where the turn bar 34a is raised is visually checked with the solenoid turned on, and a position where the solenoid is attached or a stopper is adjusted to cause a state where vertical creases and horizontal creases are not generated. In addition to the solenoid, an air cylinder or a hydraulic actuator may be used as the linear motion mechanism, and the attachment position or the stopper is adjusted and fixed such that any linear motion mechanism is in an appropriate tension state in a case of being turned on.

In addition, in a case where a driving unit or an electric actuator composed of a ball screw, a linear guide, a servo motor, or the like is used, linear motion can be randomly made not only in on and off states but also in a certain range, and the tension can be finely adjusted. In a case where the linear motion mechanisms are configured to operate the tension applying unit via a load cell or a strain gauge, tension applied to the flexographic printing plate precursor 70 can be measured. By quantifying a tension range in a state where vertical creases and horizontal creases are not visually generated in the flexographic printing plate precursor 70, in a state where the flexographic printing plate precursor 70 is fixed to the leader according to various types such as a width, a length, and a thickness of the flexographic printing plate precursor 70, a state where the turn bar 34a is raised with the solenoid turned on is visually checked, and a position where the solenoid is attached or the stopper is adjusted to cause a state where vertical creases and horizontal creases are not generated. In addition to the solenoid, an air cylinder or a hydraulic actuator may be used as the linear motion mechanism, and the attachment position or the stopper is adjusted and fixed such that any linear motion mechanism is in an appropriate tension state in a case of being turned on.

In addition, in a case where the driving unit or the electric actuator composed of the ball screw, the linear guide, the servo motor, or the like is used, linear motion can be randomly made not only in on and off states but also a certain range, and tension applied to the flexographic printing plate precursor 70 can be finely adjusted. In a case where the linear motion mechanisms are configured to operate the tension applying unit via the load cell or the strain gauge, tension applied to the flexographic printing plate precursor 70 can be measured. By quantifying a tension range in a state where vertical creases and horizontal creases are not visually generated in the flexographic printing plate precursor 70, an appropriate tension state according to various types such as the width, the length, and the thickness of the flexographic printing plate precursor 70 is easily set.

As a tension measurer, a tension controller is preferable.

The tension applying unit is not limited to the turn bar 34a described above, and a roller (not shown) can also be used instead of the turn bar 34a. In a case where the roller is provided, as in the turn bar 34a described above, the roller is configured to move forward and backward with respect to the curved transport passage Dpc, and tension can be applied to the flexographic printing plate precursor 70 in a case where the roller has entered the curved transport passage Dpc.

The surfaces of the turn bars 34a and 34b, which are brought into contact with the flexographic printing plate precursor 70, are composed of, for example, resin layers, plating layers, or diamond-like carbon layers (DLC layers). The resin layer can be formed of a fluororesin, such as polytetrafluoroethylene (PTFE) and high-density polyethylene. The plating layer is, for example, hard chrome plating. In addition thereto, a titanium nitride (TiN) layer or the like can be used. Further, a nonwoven fabric can also be used as the turn bars 34a and 34b. In a case of using the nonwoven fabric, an attachment on the back surface 70b of the flexographic printing plate precursor 70 can be removed.

In addition, a plurality of uneven portions may be formed in the surfaces of the turn bars 34a and 34b, which are brought into contact with the flexographic printing plate precursor 70. As the plurality of uneven portions are formed, a contact area reduces, and a frictional resistance decreases. An example in which the plurality of uneven portions are formed includes a metal plate such as an embossed stainless steel plate.

The turn bars 34a and 34b may be entirely formed of a material forming the surfaces brought into contact with the flexographic printing plate precursor 70.

Since the turn bar 34b is used in a state of being immersed in the washing solution Q in some cases, a unit that does not dissolve in the washing solution Q, a unit that does not deteriorate due to the washing solution Q, or a unit that does not deform, such as swelling, due to the washing solution Q is preferable.

In addition, a back plate portion 35 with which the flexographic printing plate precursor 70 is brought into contact is provided between the beam member 15b at the center of the member 15a of the frame 15 and the beam member 15b at the end. For example, the back plate portion 35 is provided on the back surface 70b side of the flexographic printing plate precursor 70.

Since the back plate portion 35 is brought into contact with the flexographic printing plate precursor 70, a surface brought into contact with the flexographic printing plate precursor 70 is preferably a plane. As the surface brought into contact with the flexographic printing plate precursor 70 is a plane, the flexographic printing plate precursor 70 can be efficiently washed.

The back plate portion 35 is formed of, for example, a metal. The metal is preferably stainless steel, titanium, or the like, the surface of the back plate portion 35 brought into contact with the flexographic printing plate precursor 70 may be plated, the plating is preferably hard chrome plating and is more preferably diamond-like carbon (DLC) processing. In addition thereto, surface treatment with titanium nitride (TiN) or the like may be performed on the surface brought into contact with the flexographic printing plate precursor 70.

In addition, it is preferable that the back plate portion 35 is disposed also in a region where the attachment and detachment unit 64 is disposed. By providing the back plate portion 35 also in the region where the attachment and detachment unit 64 is disposed, in a case of fixing the flexographic printing plate precursor 70 to the leading end leader 37 and the trailing end leader 38, the back plate portion 35 becomes a support of the flexographic printing plate precursor 70, and the flexographic printing plate precursor 70 can be more reliably fixed to a pin 37d and a pin 38d. The back plate portion 35 may not be the plane surface brought into contact with the flexographic printing plate precursor 70, and at least one of convex portions or uneven portions may be in the contact surface. The convex portions or the uneven portions of the contact surface are formed by, for example, embossing.

In a case where the tension of the flexographic printing plate precursor 70 is high, that is, the flexographic printing plate precursor 70 extends, vertical creases are generated in the flexographic printing plate precursor 70. On the other hand, in a case where the tension of the flexographic printing plate precursor 70 is low, that is, the flexographic printing plate precursor 70 loosens, horizontal creases are generated. Both of the vertical creases and the horizontal creases cause development defects. An operator visually checks the vertical creases and the horizontal creases and checks the tension of the flexographic printing plate precursor 70. A state where none of the vertical creases and the horizontal creases are generated in the flexographic printing plate precursor 70 is defined as appropriate tension.

In addition, for example, three nip rollers 36 are provided to face the back plate portion 35 at intervals in the longitudinal direction of the members 15a. Two of the three nip rollers are provided near a brush 41 of the developing portion 12. Although the flexographic printing plate precursor 70 has flexibility as described above, the nip rollers 36 prevent deflection or the like during transporting so that the flexographic printing plate precursor 70 can be stably transported, and even in a case where the brush 41 rotates or moves particularly during development, the flexographic printing plate precursor 70 can be stably transported. The nip rollers 36 are not limited to three. In a case where there is one brush 41, the nip rollers 36 are disposed as a pair around the brush 41 such that the brush 41 is sandwiched therebetween in the longitudinal direction of the members 15a. In a case where two brushes 41 are disposed in the longitudinal direction of the members 15a as in Fig. 2, the brushes 41 are disposed to be sandwiched between the nip rollers 36 around each brush in the longitudinal direction of the members 15a. In a case where the two brushes 41 are disposed at a distance apart from each other, since the nip rollers 36 are disposed around each brush, there are four brushes.

In order to make the nip rollers 36 do not damage a printing surface, that is, the front surface 70a of the flexographic printing plate precursor 70, surface roughness is made lower than 6.3, is preferably 3.2, and is more preferably 1.6 or lower in terms of arithmetic average roughness Ra in a case where the nip rollers 36 are hard rollers made of a metal or the like. In a case where soft rollers such as rubber rollers are used as the nip rollers 36, it is preferable to use a relatively hard material having rubber hardness of 50 degrees or higher.

Since the flexographic printing plate precursor 70 has flexibility as described above, there is a possibility that the non-exposed portion cannot be efficiently removed by the brush 41 due to deflection or the like in a case of being rubbed against the brush 41. For example, as the back plate portion 35 described above is provided on the back surface 70b side of the flexographic printing plate precursor 70, the back surface 70b of the flexographic printing plate precursor 70 is supported by the back plate portion 35 in a case of removing the non-exposed portion by the brush 41, so that the non-exposed portion can be efficiently removed. In addition, the back plate portion 35 functions as a transport guide, and thus the flexographic printing plate precursor 70 can be more stably transported by the back plate portion 35.

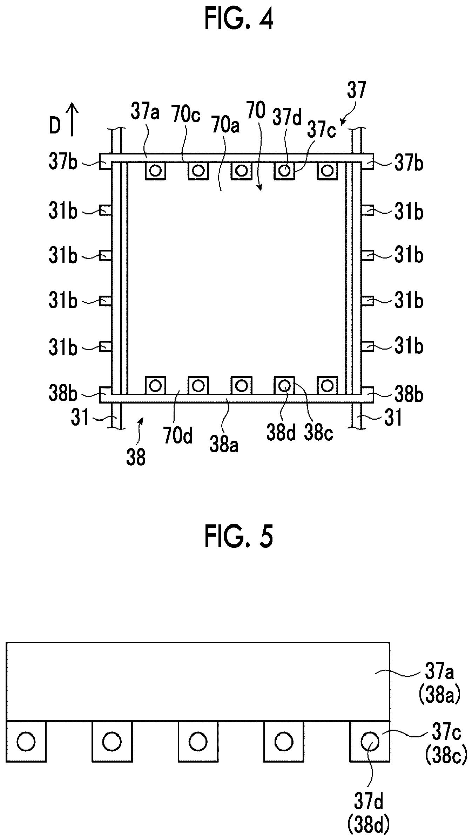

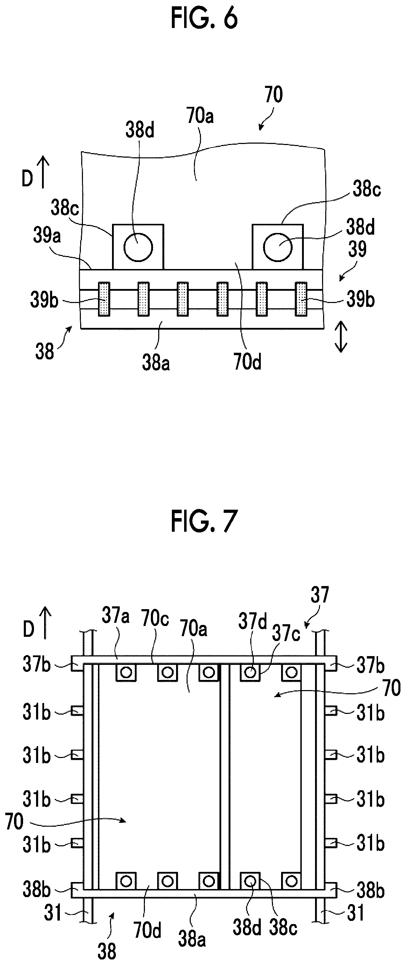

Herein, Fig. 4 is a schematic plan view showing a transporting form of the flexographic printing plate precursor according to the embodiment of the present invention and is a schematic view showing an example of the leading end leader used in transporting the flexographic printing plate precursor according to the embodiment of the present invention. Fig. 6 is a schematic view showing a leader mechanism portion used in transporting the flexographic printing plate precursor according to the embodiment of the present invention. In addition, Fig. 7 is a schematic plan view showing another example of the transporting form of the flexographic printing plate precursor according to the embodiment of the present invention.

The transporting unit 11 fixes the leader to the pair of transport chains 31 and transports the flexographic printing plate precursor 70.

The leaders are provided on a traveling direction side of the flexographic printing plate precursor 70, that is, on a leading end 70c (see Fig. 4) on a transport direction D side and a trailing end 70d (see Fig. 4) on an opposite side of the leading end 70c (see Fig. 4). The leaders include the leading end leader 37 and the trailing end leader 38 shown in Figs. 4 and 7. Both of the leading end and the trailing end of the flexographic printing plate precursor 70 are fixed by the leaders.

As shown in Figs. 4 and 7, for example, a plurality of fixing units 31b are provided on the transport chain 31 at equal intervals along a longitudinal direction of the transport chain 31. The leading end leader 37 and the trailing end leader 38 are fixed to the fixing units 31b. The longitudinal direction of the transport chain 31 is the same direction as the transport direction D.

As shown in Fig. 4, the leading end leader 37 has a long base 37a and a bending portion 37b provided at each end of the base 37a in the longitudinal direction. As shown in Fig. 5, a plurality of attaching portions 37c are provided at the base 37a with gaps at equal intervals along a longitudinal direction of the base 37a. The pin 37d is provided for each of the attaching portions 37c. The pin 37d is passed through the flexographic printing plate precursor 70, and the flexographic printing plate precursor 70 is fixed to the leading end leader 37. In this case, in order to prevent the flexographic printing plate precursor 70 from moving during transporting, it is preferable that the base 37a and the leading end of the flexographic printing plate precursor 70 are aligned and fixed.

As shown in Fig. 4, the bending portion 37b of the leading end leader 37 is fixed to the fixing unit 31b of the transport chain 31, and the leading end leader 37 is fixed to the transport chain 31. A method of fixing the leading end leader 37 to the transport chain 31 is not particularly limited, and the leading end leader is fixed to the transport chain through at least one of fixing methods using hooking, screwing, sandwiching, or a magnetic force.

The hooking is, for example, a method of hooking the bending portion 37b to the fixing unit 31b.

The screwing is, for example, a method of fixing the bending portion 37b to the fixing unit 31b using a bolt and a nut. In addition thereto, a method of forming a female thread in the fixing unit 31b and fixing the bending portion 37b to the fixing unit 31b using a screw is also included in screwing.

The sandwiching is, for example, a method of collectively sandwiching and fixing the bending portion 37b and the fixing unit 31b to each other using a member such as a clip.

Fixing by a magnetic force is, for example, a method of forming the bending portion 37b and the fixing unit 31b by magnetic materials and fixing the bending portion 37b and the fixing unit 31b to each other using magnets.

The trailing end leader 38 has basically the same configuration as the leading end leader 37 described above. As shown in Fig. 5, the trailing end leader 38 has a long base 38a and a bending portion 38b provided at each end of the base 38a in a longitudinal direction. A plurality of attaching portions 38c are provided at the base 38a with gaps at equal intervals along the longitudinal direction. The pin 38d is provided for each of the attaching portions 38c. The pin 38d is passed through the flexographic printing plate precursor 70, and the flexographic printing plate precursor 70 is fixed to the trailing end leader 38. In this case, in order to prevent the flexographic printing plate precursor 70 from moving during transporting, it is preferable that the base 38a and the trailing end of the flexographic printing plate precursor 70 are aligned and fixed. As described above, the pins 37d and 38d are fixing members fixing the flexographic printing plate precursor.

The bending portion 38b of the trailing end leader 38 is fixed to the fixing unit 31b of the transport chain 31, and the trailing end leader 38 is fixed to the transport chain 31. A method of fixing the trailing end leader 38 to the transport chain 31 is not particularly limited, and the trailing end leader is fixed to the transport chain through at least one method of fixing methods using hooking, screwing, sandwiching, or a magnetic force, like the leading end leader 37.

Since the leading end leader 37 is on the traveling direction side, a force acts in a direction in which the fixing unit 31b presses the bending portion 37b of the leading end leader 37 even in a case of being hooked. In order to make a force act in the direction in which the bending portion 37b is pressed, it is necessary to hook the bending portion 38b of the trailing end leader 38 in an opposite direction to the leading end leader 37. For this reason, fixing methods using screwing, sandwiching, and a magnetic force, which allow fixing in states of Figs. 4 and 7, are preferable for the trailing end leader 38.

In addition, transporting tension fluctuates in some cases due to fluctuations of transporting during transporting. Transporting becomes unstable due to the fluctuations of the transporting tension. In addition, the flexographic printing plate precursor 70 expands and contracts in some cases due to the transporting tension during transporting. For this reason, it is preferable to prevent the fluctuations of the transporting tension and effects of expansion and contraction or the like of the flexographic printing plate precursor 70. Thus, it is preferable for the leader to have a leader mechanism portion 39 that expands and contracts with respect to the traveling direction of the flexographic printing plate precursor 70. The leader mechanism portion 39 can reduce the fluctuations of the transporting tension and the effects of expansion and contraction or the like of the flexographic printing plate precursor 70 by expanding and contracting with respect to the traveling direction of the flexographic printing plate precursor 70.

Since the leading end leader 37 is on the traveling direction side, transporting tension is unlikely to fluctuate, but the transporting tension of the trailing end leader 38 is likely to fluctuate. For this reason, it is preferable for the trailing end leader 38 to have the leader mechanism portion 39 (see Fig. 6).

For example, as shown in Fig. 6, the leader mechanism portion 39 is provided between the base 38a and the flexographic printing plate precursor 70. The leader mechanism portion 39 has a frame material 39a and an elastic member 39b such as a spring and rubber, and the frame material 39a and the base 38a are disposed in parallel with each other and are connected to each other by the elastic member 39b. In a case where the leader mechanism portion 39 is provided, the pin 38d is not provided at the base 38a, and the pin 38d (see Fig. 5) is provided at the frame material 39a. The frame material 39a is fixed to the flexographic printing plate precursor 70.

The leading end leader 37 may be configured to have the leader mechanism portion 39. In this case, the leader mechanism portion 39 is provided at the base 37a.

The washout processor 10 is not limited to a form in which the leading end leader 37 and the trailing end leader 38 are attached to the one flexographic printing plate precursor 70 as described above, and a plurality of flexographic printing plate precursors may be attached to the leaders. For example, as shown in Fig. 7, a form in which the leading end leader 37 and the trailing end leader 38 are attached to two flexographic printing plate precursors 70 may be adopted. An example in which the two flexographic printing plate precursors 70 are provided as shown in Fig. 7 is merely an example, the flexographic printing plate precursor 70 is not limited to two, a form in which three or more flexographic printing plate precursors 70 are attached may be adopted, and a form in which a plurality of flexographic printing plate precursors 70 are attached as described above can be adopted.

Although the leading end leader 37 and the trailing end leader 38 fix the flexographic printing plate precursor 70 using the pin 37d and the pin 38d respectively, the shapes, numbers, and disposition intervals of the pins 37d and 38d are not particularly limited. It is preferable that the attaching portion 37c provided with the pin 37d and the attaching portion 38c provided with the pin 38d are disposed with a gap from convenience of removing the flexographic printing plate precursor 70. In a case where the pins 37d and 38d fix the flexographic printing plate precursor 70, it is preferable that residues or the like are not generated in order not to contaminate an exposure surface of the flexographic printing plate precursor 70, that is, the front surface 70a or not to contaminate the washing solution Q in the developing tank 13.

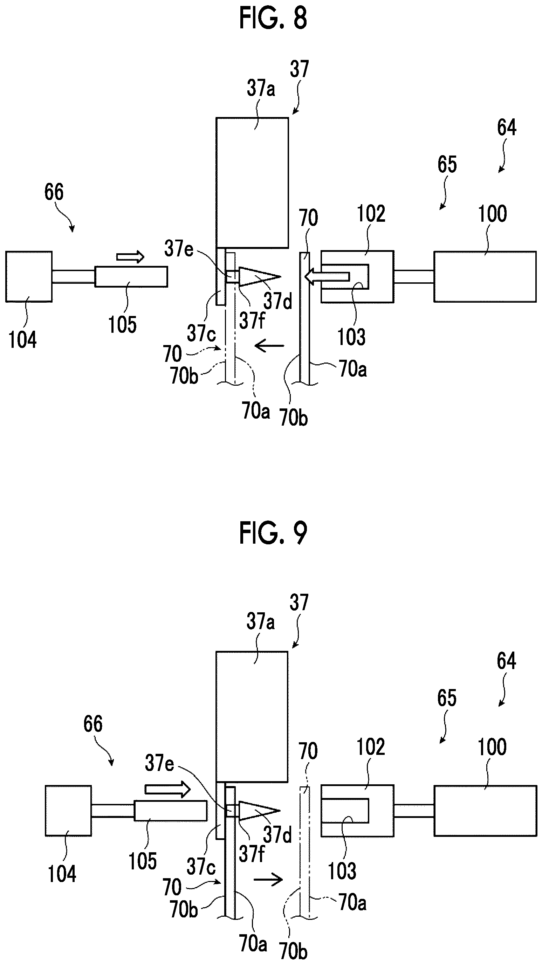

In addition, the pins 37d and 38d have, for example, barbs. Due to the barbs, the flexographic printing plate precursor 70 is unlikely to come off from the pin 37d, and the flexographic printing plate precursor 70 is reliably fixed. For this reason, it is preferable that the pins 37d and 38d have barbs. The barb is a portion in which the pin 37d (see Fig. 8) on a base 37e (see Fig. 8) side as will be described later protrudes from the base 37e. Although the flexographic printing plate precursor 70 is fixed by the base 37e, a barb 37f (see Fig. 8) protrudes from the base 37e, and the movement of the flexographic printing plate precursor 70 to a distal end side of the pin 37d is restricted. In this manner, the barb makes the flexographic printing plate precursor 70 unlikely to come off from the pin 37d.

In addition, it is preferable that surfaces of the pins 37d and 38d brought into contact with at least the flexographic printing plate precursor 70 have a resin layer, a plating layer, or a diamond-like carbon layer (DLC layer) or a plurality of uneven portions are formed on the surfaces brought into contact with the flexographic printing plate precursor 70.

A hard chrome plating layer is preferable as the plating layer. In addition thereto, surface treatment with titanium nitride (TiN) or the like may be performed on the surfaces of the pins 37d and 38d brought into contact with the flexographic printing plate precursor 70. Accordingly, friction between the pins 37d and 38d and the flexographic printing plate precursor 70 is reduced, and the pins 37d and 38d are likely to be passed through the flexographic printing plate precursor 70. Further, the durability of the pins 37d and 38d improves, the pins 37d and 38d can be repeatedly used, and the durability of the leading end leader 37 and the trailing end leader 38 also improves.

The plurality of uneven portions of the surfaces of the pins 37d and 38d brought into contact with the flexographic printing plate precursor 70 are formed through, for example, embossing.

In the washout processor 10, the developing portion 12 and the rinsing unit 14 are provided along the transport path Dp for the flexographic printing plate precursor 70. For example, the developing portion 12 is provided in the developing tank 13, and the rinsing unit 14 is provided at an upper portion of the developing tank 13 where the flexographic printing plate precursor 70 that has gone through the developing portion 12 first comes out. The rinsing unit 14 is provided on a downstream side of the developing portion 12 in the traveling direction of the flexographic printing plate precursor 70. Herein, the downstream side is a side in a direction in which the leading end 70c (see Fig. 4) of the flexographic printing plate precursor 70 advances in a case of transporting the flexographic printing plate precursor 70. In addition, downstream is a destination where the leading end 70c (see Fig. 4) advances in the transport direction D of the flexographic printing plate precursor 70. An opposite side of the downstream side is an upstream side.

Further, the washout processor 10 has a processing unit 18 provided at the developing tank 13 via a connecting pipe 17. In the washout processor 10, for example, the flexographic printing plate precursor 70 that has gone through the rinsing unit 14 is taken out. A position where the flexographic printing plate precursor 70 in the washout processor 10 is taken out is not particularly limited.

### (Transporting Unit)

In the transporting unit 11, the gear 30 is rotated by the transport driving unit 32, and the flexographic printing plate precursor 70 fixed to the transport chain 31 using the leading end leader 37 and the trailing end leader 38 moves in the vicinity of the frame 15. The transport path Dp for the flexographic printing plate precursor 70 is a path for going around the vicinity of the frame 15 and has the curved transport passage Dpc and the linear transport passage Dps.

In the washout processor 10, for example, after one time of development, processing by the rinsing unit 14 is performed and ended. A rinsing step is performed after the developing step of performing development. However, development is not limited to one time, and the flexographic printing plate precursor may go around the vicinity of the frame 15 a plurality of times in order to perform development a plurality of times.

Although there are various transport paths such as a one-direction transport path, a reciprocating transport path, and a go-around transport path as the transport path Dp for the flexographic printing plate precursor 70, it is preferable that the transport path Dp for the flexographic printing plate precursor 70 is the one-direction transport path or the go-around transport path since processing by the rinsing unit 14 is necessary after development.

### (Attachment and Detachment Unit of Flexographic Printing Plate Precursor)

Fig. 8 is a schematic view showing an example of attachment of the flexographic printing plate precursor by a detachment and attachment unit of the washout processor according to the embodiment of the present invention, and Fig. 9 is a schematic view showing an example of removal of the flexographic printing plate precursor by the detachment and attachment unit of the washout processor according to the embodiment of the present invention. In Figs. 8 and 9, the same components as the washout processor 10 shown in Figs. 1 to 3 will be assigned with the same reference numerals, and detailed description thereof will be omitted.

The attachment and detachment unit 64 fixes the flexographic printing plate precursor 70 to the leading end leader 37 and the trailing end leader 38 and releases the fixing. The attachment and detachment unit 64 has the plate attachment portion 65 and the plate detachment portion 66 as described above. The plate attachment portion 65 is provided for each pin, and it is preferable that the leading end leader 37 and the trailing end leader 38 have the same number of pins. For this reason, in a case where there are a plurality of pins, a plurality of attachment and detachment units 64 are also provided according to the number of pins. In addition, the plate detachment portion 66 presses a region of the flexographic printing plate precursor 70, which is not fixed to the pin to remove the flexographic printing plate precursor 70, and is preferably provided between pins, that is, between the attaching portions. For this reason, a plurality of plate detachment portions 66 are provided according to the number of a space between the attaching portions.

Since the leading end leader 37 and the trailing end leader 38 basically have the same configuration as described above, the leading end leader 37 will be described as an example, and the same applies to the trailing end leader 38 as well.

The plate attachment portion 65 shown in Fig. 8 has a driving unit 100 and a pushing portion 102. The pushing portion 102 has a concave portion 103. Since the pin 37d is fitted to the concave portion 103, it is preferable that the inner diameter of the concave portion 103 is larger than the maximum outer diameter of the pin 37d. Accordingly, the pin 37d can be more reliably passed through the flexographic printing plate precursor 70.

Insofar as the driving unit 100 can move the pushing portion 102 from a first position toward the pin 37d and restore to the first position, a configuration thereof is not particularly limited, and for example, an air cylinder is used. The first position is a position where the pushing portion 102 is provided, and the first position is also referred to an initial position.

Since the pushing portion 102 causes the pin 37d to pass through the flexographic printing plate precursor 70, it is preferable that the pushing portion has strength so as not to deform and is formed of, for example, a metal.

Martensite-based stainless steel that is resistant to abrasion in a case of forming a hole in the flexographic printing plate precursor 70 and has hardenability is preferable for the pushing portion 102 among various types of stainless steel which is unlikely to rust. Martensite-based stainless steel corresponds to original brand stainless steel developed for a cutting tool by a material manufacturer, stainless steel (SUS)410, SUS420J1, SUS420J2, and the like. In addition, carbon tool steel, alloy tool steel, high-speed tool steel, and super steel may be used as the pushing portion 102.

The flexographic printing plate precursor 70 is disposed with the back surface 70b facing the pin 37d of the leading end leader 37. The pushing portion 102 of the plate attachment portion 65 is disposed on the front surface 70a side of the flexographic printing plate precursor 70.

In a case where the position of the concave portion 103 of the pushing portion 102 and the position of a pin 27d of the leading end leader 37 are aligned and the driving unit 100 pushes out the pushing portion 102 at the first position toward the pin 37d, the flexographic printing plate precursor 70 is pressed toward the pin 37d, the pin 37d is passed through the flexographic printing plate precursor 70, and the flexographic printing plate precursor 70 is fixed to the leading end leader 37. In this case, the pin 37d is fitted into the concave portion 103. The driving unit 100 restores the pushing portion 102 to the first position.

The pin 37d has, for example, a conical shape, and on a conical bottom surface, the base 37e having a diameter smaller than the conical bottom surface is provided. The base 37e and the attaching portion 37c are connected to each other. For example, the length of the base 37e is approximately the same as the thickness of the flexographic printing plate precursor 70. A base 37e side of the pin 37d protrudes from the base 37e, and the pin has the barb 37f. The barb 37f is a portion where the base 37e side of the pin 37d protrudes from the base 37e. In a case where the pin 37d passes through the flexographic printing plate precursor 70 as described above, the flexographic printing plate precursor is unlikely to come off from the pin 37d and is reliably fixed due to the barb 37f.

The plate detachment portion 66 is provided in, for example, a space 15c between the two beam members 15b of the frame 15 shown in Fig. 3. The plate detachment portion 66 shown in Fig. 9 has a driving unit 104 and an extrusion portion 105. The extrusion portion 105 has a tubular member. The extrusion portion 105 is disposed in a region where there is no attaching portion 37c of the leading end leader 37 (see Fig. 5).

Insofar as the driving unit 104 can cause the extrusion portion 105 to protrude from the first position toward the back surface 70b of the flexographic printing plate precursor 70, press the flexographic printing plate precursor 70 to remove the pin 37d, and restore to the first position, a configuration thereof is not particularly limited, and for example, an air cylinder is used.

Since the extrusion portion 105 presses the flexographic printing plate precursor 70, it is preferable to have strength so as not to deform and is formed of, for example, austenitic stainless steel, such as SUS304 and SUS303, which easily performs cutting or martensite-based stainless steel that can obtain hardness of 50 or more in Rockwell Hardness C scale (HRC) by quenching.

Due to the driving unit 104, the extrusion portion 105 protrudes from the first position in a longitudinal direction of the pin 37d, the back surface 70b of the flexographic printing plate precursor 70 is pressed, and the flexographic printing plate precursor 70 is removed from the pin 37d.

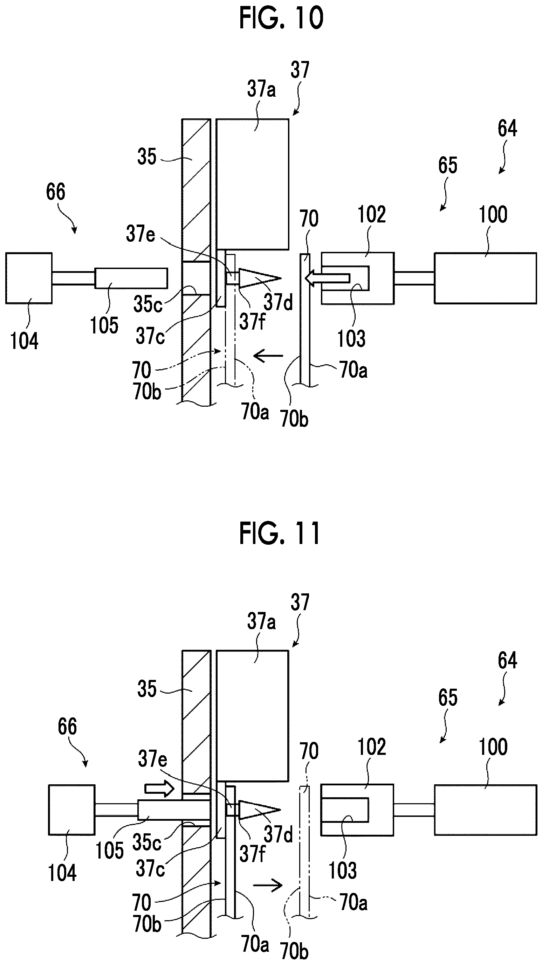

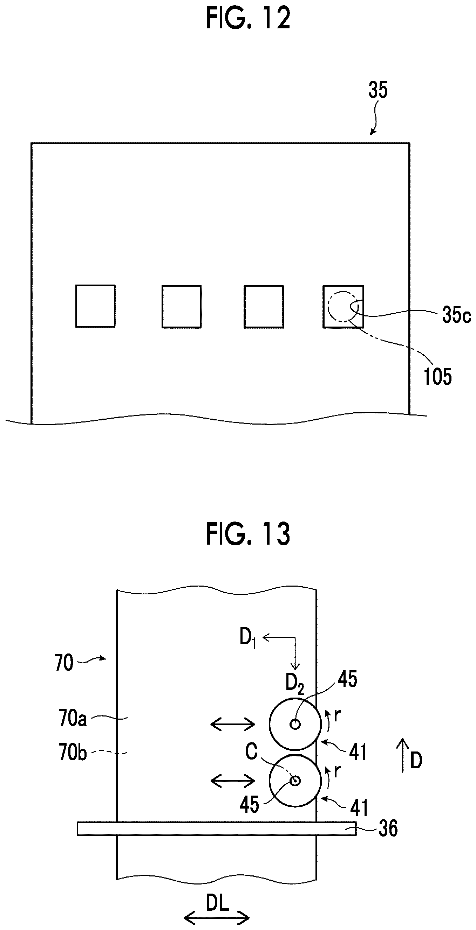

Fig. 10 is a schematic view showing another example of attachment of the flexographic printing plate precursor by the detachment and attachment unit of the washout processor according to the embodiment of the present invention, and Fig. 11 is a schematic view showing another example of removal of the flexographic printing plate precursor by the detachment and attachment unit of the washout processor according to the embodiment of the present invention. Fig. 12 is a schematic view showing an example of the back plate portion of the washout processor according to the embodiment of the present invention. In Figs. 10 to 12, the same components as the washout processor 10 shown in Figs. 1 to Fig. 3 will be assigned with the same reference numerals, and detailed description thereof will be omitted.

As shown in Fig. 10, the back plate portion 35 of the leading end leader 37 may be provided on a plate detachment portion 66 side. In a case where the back plate portion 35 pushes out the pushing portion 102 of the plate attachment portion 65 toward the pin 37d, the back plate portion 35 supports the attaching portion 37c of the leading end leader 37. Thus, in a case where the pin 37d is brought into contact with the flexographic printing plate precursor 70, the attaching portion 37c is stably prevented from being displaced, the pin 37d passes through the flexographic printing plate precursor 70, and the flexographic printing plate precursor 70 is more reliably fixed to the leading end leader 37.

In addition, in a case where the back plate portion 35 is provided as shown in Fig. 11, an opening portion 35c is provided in the back plate portion 35 corresponding to a region where there is no attaching portion 37c of the leading end leader 37 as shown in Fig. 12. The plate detachment portion 66 is disposed such that the extrusion portion 105 passes through the opening portion 35c.

### (Developing Portion)

Insofar as the non-exposed portion (not shown) of the flexographic printing plate precursor 70 can be removed and developed, the configuration of the developing portion 12 is not particularly limited and is not limited to development using the brush 41 to be described later. The configuration of the brush is also not particularly limited, and a rotary brush and a brush having a rotation axis parallel to the nip roller 36 can also be used in addition to the configuration of the brush 41 to be described later. In this case, a roller-shaped brush in which bristles are bundled radially with respect to a rotation axis can be used. In the developing portion 12, the configuration of the brush, the number of brushes, and the like are not particularly limited.

For example, the developing portion 12 has a developing unit 40 that performs development on the flexographic printing plate precursor 70 which is in a state of being immersed in the washing solution Q in the developing tank 13 and is transported.

In the developing portion 12, a fatiqued developer Qw is generated in the developing tank 13 due to development by the developing unit 40. The fatiqued developer Qw is the washing solution Q containing solid substances generated by removing the non-exposed portion (not shown) of the flexographic printing plate precursor 70 due to development using the washing solution Q. The developing portion 12 performs development, for example, using the washing solution Q stored in the developing tank 13.

The flexographic printing plate precursor in a state where the non-exposed portion is removed due to development is called a developed flexographic printing plate precursor.

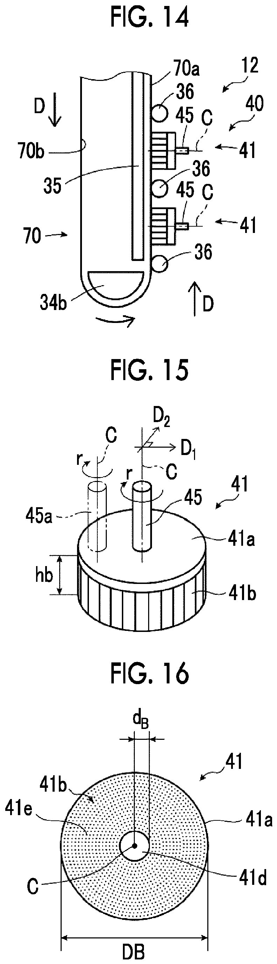

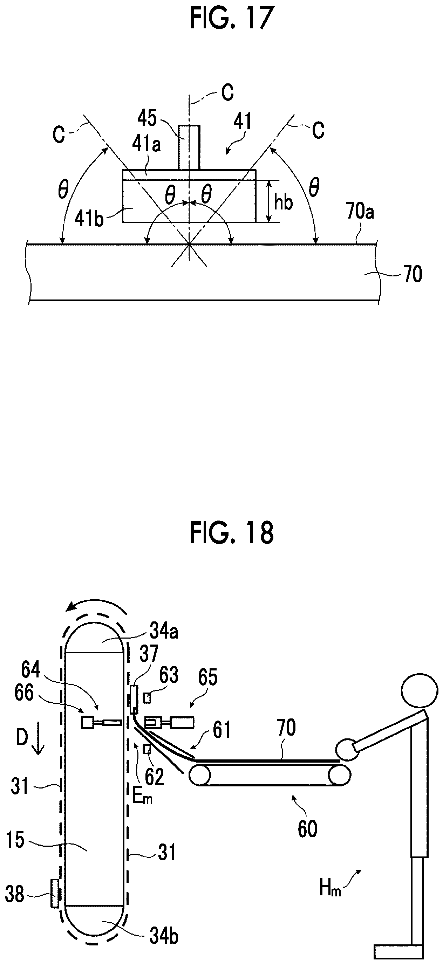

Herein, Fig. 13 is a schematic plan view showing an example of the developing portion of the washout processor according to the embodiment of the present invention, and Fig. 14 is a schematic side view showing the example of the developing portion of the washout processor according to the embodiment of the present invention. In addition, Fig. 15 is a schematic perspective view showing a configuration of the brush of the washout processor according to the embodiment of the present invention, and Fig. 16 is a schematic plan view showing a bristle side of the brush of the washout processor according to the embodiment of the present invention. Fig. 17 is a schematic view showing the configuration of the brush of the washout processor according to the embodiment of the present invention. A part of the nip roller 36 is not shown in Fig. 13.

The developing unit 40 of the developing portion 12 has the brush 41 used in development and a driving unit 26 that controls rotation about a rotation axis C (see Fig. 15) of the brush 41 and movement of the brush 41. In the configuration of the developing unit 40 shown in Fig. 13, there are two brushes 41. The two brushes 41 are arranged along the transport direction D of the flexographic printing plate precursor 70. In addition, the rotation axis C (see Fig. 15) of the brush 41 is in a direction perpendicular to the front surface 70a of the flexographic printing plate precursor 70.

In the developing unit 40, development can be simultaneously performed by the two brushes 41. Accordingly, an area rubbed by the brushes 41 can be increased, and a development speed can be increased in a state where the adhesion of development residues is prevented and development uniformity is maintained. In this case, the rotation speeds of a plurality of brushes 41 may be the same, or the rotation speed may be changed for each of the plurality of brushes 41. In addition, the sizes of the two brushes 41 may be the same or may be different from each other.

In a case where a plurality of brushes are provided, for example, at least two brushes may be simultaneously driven by one motor instead of rotating each brush. In a case of the two brushes 41, at least the two brushes 41 may be simultaneously driven by one motor instead of rotating each brush 41. Accordingly, the number of motors can be reduced, and thus the device can be miniaturized. In addition, in a case where the plurality of brushes are rotated by one motor, the rotation speed can be changed for each brush 41 by providing a transmission. Accordingly, the number of motors can be reduced, and thus the device can be miniaturized. In addition, in a case where the plurality of brushes are rotated by one motor, the rotation speed can be changed for each brush 41 by providing a transmission.

The rotation about the rotation axis C of the brush 41 described above is rotation of the brush 41 with the rotation axis C as a rotation center, and the brush 41 spins. The rotation axis C is a fixed axis passing through one point in the brush 41. A rotation shaft portion 45 is provided at the brush 41, and a central axis of the rotation shaft portion 45 is the rotation axis C. The rotation shaft portion 45 functions as a rotation drive shaft that is rotated as power is transmitted from the driving unit 26, and the brush 41 spins, for example, in a rotation direction r as the rotation shaft portion 45 is rotated.

The driving unit 26 rotates the brush 41 in a state where the rotation axis C of the brush 41 passes through the front surface 70a of the flexographic printing plate precursor 70 (see Fig. 17). The driving unit 26 moves the rotation axis C of the brush 41 in at least one direction intersecting the rotation axis C. The rotation of the brush 41 and the movement of the brush 41 are controlled by the driving unit 26 unless stated otherwise.

As shown in Fig. 13, the brush 41 is disposed on the front surface 70a side of the flexographic printing plate precursor 70, and for example, the direction DL orthogonal to the transport direction D is set as a first moving direction Di of the brush 41, which intersects the rotation axis C. The brush 41 is configured to move in the direction DL. In addition, the brush 41 may be configured to be moved in two directions with respect to the rotation axis C. In a case of being moved in two directions, the two directions are not particularly limited insofar as the brush is moved in two directions, may be two directions intersecting the rotation axis C, or may be two directions orthogonal to the rotation axis C. Specifically, for example, the first moving direction Di is the direction DL, and a second moving direction D₂ is the transport direction D. Insofar as the brush 41 can uniformly rub the entire front surface 70a of the flexographic printing plate precursor 70, the moving directions of the brush 41 are not particularly limited. Insofar as the brush 41 is configured to be moved in the two directions orthogonal to each other, the entire front surface 70a of the flexographic printing plate precursor 70 can be uniformly rubbed by the brush 41, and development uniformity improves. Further, the development speed also improves by moving the brush 41 in the two directions orthogonal to each other.

In a case where the two brushes 41 are arranged along the transport direction D of the flexographic printing plate precursor 70, it is preferable to change at least one of a density at which bristles 41b are planted or the thickness of the bristles 41b in the first brush 41 and the second brush 41. While development proceeds even with the same processing time with a brush having a high-density or thick bristles, a finished state related to print quality, such as independent small dots, deteriorates in some cases. Thus, in a case of disposing two or more brushes 41 in the transport direction D, it is preferable to first dispose a type of brush that makes development progress quickly and to dispose a type of brush that is excellent in development treatment quality as a brush in the latter half of the development.

### <Brush>

The brush 41 performs development by removing the non-exposed portion (not shown) of the flexographic printing plate precursor 70. For example, the brush 41 is immersed in the washing solution Q and is disposed on the front surface 70a side of the flexographic printing plate precursor 70 in the transport direction D in the developing tank 13. In a state where the flexographic printing plate precursor 70 is transported, the front surface 70a of the flexographic printing plate precursor 70 is rubbed as the brush 41 is rotated in the rotation direction r (see Fig. 13) by the driving unit 26, and development is performed by removing the non-exposed portion (not shown) of the flexographic printing plate precursor 70. During the development, the fatiqued developer Qw described above is generated.

Since the brush 41 is disposed by being immersed in the washing solution Q, the washing solution Q adhered to the brush 41 is not dried, and the non-exposed portion or the like removed by the brush 41 is prevented from being fixed to the brush 41 as development residues.

The area of the brush 41, which is obtained by projecting the brush 41 onto the front surface 70a of the flexographic printing plate precursor 70, is smaller than the area of the front surface 70a of the flexographic printing plate precursor 70. For this reason, the brush 41 is partially applied with respect to the entire width of the flexographic printing plate precursor 70 and performs development. During development, since the brush 41 is small, the brush 41 moves, for example, in the transport direction D and the direction DL as described above in order for the brush 41 to uniformly rub the entire front surface 70a of the flexographic printing plate precursor 70, but may be configured to move only in the direction DL.

A moving path of the brush 41 is determined in advance according to the size of the brush 41, the size and the transportation speed of the flexographic printing plate precursor 70, or the like. Accordingly, the moving path of the brush 41 is programmed in the driving unit 26, and the driving unit 26 can move the brush 41 along the moving path to perform development based on the program.

As shown in Fig. 15, the brush 41 is obtained, for example, by bundling the bristles 41b perpendicular to a substrate 41a. The shape of the substrate 41a is the shape of the brush 41. For example, the substrate 41a is circular, but is not particularly limited thereto.

The rotation shaft portion 45 is provided on the substrate 41a. Accordingly, the rotation axis C is provided in the brush 41. In addition, by adjusting a position where the rotation shaft portion 45 is provided, the position of the rotation axis C can be adjusted in the brush 41. As shown in Fig. 15, a rotation shaft portion 45a can also be provided at a place other than the center of the substrate 41a.

Herein, the center of the brush 41 is the center of the substrate 41a of the brush 41, that is, the geometric center of a shape obtained by projecting the substrate 41a onto a plane. In a case where the substrate 41a is circular, the center of the circle is the center of the brush 41. In a case where the substrate 41a is rectangular, a point where diagonals of the rectangle intersect each other is the center of the brush 41.

The expression that the rotation axis C of the brush 41 passes through the center of the brush 41 means that the rotation shaft portion 45 is disposed such that the rotation axis C passes through the center of the substrate 41a in a case where the substrate 41a is circular. As the rotation axis C is disposed to pass through the center of the brush 41, the brush 41 can be uniformly brought into contact with the front surface 70a of the flexographic printing plate precursor 70. For this reason, development uniformity improves.

In addition, as the rotation axis C is disposed to pass through the center of the brush 41, the brush 41 rotates stably in a case where the brush 41 spins. For this reason, the brush can be stably rotated even in a case where the number of rotations is increased in order to increase the rotation speed of the brush 41. Accordingly, the development speed can be increased.

In addition, in a case where the plurality of brushes 41 are disposed in parallel, contact between the brushes 41 can be prevented even in a case where an interval between the brushes 41 is decreased. For this reason, the rotation axis C of the brush 41 preferably passes through the center of the brush 41.

For example, a brush called a cup brush is used as the brush 41. It is preferable that the bristles 41b of the brush 41 are used by being applied substantially perpendicular to the front surface 70a of the flexographic printing plate precursor 70.

The brush 41 is smaller than the flexographic printing plate precursor 70 as described above. As the brush 41 is small, the brush 41 is moved and performs development on the flexographic printing plate precursor 70, the pressure of the brush 41 can be made uniform, and development uniformity can be improved.

Further, since a brush area necessary for development can be reduced as the brush 41 performs development by moving in a plane direction while the flexographic printing plate precursor 70 is transported, the washout processor can be simplified.

The size of the brush 41 is not particularly limited insofar as the brush is smaller than the flexographic printing plate precursor 70. In a case where the outer shape of the substrate 41a of the brush 41 is circular, a diameter DB (see Fig. 16) thereof is preferably 30 mm to 500 mm, the diameter DB is more preferably 100 to 400 mm, and the diameter DB is most preferably 200 to 400 mm.

In a case where the shape of the substrate 41a of the brush 41 is a brush shape other than a circle, a diameter equivalent to the circle, that is, a diameter corresponding to the brush area is used as the diameter in a case where the outer shape of the substrate 41a described above is circular.

In addition, the brush 41 rotates and performs development, but the rotation speed of the brush 41 is preferably 10 revolutions per minute (rpm) to 2,000 rpm, more preferably 20 to 800 rpm, and even more preferably 30 to 200 rpm.

By increasing the number of rotations of the brush 41 and increasing the rotation speed, the development speed can be increased as described above, and development uniformity also improves.

Herein, as for a mechanism of adhesion of development residues, it is estimated that development residues are deposited in the brush 41, are transferred and adhered to the flexographic printing plate precursor 70 at a certain timing during development. For this reason, it is necessary to efficiently discharge the development residues from the inside of the brush 41 to the outside of the brush 41. Thus, in a case where the rotation speed of the brush 41 is high, the washing solution in the brush 41 is likely to be discharged to the outside of the brush 41 due to rotation, and development residues in the brush 41 can be efficiently discharged to the outside of the brush 41.

In addition, the rotation speed of the brush 41 is not limited to being a fixed value and may be variable. In a case where the rotation speed of the brush 41 is variable, for example, the rotation speed is determined in advance from the initial stage of development to the end of development, and development can be performed at the determined rotation speed.

The substrate 41a of the brush 41 holds the bristles 41b, and for example, the bristles are implanted in a bundle. Insofar as the substrate 41a can hold the bristles 41b and does not become deteriorated due to the washing solution Q, there is no particular limitation.

The material for the bristles of the brush 41 is not particularly limited. For example, natural fibers, such as coir, and any material that can be made into a fibrous form, such as a metal, polyamide, polyester, vinyl chloride, vinylidene chloride, polyimide, and polyacrylonitrile, are suitably used.

The fiber diameter of each bristle of the brush is preferably approximately 10 µ to 1 mm and may be implanted in a bundle or be independently implanted within several bristles. The implanting interval is preferably approximately 1 to 20 mm, and in a case of being implanted in a bundle, the diameter of the bundle is preferably approximately 1 to 10 mm. In addition, a length hb (see Figs. 15 and 17) of each of the bristles of the brush is preferably approximately 2 to 50 mm and more preferably 5 to 25 mm. In a case where the length hb of each of the bristles of the brush is 5 to 25 mm, the leading end leader 37 and the trailing end leader 38 for transport can be passed through, a brush force becomes strong so that independent small dot performance is obtained, and a development speed thereof also increases.

The length of each of the bristles may vary in one brush 41, and it is preferable that bristles in a central portion are long. In addition, the thickness of each of the bristles in one brush 41 may vary, or the density of the bristles in one brush 41 may vary.

The bristles 41b of the brush 41 are bundled on the substrate 41a. As shown in Fig. 16, the bristles 41b are provided in a region 41e other than a region 41d where a radius with respect to the center of the substrate 41a is within 10 mm. That is, it is preferable that the bristles 41b are not provided in the region 41d where a radius d_{B} with respect to the rotation axis C is 10 mm, and the bristles 41b are provided in the region 41e other than the region 41d. As described above, it is preferable that in the brush 41, the bristles 41b are not provided in the region 41d where the radius d_{B} with respect to the rotation axis C is within 10 mm, and the bristles 41b are provided in the region 41e where the radius da exceeds 10 mm.

In a case where the bristles 41b are provided in the region 41e of the brush 41 other than the region 41d where the radius is within 10 mm, development residues are likely to be discharged, the rotation speed also increases, and independent small dot performance is obtained during development, which are preferable.

In order to maintain the development speed of the brush 41, it is preferable that the bristles 41b are provided in a region of 30% or more of the substrate 41a. The fact that the bristles 41b are provided in an area of 30% or more of the substrate 41a of the brush 41 means that the area of the bristles is 30%.

As described above, the driving unit 26 (see Fig. 1) rotates the brush 41 in a state where the rotation axis C of the brush 41 passes through the front surface 70a of the flexographic printing plate precursor 70 (see Fig. 17). In this case, as shown in Fig. 17, in a case where an angle formed by the rotation axis C with respect to the front surface 70a of the flexographic printing plate precursor 70 is set as θ, the angle θ is preferably 30° ≦ θ ≦ 90°, more preferably 45° ≦ θ ≦ 90°, and most preferably 60° ≦ θ ≦ 90°. By setting the angle θ to 60° ≦ θ ≦ 90°, the brush 41 can be uniformly brought into contact with the front surface 70a of the flexographic printing plate precursor 70, and development can be performed even in a case where the pressure of the brush 41 is increased. For this reason, both of the development uniformity and the development speed can be increased. As described above, it is most preferable that the rotation axis C of the brush 41 is perpendicular to the front surface 70a of the flexographic printing plate precursor 70.

The angle θ can be obtained as follows. First, an image of a state where the brush 41 is disposed on the front surface 70a of the flexographic printing plate precursor 70 is acquired, a line corresponding to the rotation axis C of the brush 41 and a line corresponding to the front surface 70a of the flexographic printing plate precursor 70 are acquired from the image. Next, an angle formed by the two lines is acquired. Accordingly, the angle θ can be obtained.

A state where the rotation axis C of the brush 41 passes through the front surface 70a of the flexographic printing plate precursor 70 means passing through the front surface 70a of the flexographic printing plate precursor 70 or a surface obtained by expanding the front surface 70a of the flexographic printing plate precursor 70 in a case where the rotation axis C or the rotation axis C is extended, and shows a disposition relationship between the brush 41 and the flexographic printing plate precursor 70.

For this reason, the rotation axis C of the brush 41 does not pass through the actual front surface 70a of the flexographic printing plate precursor 70 in some cases depending on the inclination of the rotation axis C, but the rotation axis C of the brush 41 is not limited to actually passing through the front surface 70a of the flexographic printing plate precursor 70 as described above.

The position of the brush 41 with respect to the front surface 70a of the flexographic printing plate precursor 70 may be fixed. In addition, a configuration where the brush approaches or is spaced apart from the front surface 70a of the flexographic printing plate precursor 70 may be adopted. As the brush 41 can approach or be spaced apart from the front surface 70a of the flexographic printing plate precursor 70, the pressure of the brush 41 can be adjusted with respect to the front surface 70a of the flexographic printing plate precursor 70. Accordingly, the pressure of the brush 41 can be increased, and the development speed can be improved.

In a case where the pressure of the brush 41 is increased, it is preferable that the material for the bristles 41b of the brush 41, the length of each bristle, the thickness of each bristle, or the like corresponds to the pressure. The bristles of the central portion in one brush 41 may be made long, the thickness of each of bristles in one brush 41 may be changed, or the density of the bristles in one brush 41 may be changed.

In addition, as the brush 41 can be spaced apart from the front surface 70a of the flexographic printing plate precursor 70, the brush 41 can be lifted from the front surface 70a of the flexographic printing plate precursor 70. Accordingly, in a case where development residues of the brush 41 are adhered, the development residues can be removed from the brush 41.

As for the operation of the brush 41, the brush 41 may move constantly during development, or the brush 41 may rotate only in a case where the flexographic printing plate precursor 70 is transported to the developing tank 13. In this case, for example, a sensor (not shown) that detects the flexographic printing plate precursor 70 is provided above the developing tank 13, a time when the brush 41 is reached is identified using a transport timing and the transportation speed of the flexographic printing plate precursor 70, and development can be performed by rotating the brush 41.

In addition, for example, the outside of the flexographic printing plate precursor 70 and the upper side of the front surface 70a of the flexographic printing plate precursor 70 can be used as a retracting place for the brush 41. The driving unit 26 moves the brush 41 to the retracting place, and the driving unit 26 causes the brush 41 to retract from the flexographic printing plate precursor 70. By retracting the brush 41 from the flexographic printing plate precursor 70, development residues are prevented from adhering, which is preferable.

In a case where the retracting place is outside the flexographic printing plate precursor 70, the development residues are unlikely to adhere to the front surface 70a of the flexographic printing plate precursor 70 again, and the development residues can be further prevented from adhering compared to a case where the brush 41 is retracted by being simply lifted from the front surface 70a of the flexographic printing plate precursor 70.

In a case of removing the development residues, in addition to moving the brush 41 to the retracting place, retracting conditions such as a development time and a development treatment area are set, and in a case where the retracting conditions are satisfied, the brush 41 may be configured to be moved to the retracting place. In this case, for example, the sensor (not shown) that detects the flexographic printing plate precursor 70 is provided above the developing tank 13, the retracting conditions are set in the driving unit 26, the input amount of the flexographic printing plate precursor 70 is identified using the transport timing and the transportation speed of the flexographic printing plate precursor 70, and the retraction of the brush 41 can be controlled.

In addition, in order to efficiently discharge the development residues in the brush 41 to the outside of the brush 41, the washing solution may be supplied to the brush 41 at the retracting place for the brush 41, and the development residues may be discharged to the outside of the brush 41.

### (Rinsing Unit)

The rinsing unit 14 removes residues, such as latex components and rubber components remaining on the front surface 70a of the developed flexographic printing plate precursor 70 taken out from the developing portion 12, using a rinsing liquid such as a washing solution. Removing residues, such as latex components and rubber components remaining on the front surface 70a of the flexographic printing plate precursor 70, using a rinsing liquid such as a washing solution, by the rinsing unit 14 is called a rinsing step.

The developed flexographic printing plate precursor 70 is transported from the developing portion 12, is transported to the outside of the developing tank 13, and is processed by the rinsing unit 14.

The rinsing unit 14 has, for example, a supply unit 22 that supplies the fatiqued developer Qw processed by the processing unit 18 to the front surface 70a of the flexographic printing plate precursor 70. The fatiqued developer Qw processed by the processing unit 18 is supplied to the supply unit 22 via a pipe 20. The supply unit 22 is a nozzle that is for at least supplying the washing solution Q to the front surface 70a of the flexographic printing plate precursor 70, from which the non-exposed portion of the flexographic printing plate precursor 70 is removed. The rinsing liquid may be water other than the washing solution and the fatiqued developer Qw described above.

It is preferable for the supply unit 22 to have a jetting type spray nozzle. The type of jetting type spray nozzle is not particularly limited and may be, for example, one-fluid type using only a liquid or may be two-fluid type using a liquid and air.

The rinsing unit 14 applies, as the washing solution Q from the supply unit 22, the fatiqued developer Qw processed by the processing unit 18, for example, to the front surface 70a of the developed flexographic printing plate precursor 70, for example, in a spray-like manner, washing away the residues described above. The fatiqued developer Qw supplied from the supply unit 22 and the residues, which are washed away and are described above, accumulate in the developing tank 13.

It is preferable that the rinsing unit 14 is provided such that the rinsing liquid is supplied to a liquid film generated by the washing solution remaining on the developed flexographic printing plate precursor 70 taken out from the developing portion 12.

For a reason that the liquid film generated by the washing solution is likely to flow into the developing tank 13 together with the rinsing liquid, a position to which the rinsing liquid is supplied is preferably 50 cm or lower, is more preferably 30 cm or lower, and is even more preferably 15 cm or lower from the liquid level of the washing solution.

As the used rinsing liquid supplied from the rinsing unit 14 flows into the developing tank 13, a total waste liquid amount can be reduced. In particular, in a case where the transport path is in an up-down direction, an effect of reducing the waste liquid amount is large. For this reason, it is preferable that the used rinsing liquid flows into the developing tank 13 also in the rinsing step.

The rinsing liquid supply amount of the rinsing liquid supplied for each unit area of the flexographic printing plate precursor to which the rinsing liquid is supplied is preferably sprayed at 0.3 to 7 kg/m² and more preferably at 0.5 to 4 kg/m². As the rinsing liquid supply amount described above is set to 0.3 kg/m² or more, the residues described above, which remain on the front surface 70a of the developed flexographic printing plate precursor 70, can be stably washed away. On the other hand, as the rinsing liquid supply amount described above is set to 7 kg/m² or less, the inflow amount of rinsing liquid into the developing tank 13 is reduced, and the waste liquid amount can be reduced.

As the rinsing liquid, the washing solution Q to be supplied may be the washing solution Q newly prepared in another tank (not shown). In this case, as shown in Fig. 1, a supply pipe 21a is connected to the pipe 20, and a valve 21b is provided at the supply pipe 21a and is connected to a rinsing liquid supply unit 21. The rinsing liquid supply unit 21 stores the washing solution Q and supplies the washing solution Q to the supply unit 22 at a specific flow rate. The rinsing liquid is the washing solution Q.

During the rinsing step, the washing solution Q is supplied as the rinsing liquid from the rinsing liquid supply unit 21 to the supply unit 22 via the valve 21b and the supply pipe 21a.

### (Processing Unit)

The processing unit 18 removes solid substances 23 in the fatiqued developer Qw containing the solid substances 23 generated by removing the non-exposed portion due to development using the washing solution Q. The fact that the fatiqued developer Qw contains the solid substances 23 means a state where the solid substances 23 are dissolved or dispersed.

In addition, the processed fatiqued developer Qw is the fatiqued developer Qw from which the solid substances 23 contained in the fatiqued developer Qw are removed.

The solid substances 23 removed by the processing unit 18 from the fatiqued developer Qw are collected by a saucer 19 provided below the processing unit 18.

On the other hand, the fatiqued developer Qw from which the solid substances 23 are removed, that is, the processed fatiqued developer Qw described above is supplied to the supply unit 22 through the pipe 20 and is used in the rinsing unit 14. For example, a pump (not shown) is used to supply the processed fatiqued developer Qw from the processing unit 18 to the supply unit 22.

Since the fatiqued developer Qw can be reused by providing the processing unit 18, the washing solution Q can be effectively used, and the using efficiency of the washing solution Q can be increased.

The configuration of the processing unit 18 is not particularly limited insofar as the solid substances 23 can be removed from the fatiqued developer Qw as described above, and the processing unit is composed of, for example, a centrifuge.

In addition, a separation membrane 24 that removes the solid substances 23 in the fatiqued developer Qw may be provided in the pipe 20. The separation membrane 24 is not particularly limited insofar as the solid substances contained in the fatiqued developer Qw can be separated out and is determined as appropriate according to the size of a solid substance to be separated out. For example, a ceramic filter is used. It is preferable that the separation membrane 24 can separate out, for example, a solid substance having a particle diameter of 1 µm or less.

The separation membrane 24 is not necessarily required, and a configuration where the separation membrane is not provided may be adopted. However, causing the fatiqued developer Qw to pass through the separation membrane 24 can further decrease the concentration of solid substances of the fatiqued developer Qw supplied to the rinsing unit 14 and is preferable since the rinsing unit 14 can use the fatiqued developer Qw having a low concentration of solid substances.

In addition, the separation membrane 24 may be configured to be used as the processing unit 18. In this case, for example, only the separation membrane 24 is provided without providing the centrifuge described above.

The processing unit 18 is not necessarily required, and a configuration where there is no processing unit 18 may be adopted. In this case, for example, the rinsing unit 14 uses the washing solution Q.

Herein, the higher the concentration of solid substances contained in the fatiqued developer Qw, the more development residues are fixed, which is more likely to contaminate the device. Therefore, the lower the concentration of solid substances in the fatiqued developer Qw, the better maintainability, since the contamination of the device can be prevented. For this reason, it is preferable to provide the processing unit 18 that removes solid substances.

### (Washing Method)

Next, the washing method for the flexographic printing plate precursor 70, in which the washout processor 10 is used, will be described.

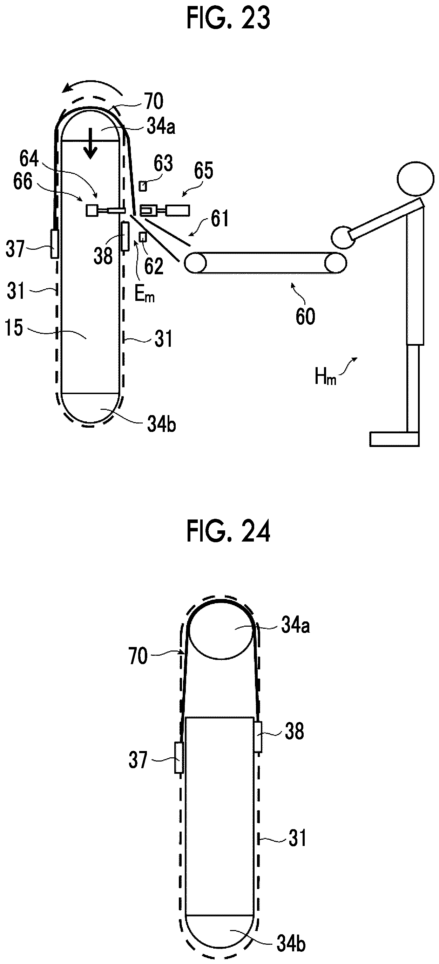

Figs. 18 to 23 are schematic views showing an example of development treatment by the washout processor according to the embodiment of the present invention in order of steps. Fig. 24 is a schematic view showing an example of an attachment form of the flexographic printing plate precursor of the washout processor according to the embodiment of the present invention. In Figs. 18 to 24, the same components as the washout processor 10 shown in Figs. 1 to Fig. 3 will be assigned with the same reference numerals, and detailed description thereof will be omitted. In addition, in Figs. 18 to 24, showing is omitted in order to describe the fixing, removal, and transport of the flexographic printing plate precursor of the washout processor.

First, the front surface 70a of the flexographic printing plate precursor 70 is imagewise exposed, that is, exposed in a specific pattern by the exposure device (not shown).

In the washout processor 10, for example, the leading end leader 37 is fixed by being hooked or the like to the fixing units 31b of the pair of transport chains 31 respectively. For example, the trailing end leader 38 is fixed to the fixing units 31b of the transport chains 31 using a magnet. Accordingly, the leading end leader 37 and the trailing end leader 38 are transported in the transport passage by the transporting unit 11.

Next, as shown in Fig. 18, for example, an operator Hₘ disposes the imagewise exposed flexographic printing plate precursor 70 in the feeding device 60. In this case, the leading end leader 37 is disposed at the attachment and detachment station Eₘ, and the pin 37d of the leading end leader 37 and the pushing portion 102 of the plate attachment portion 65 face each other at the attachment and detachment station Eₘ. The position of the leading end leader 37 is detected by the sensor 63, and the position is adjusted by the transport driving unit 32.

The flexographic printing plate precursor 70 is fed from the feeding device 60 toward the leading end leader 37 via the guide 61.

Next, in the plate attachment portion 65, the driving unit 100 moves the pushing portion 102 toward the pin 37d, the pushing portion 102 is pushed from the front surface 70a side of the flexographic printing plate precursor 70 to the pin 37d, and the pin 37d is passed through the flexographic printing plate precursor 70. Accordingly, the flexographic printing plate precursor 70 is fixed to the leading end leader 37.

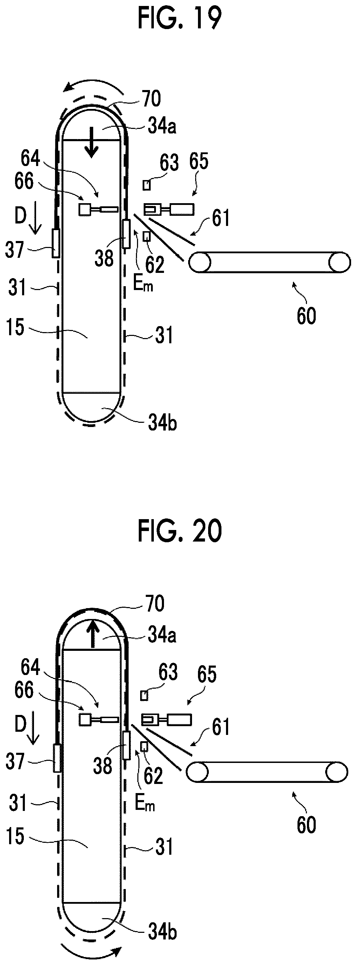

Next, after fixing the flexographic printing plate precursor 70 to the leading end leader 37, as shown in Fig. 19, the turn bar 34a is lowered, the leading end leader 37 is moved by the transport driving unit 32, and the trailing end leader 38 is moved to a position where the pin 38d faces the pushing portion 102. In this case, the trailing end leader 38 is detected by the sensor 62.

In a state where the turn bar 34a is lowered, as shown in Fig. 24, in the flexographic printing plate precursor 70, the transport path is shorter than the transport chain 31 in a portion where there is no turn bar 34a, and a so-called short pass state is caused. In this state, the tension of the flexographic printing plate precursor 70 is low, and the detachment and attachment of the flexographic printing plate precursor 70 with respect to the trailing end leader 38 can be easily performed.

Next, in the plate attachment portion 65, the driving unit 100 moves the pushing portion 102 toward the pin 38d, the pushing portion 102 is pushed from the front surface 70a side of the flexographic printing plate precursor 70 to the pin 38d, and the pin 38d is passed through the flexographic printing plate precursor 70. Accordingly, the flexographic printing plate precursor 70 is fixed to the trailing end leader 38. In this manner, the leading end of the flexographic printing plate precursor 70 is fixed to the leading end leader 37, and the trailing end is fixed to the trailing end leader 38. In a state where the flexographic printing plate precursor 70 is fixed to the leading end leader 37 and the trailing end leader 38, as shown in Fig. 20, the turn bar 34a is raised from a lowered state, and tension is applied to the flexographic printing plate precursor 70. As described above, the flexographic printing plate precursor 70 is fixed to the leaders, and a force acts in the direction in which the length of the flexographic printing plate precursor 70 extends in a state where the flexographic printing plate precursor 70 is fixed to the leaders. After fixing the flexographic printing plate precursor 70, tension applied to the flexographic printing plate precursor 70 is made higher than tension applied to the flexographic printing plate precursor 70 in a case of fixing the flexographic printing plate precursor 70 to the leaders shown in Fig. 19.

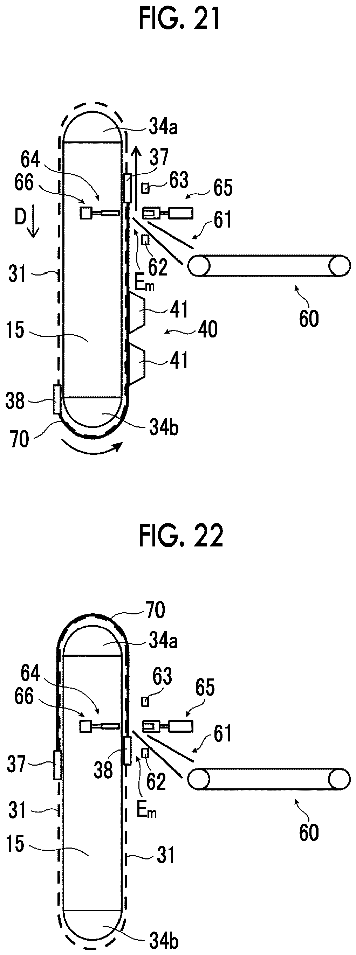

Next, as shown in Fig. 21, the flexographic printing plate precursor 70 is transported along the transport path Dp by the transporting unit 11. In a state where the flexographic printing plate precursor 70 is immersed in the washing solution Q and is transported, the brush 41 of the developing unit 40 performs development by removing the non-exposed portion of the flexographic printing plate precursor 70 as described above. In a developing step of performing the development, while transporting the flexographic printing plate precursor 70, for example, the brush 41 is rotated in a state where the rotation axes C of the two brushes 41 pass through the front surface 70a of the flexographic printing plate precursor 70, and the rotation axes C of the brushes 41 are moved in at least one direction intersecting the rotation axes C as described above. Since the operations of the brushes 41 are as described above, detailed description thereof will be omitted. In the developing step, the fatiqued developer Qw is generated.

Then, the flexographic printing plate precursor 70 comes out of the developing tank 13. In a state where the flexographic printing plate precursor 70 is transported, the supply unit 22 applies, for example, the fatiqued developer Qw processed by the processing unit 18 to the front surface 70a of the flexographic printing plate precursor 70, and residues on the front surface 70a are removed. Then, the flexographic printing plate precursor 70 is transported until the flexographic printing plate precursor passes through the rinsing unit 14. In a case of performing development once, at this time point, the fixing of the leading end leader 37 and the trailing end leader 38 is released as will be described later, and the flexographic printing plate precursor 70 is removed from the leading end leader 37 and the trailing end leader 38. In a case of performing development a plurality of times, the flexographic printing plate precursor 70 is transported by going around and is transported to the developing portion 12 again to perform development. Until a predetermined number of times is reached, the developing step and the rinsing step are performed repeatedly.

For example, after the developing step ends, as shown in Fig. 22, the trailing end leader 38 is moved to the attachment and detachment station Eₘ for the flexographic printing plate precursor 70. At the plate detachment portion 66, due to the driving unit 104, the extrusion portion 105 disposed in the region where the attaching portion 38c is not provided protrudes from the first position in a longitudinal direction of the pin 38d, the back surface 70b of the flexographic printing plate precursor 70 is pressed, and the flexographic printing plate precursor 70 is removed from the pin 38d. Accordingly, the fixing is released, and the flexographic printing plate precursor 70 is removed from the trailing end leader 38.

Next, as shown in Fig. 23, the turn bar 34a is lowered, and the tension of the flexographic printing plate precursor 70 is decreased. In this case, as described above, the flexographic printing plate precursor 70 is a so-called short pass (see Fig. 24). In this state, the tension of the flexographic printing plate precursor 70 is low.

Next, the flexographic printing plate precursor 70 is pressed by the extrusion portion 105 and is guided by the guide 61. Then, the extrusion portion 105 is restored to the first position.

Next, the transport driving unit 32 drives the transport chain 31 to move the leading end leader 37 in an opposite direction to the transport direction D, and the flexographic printing plate precursor 70 is carried to the conveyor belt 60c of the feeding device 60. Next, the drive roller 60a is rotated to rotationally move the conveyor belt 60c, and the flexographic printing plate precursor 70 is placed on the conveyor belt 60c. In a case where the leading end leader 37 is moved to the attachment and detachment station Eₘ shown in Fig. 18, the driving of the transport chain 31 is stopped. The movement of the leading end leader 37 to the attachment and detachment station Eₘ shown in Fig. 18 is detected by the sensor 63.

At the plate detachment portion 66, due to the driving unit 104, the extrusion portion 105 disposed in the region where the attaching portion 37c is not provided protrudes from the first position in the longitudinal direction of the pin 37d, the back surface 70b of the flexographic printing plate precursor 70 is pressed, and the flexographic printing plate precursor 70 is removed from the pin 37d. Accordingly, the fixing is released, the flexographic printing plate precursor 70 is removed from the leading end leader 37, the conveyor belt 60c of the feeding device 60 is moved rotationally, and the flexographic printing plate precursor 70 is placed on the conveyor belt 60c. The operator Hₘ collects the development-treated flexographic printing plate precursor 70 on the conveyor belt 60c.

By setting the transport path Dp that goes around the vicinity of the frame 15 as in the washout processor 10, a provision area can be decreased compared to a transport path through which the flexographic printing plate precursor 70 is transported in one direction.

By changing the sizes of the member 15a and the beam member 15b of the frame 15, it is possible to correspond to the size of the flexographic printing plate precursor 70. Even in a case where the flexographic printing plate precursor 70 is large, the configuration of the washout processor 10 does not become complicated.

Further, by making the frame 15 in an upright state as shown in Fig. 1 and configuring the flexographic printing plate precursor 70 to be transported perpendicularly to the liquid level of the washing solution Q in the developing tank 13, a grounding area can be decreased compared to a state where the frame 15 is rotated 90° from the state shown in Fig. 1, and the space can be saved. In addition, even in a case where the transport path Dp is long, without increasing the washout processor 10 in size, the grounding area can be decreased, and the space can be saved. In a state where the frame 15 is rotated 90° from the state shown in Fig. 1, in a case of development, it is necessary to increase a region immersed in the washing solution Q, and it is necessary to increase the developing tank 13 as well. However, even in a state where the frame 15 is rotated 90° from the state shown in Fig. 1, the volume of the washout processor 10 is small. For this reason, the washout processor 10 has a small device configuration regardless of the disposition state of the frame 15, and the space can be saved.

In addition, transporting the flexographic printing plate precursor 70 perpendicularly to the liquid level of the washing solution Q in the developing tank 13 is called vertical transport.

Further, a configuration of being removed from the pins 37d and 38d and not being buckled in a case of removing the flexographic printing plate precursor 70 from the leading end leader 37 and the trailing end leader 38 is adopted. In addition, since an adhesive layer is not used even in a case where the flexographic printing plate precursor 70 is immersed in the washing solution Q, processing such as development can be stably performed on the flexographic printing plate precursor without being detached.

In a state where the flexographic printing plate precursor 70 is fixed to the leading end leader 37 and the trailing end leader 38 and tension is applied by the tension applying unit, development is performed using the washing solution while transporting the flexographic printing plate precursor. For this reason, fluctuations in the tension of the flexographic printing plate precursor 70 are prevented, development treatment can be performed in a state where the tension is stable, and processing such as development can be stably performed on the flexographic printing plate precursor.

By providing the leader mechanism portion 39 that expands and contracts in the traveling direction of the flexographic printing plate precursor 70 shown in Fig. 6, development treatment can be performed in a state where tension is more stable. Accordingly, processing such as development can be more stably performed on the flexographic printing plate precursor.

In the washout processor 10, the flexographic printing plate precursor 70 is transported using the transport chain 31, and maintainability is excellent without having a complicated device configuration.

In addition, by performing the developing step in a state where the flexographic printing plate precursor 70 is being transported, the brush can be miniaturized, and washing productivity can be improved. It was necessary for the method of the related art in which the printing plate is fixed and only the brush is movable to prepare a brush having a wide area corresponding to the size of the printing plate, to increase the number of brushes in a case of using a small brush, or to increase the operating range of the brush. In a case where the printing plate precursor is transported, even the small brush can obtain the same processing capacity. Further, it is possible to provide more brushes in the linear transport passage Dps in a treatment liquid (not shown) and the curved transport passage Dpc (turn portion), it is possible to increase the transportation speed of the printing plate precursor since a processing time is shortened by an increase in the number of brushes, and the productivity of the washout processor 10 increases.

In addition, by developing the flexographic printing plate precursor 70 in the washing solution Q, development residues are prevented from being fixed to the brush 41, and the frequency of maintenance can be decreased. Accordingly, a maintenance load can be decreased, and the washout processor 10 is excellent in maintainability.

Since the frequency of maintenance can be decreased, for example, monthly average or annual average development treatment can be increased, and the washout processor 10 has high productivity from this point as well.

### (Other Configurations of Transporting Unit and Developing Unit)

Configurations of the transporting unit 11 and the developing unit 40 are not limited to the configurations described above and may be other configurations.

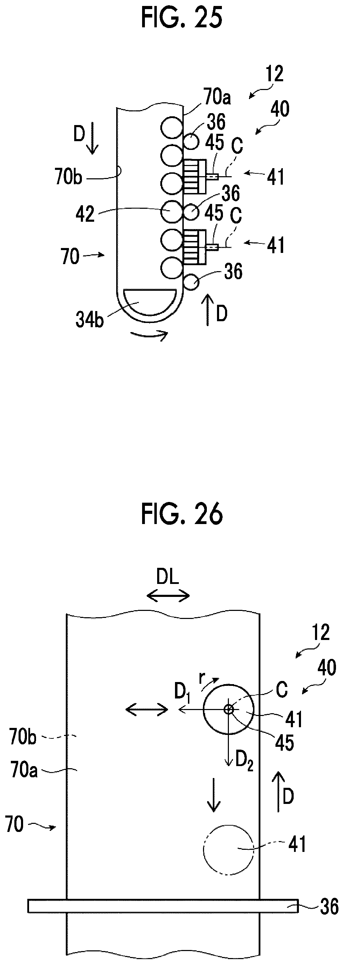

Herein, Fig. 25 is a schematic view showing another example of the developing portion of the washout processor according to the embodiment of the present invention, and Fig. 26 is a schematic plan view showing still another example of the developing portion of the washout processor according to the embodiment of the present invention.

In Figs. 25 and 26, the same components as the developing portion 12 shown in Fig. 13 will be assigned with the same reference numerals, and detailed description thereof will be omitted.

For example, as in the developing unit 40 of the developing portion 12 shown in Fig. 25, instead of the back plate portion 35 (see Fig. 1), a plurality of guide rollers 42 may be disposed at positions facing the brush 41 with the flexographic printing plate precursor 70 nipped therebetween. Each of the guide rollers 42 can rotate. Like the back plate portion 35 (see Fig. 1), by disposing the guide rollers 42, the back surface 70b of the flexographic printing plate precursor 70 is supported by the guide rollers 42 in a case of removing the non-exposed portion by the brush 41, so that the non-exposed portion can be efficiently removed. In addition, the guide rollers 42 function as transport guides for the flexographic printing plate precursor 70, and the flexographic printing plate precursor 70 can be more stably transported.

In addition, like the back plate portion 35 described above, each of the guide rollers 42 can be formed of a metal such as stainless steel and titanium. Like the back plate portion 35, hard chrome plating and diamond-like carbon (DLC) or titanium nitride (TiN) surface treatment may be performed on the surfaces of the guide rollers 42.

In addition, although a configuration where two brushes 41 are provided is adopted, without being limited thereto, there may be one brush 41 as shown in Fig. 26. In this case, for example, with the first moving direction Di set as the direction DL and the second moving direction D₂ set as the transport direction D, the brush 41 is configured to be moved in two directions orthogonal to the rotation axis C. However, the brush may be configured to be moved only in the first moving direction Di, that is, the direction DL.

As described above, since the brush 41 is smaller than the front surface 70a of the flexographic printing plate precursor 70, the brush 41 is partially applied with respect to the entire width of the flexographic printing plate precursor 70 to perform development. As described above, since the brush 41 is small, the brush is moved, for example, in two directions orthogonal to each other during development. In addition to moving the brush 41 in the two directions orthogonal to each other, the brush may be configured to be moved in at least one direction intersecting the rotation axis, for example, the direction DL. By moving the brush 41 in this manner, development can be efficiently performed with the small brush 41.

Insofar as the brush 41 can uniformly rub the entire front surface 70a of the flexographic printing plate precursor 70 during development, the moving direction of the brush 41 is not particularly limited.

In addition, the moving path of the brush 41 is determined in advance according to the size of the brush 41, the size and the transportation speed of the flexographic printing plate precursor 70, or the like. Accordingly, by programming the moving path of the brush 41, development can be performed based on the program.

The configuration of the developing unit 40 of the developing portion 12 is not limited to the configuration described above and may be a configuration to be described below.

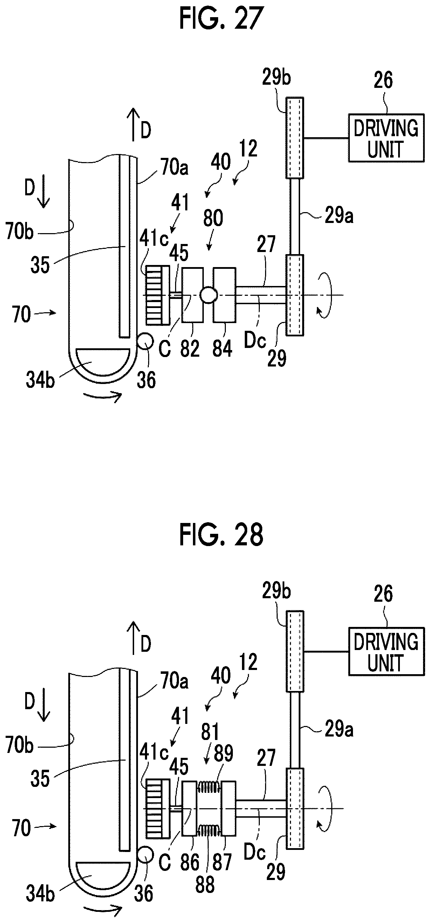

Herein, Figs. 27 to 29 are schematic views showing still another example of the developing portion of the washout processor according to the embodiment of the present invention. In Figs. 27 to 29, the same components as the developing portion 12 shown in Fig. 13 will be assigned with the same reference numerals, and detailed description thereof will be omitted. Although a configuration where there is one brush 41 is shown in Figs. 27 to 29, the developing unit 40 shown in Figs. 27 to 29 can also be applied to the configuration where there are two brushes 41 described above and can also be applied to a configuration where there are three or more brushes 41.

The driving unit 26 (see Fig. 1) is connected to a rotating driving shaft portion 27 to be described later. The driving shaft portion 27 of the driving unit 26 and the rotation shaft portion 45 of the brush 41 are connected to each other such that the rotational force of the driving shaft portion 27 of the driving unit 26 can be transmitted to the rotation axis C of the brush 41, and a shaft joint portion 80 that adjusts the rotation axis C of the brush 41 with respect to the front surface 70a of the flexographic printing plate precursor 70 is provided. The inclination of the rotation axis C of the brush 41 is adjusted by the shaft joint portion 80, and a distal end surface 41c of the brush 41 is disposed parallel to the front surface 70a of the flexographic printing plate precursor 70.

The shaft joint portion 80 shown in Fig. 27 is called a ball joint. A first member 82 and a second member 84 of the shaft joint portion 80 are connected to each other via a ball 85. The ball 85 allows the first member 82 and the second member 84 to move relatively to each other.

The first member 82 is connected to the rotation shaft portion 45 of the brush 41. The second member 84 is connected to the driving shaft portion 27. At an end of the driving shaft portion 27, which is on an opposite side to the second member 84, for example, a pulley 29 is provided. A pulley 29b is disposed to face the pulley 29, and a transmission belt 29a is wound around the pulley 29 and the pulley 29b. The driving unit 26 is connected to the pulley 29b. In a case where the pulley 29b is rotated by the driving unit 26, the pulley 29 rotates and the driving shaft portion 27 rotates. The rotational force of the driving shaft portion 27 is transmitted to the rotation shaft portion 45 via the shaft joint portion 80, and the brush 41 rotates.

As described above, since the ball 85 allows the first member 82 and the second member 84 to move relatively to each other, the inclination of the rotation axis C of the rotation shaft portion 45 of the brush 41 with respect to the front surface 70a of the flexographic printing plate precursor 70 can be changed. Accordingly, the direction of the distal end surface 41c of the brush 41 can be changed, and the distal end surface 41c of the brush 41 can be disposed parallel to the front surface 70a of the flexographic printing plate precursor 70. Accordingly, development can be performed in a state where the distal end surface 41c of the brush 41 is uniformly brought into contact with the front surface 70a of the flexographic printing plate precursor 70, and by preventing one-sided contact or the like, development can be performed efficiently and even better.

In addition, due to the device configuration, also in a case where the rotation axis C of the brush 41 is inclined, a drive shaft Dc can be made horizontal by the shaft joint portion 80.

The shaft joint portion 80 is not limited to the configuration shown in Fig. 27, a universal joint, flexible coupling, a floating joint, and the like are used. In addition, for example, a shaft joint portion 81 shown in Fig. 28 may be used. In Fig. 28, the same components as the components shown in Fig. 27 will be assigned with the same reference numerals, and detailed description thereof will be omitted. Except that the configuration is different, the shaft joint portion 81 shown in Fig. 28 has the same function as the shaft joint portion 80 shown in Fig. 27.

The shaft joint portion 81 shown in Fig. 28 has, for example, a first flange 86, a second flange 87, and two elastic members 88 and 89. The first flange 86 and the second flange 87 are disposed to face each other, and the two elastic members 88 and 89 are provided between the first flange 86 and the second flange 87. The two elastic members 88 and 89 are, for example, springs.

The first flange 86 and the second flange 87 can move relatively to each other as the two elastic members 88 and 89 are displaced.

The first flange 86 is connected to the rotation shaft portion 45 of the brush 41. The second flange 87 is connected to the driving shaft portion 27.

As described above, since the two elastic members 88 and 89 allow the first flange 86 and the second flange 87 to move relatively to each other, the inclination of the rotation axis C of the rotation shaft portion 45 of the brush 41 with respect to the front surface 70a of the flexographic printing plate precursor 70 can be changed. Accordingly, the direction of the distal end surface 41c of the brush 41 can be changed, and the distal end surface 41c of the brush 41 can be disposed parallel to the front surface 70a of the flexographic printing plate precursor 70. Development can be performed in a state where the distal end surface 41c of the brush 41 is uniformly brought into contact with the front surface 70a of the flexographic printing plate precursor 70, and by preventing one-sided contact or the like, development can be performed efficiently and even better.

In addition, due to the device configuration, also in a case where the rotation axis C of the brush 41 is inclined, the drive shaft Dc can be made horizontal by the shaft joint portion 80.

In addition, by providing the two elastic members 88 and 89, for example, in a contracted state compared to a state where a force does not act, the first flange 86 and the second flange 87 receive a force relatively separating away from each other. Accordingly, the first flange 86 is displaced to the front surface 70a side of the flexographic printing plate precursor 70, and the distal end surface 41c of the brush 41 can be pressed against the front surface 70a of the flexographic printing plate precursor 70. The two elastic members 88 and 89 are not limited to springs and may be rubber, elastomer, or the like. The number of elastic members is also not limited to two, may be one, or may be three or more, and the number of elastic members is determined as appropriate according to a force acting on the brush 41 or the like.

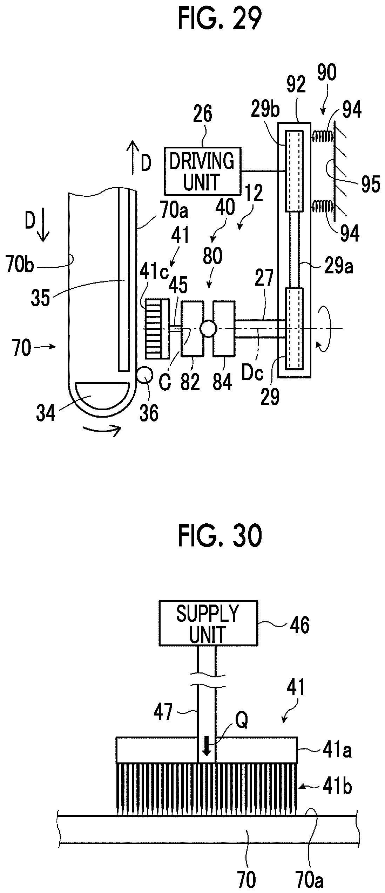

In addition, as shown in Fig. 29, a configuration where there is a pressing unit 90 that presses the distal end surface 41c of the brush 41 against the front surface 70a of the flexographic printing plate precursor 70 may be adopted. In Fig. 29, the same components as the components shown in Fig. 27 will be assigned with the same reference numerals, and detailed description thereof will be omitted.

For example, the pressing unit 90 presses the driving shaft portion 27 to the front surface 70a side of the flexographic printing plate precursor 70 and presses the distal end surface 41c of the brush 41 against the front surface 70a of the flexographic printing plate precursor 70.

The transmission belt 29a is wound around the pulley 29 provided at the driving shaft portion 27 and the pulley 29b disposed to face the pulley 29. The driving unit 26 is connected to the pulley 29b, and the pulley 29b is rotated by the driving unit 26. The pulley 29, the transmission belt 29a, and the pulley 29b are accommodated in a case 92. In the case 92, an elastic member 94 is provided on a pulley 29b side, for example, in a contracted state compared to a state where a force does not act. A fixing wall 95 is fixed to an end part of the elastic member 94 on an opposite side to the case 92. The elastic member 94 allows the case 92 to be pressed to a flexographic printing plate precursor 70 side and the distal end surface 41c of the brush 41 to be pressed against the front surface 70a of the flexographic printing plate precursor 70 via the driving shaft portion 27 and the shaft joint portion 80.

By providing the pressing unit 90 in addition to the shaft joint portion 80, the distal end surface 41c of the brush 41 can be pressed against the front surface 70a of the flexographic printing plate precursor 70 in a state where the distal end surface 41c of the brush 41 is disposed parallel to the front surface 70a of the flexographic printing plate precursor 70. Accordingly, development can be performed in a state where the distal end surface 41c of the brush 41 is uniformly pressed against the front surface 70a of the flexographic printing plate precursor 70, and development can be performed more efficiently and even better.

Although the shaft joint portion 80 shown in Fig. 27 is used in Fig. 29, without being limited thereto, the shaft joint portion 81 shown in Fig. 28 can also be used. In addition thereto, a universal joint, flexible coupling, a floating joint, and the like can be used as described above.

### (Another Example of Washing Method)

Next, another example of the washing method for the flexographic printing plate precursor 70, in which the washout processor 10 is used, will be described.

First, the front surface 70a of the flexographic printing plate precursor 70 is imagewise exposed, that is, exposed in a specific pattern by the exposure device (not shown).

Next, for example, the leading end leader 37 is fixed by being hooked or the like to the fixing units 31b of the pair of transport chains 31 respectively. For example, the trailing end leader 38 is fixed to the fixing units 31b of the transport chains 31 using a magnet. Next, the leading end of the flexographic printing plate precursor 70 is fixed to the leading end leader 37 as described above, and the trailing end is fixed to the trailing end leader 38.

The flexographic printing plate precursor 70 is transported along the transport path Dp by the transporting unit 11. In a state where the flexographic printing plate precursor 70 is immersed in the washing solution Q and is transported, the brush 41 of the developing unit 40 performs development by removing the non-exposed portion of the flexographic printing plate precursor 70. In the developing step of performing the development, while transporting the flexographic printing plate precursor 70, for example, the brush 41 is rotated in a state where the rotation axes C of the two brushes 41 pass through the front surface 70a of the flexographic printing plate precursor 70 and the rotation axes C of the brushes 41 are moved in at least one direction intersecting the rotation axes C as described above. Since the operations of the brushes 41 are as described above, detailed description thereof will be omitted. In the developing step, the fatiqued developer Qw is generated.

Further, by the shaft joint portion 80 shown in Fig. 27 and the shaft joint portion 81 shown in Fig. 28, which are described above, the inclination of the rotation axis C of the brush 41 with respect to the front surface 70a of the flexographic printing plate precursor 70 is adjusted, and the distal end surface 41c of the brush 41 is disposed parallel to the front surface 70a of the flexographic printing plate precursor 70, in the developing step. Accordingly, development can be performed in a state where the distal end surface 41c of the brush 41 is disposed parallel to the front surface 70a of the flexographic printing plate precursor 70.

In addition to the shaft joint portion 80 shown in Fig. 27 and the shaft joint portion 81 shown in Fig. 28, which are described above, further, the pressing unit 90, which is described above and is shown in Fig. 29, presses the distal end surface 41c of the brush 41 against the front surface 70a of the flexographic printing plate precursor 70 in the developing step. Accordingly, development can be performed in a state where the distal end surface 41c of the brush 41 is disposed parallel to the front surface 70a of the flexographic printing plate precursor 70 and a state where the distal end surface 41c of the brush 41 is pressed against the front surface 70a of the flexographic printing plate precursor 70.

The developed flexographic printing plate precursor 70 is taken out from the developing tank 13, that is, from the developing portion 12. In a state where the flexographic printing plate precursor 70 is transported, the supply unit 22 applies, for example, the fatiqued developer Qw processed by the processing unit 18 to the front surface 70a of the flexographic printing plate precursor 70, and residues on the front surface 70a are removed. Then, the flexographic printing plate precursor 70 is transported until the flexographic printing plate precursor passes through the rinsing unit 14. In a case of performing development once, at this time point, the fixing of the leading end leader 37 and the trailing end leader 38 is released as described above, and the flexographic printing plate precursor 70 is carried to the feeding device 60 to be removed from the washout processor 10. In a case of performing development a plurality of times, the flexographic printing plate precursor 70 is transported by going around and is transported to the developing portion 12 again to perform development. Until a predetermined number of times is reached, the developing step and the rinsing step are performed repeatedly. Next, as described above, the fixing of the leading end leader 37 and the trailing end leader 38 is released, and the flexographic printing plate precursor 70 is carried to the feeding device 60 to be removed from the washout processor 10.

Although development is performed in a state where the flexographic printing plate precursor 70 is immersed in the washing solution Q in the washout processor 10, without being limited thereto, development can be performed while supplying the washing solution Q to the brush 41. In this case, as the configuration of the brush 41, for example, the brush 41 in which a supply pipe 47 is provided may be used as shown in Fig. 30. The supply pipe 47 is connected to a supply unit 46 that supplies the washing solution Q. The washing solution Q is supplied from the supply unit 46 to the brush 41 via the supply pipe 47, and the washing solution Q is supplied between the brush 41 and the front surface 70a of the flexographic printing plate precursor 70.

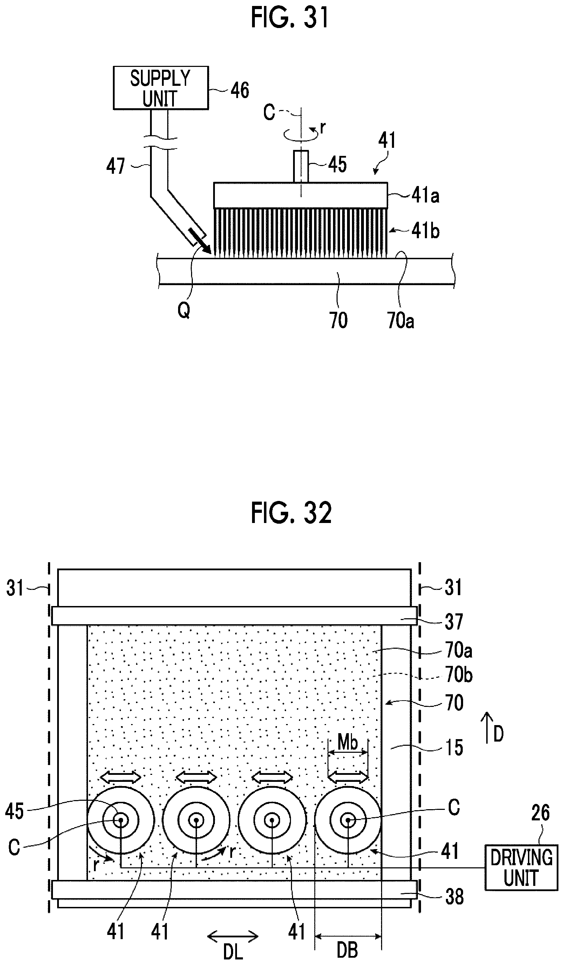

In addition, as shown in Fig. 31, the supply pipe 47 may be provided outside the brush 41, and the washing solution Q may be supplied between the brush 41 and the front surface 70a of the flexographic printing plate precursor 70. In this case, development can be performed while supplying the washing solution Q from the supply unit 46 to the brush 41 via the supply pipe 47.

Performing development while supplying the washing solution Q is preferable since the adhesion of development residues is prevented.

### (Other Configurations of Developing Unit)

Figs. 32 to 35 are schematic views showing another example of the developing unit of the washout processor according to the embodiment of the present invention. In Figs. 32 to 35, the same components as the washout processor 10 shown in Figs. 1 to 3 will be assigned with the same reference numerals, and detailed description thereof will be omitted. The nip roller 36 (see Fig. 1) is not shown in Figs. 32 to 35.

The developing unit 40 (see Fig. 1) of the developing portion 12 (see Fig. 1) may be configured such that the plurality of brushes 41, for example, four brushes 41 are arranged in a line in the direction DL as shown in Fig. 32. The four brushes 41 are connected to the driving unit 26, and the driving unit 26 controls the rotation of the brushes 41 about the rotation axes C and the movement of the brushes 41.

Development can be simultaneously performed by the four brushes 41. Accordingly, an area rubbed by the brushes 41 can be increased, and a development speed can be increased in a state where the adhesion of development residues is prevented and development uniformity is maintained. In this case, the rotation speeds of the plurality of brushes 41 may be the same, or the rotation speed may be changed for each of the plurality of brushes 41. In addition, the sizes of the four brushes 41 may be the same or may be different from each other. However, it is preferable for the four brushes 41 to have the same size and rotation speed from a perspective of development uniformity for preventing the occurrence of development unevenness.

In addition, it is preferable to move the four brushes 41 in a width direction of the flexographic printing plate precursor 70, that is, the direction DL orthogonal to the transport direction D. That is, it is preferable to swing the plurality of brushes 41 in the direction DL. In this case, it is preferable to move by a distance of one third or more of the diameter DB (see Fig. 16) of the brush 41. The distance by which the brush 41 is moved in the direction DL is called a swing width Mb.

As described above, by swinging the brush 41 in the direction DL, development unevenness can be prevented. Setting the swing width Mb to the distance of one third or more of the diameter DB (see Fig. 16) of the brush 41 is preferable since development unevenness can be prevented even better.

In a case where a plurality of brushes are provided, for example, at least four brushes may be simultaneously driven by one motor instead of rotating each brush. In a case of the four brushes 41, the four brushes 41 may be simultaneously driven by one motor instead of rotating each brush 41. Accordingly, the number of motors can be reduced, and thus the device can be miniaturized. In addition, in a case where the plurality of brushes are rotated by one motor, the rotation speed can be changed for each brush 41 by providing a transmission. Accordingly, the number of motors can be reduced, and thus the device can be miniaturized. In addition, in a case where the plurality of brushes are rotated by one motor, the rotation speed can be changed for each brush 41 by providing a transmission.

In addition, it is preferable that the washout processor 10 has at least two types of brushes used in development, and one type of at least two types of brushes is a brush of which the rotation axis C is disposed in a direction perpendicular to the flexographic printing plate precursor 70. By disposing the rotation axis C parallel to the front surface 70a of the flexographic printing plate precursor 70, development can be efficiently performed.

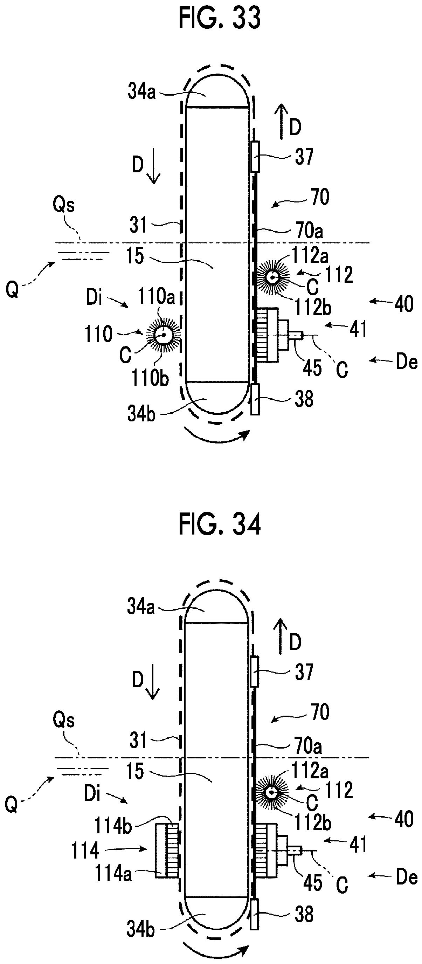

For example, as shown in Fig. 33, in the developing unit 40 of the developing portion 12 (see Fig. 1), a roller brush 110 and the brush 41 are disposed with the frame 15 sandwiched therebetween from an upstream side of the transport path Dp for the flexographic printing plate precursor 70 in the transport direction D. Further, a roller brush 112 is disposed on a downstream side of the brush 41 in the transport direction D. In Fig. 33, three types of brushes are provided. In Fig. 33, all of the brush 41, the roller brush 110, and the roller brush 112 are disposed in a state of being immersed in a liquid level Qs of the washing solution Q. The roller brush 112 is used in finishing the development. Having the roller brush 112 is preferable since on-plate residues or the like are removed, but it is not always necessary to provide the roller brush.

The brush 41 is disposed such that the rotation axis C is in the direction perpendicular to the front surface 70a of the flexographic printing plate precursor 70. As shown in Fig. 32, for example, a configuration where the four brushes 41 are disposed is adopted. For this reason, detailed description of the brush 41 will be omitted.

For the brush 41, a configuration where two brushes 41 are disposed may be adopted as shown in Figs. 1 to 3 and Fig. 13.

The roller brush 110 is disposed such that the rotation axis C is parallel to the direction DL which is a direction orthogonal to the front surface 70a of the flexographic printing plate precursor 70.

The roller brush 110 is a roller-shaped brush and is obtained by bundling bristles 110b into a substrate 110a radially with respect to the rotation axis C. The roller brush 110 rotates with the rotation axis C as a rotation center.

In addition, the roller brush 112 is disposed such that the rotation axis C is parallel to the direction DL which is the direction orthogonal to the front surface 70a of the flexographic printing plate precursor 70.

The roller brush 112 has the same configuration as the roller brush 110, is a roller-shaped brush, and is obtained by bundling bristles 112b into a substrate 112a radially with respect to the rotation axis C. The roller brush 112 rotates with the rotation axis C as a rotation center.

The lengths of the bristles 112b of the roller brush 112 are larger than the bristles of the roller brush 110. Accordingly, the roller brush 112 can remove development residues on the front surface 70a of the flexographic printing plate precursor 70 without leaving a brush trail on the plate, that is, a so-called brush mark.

It is preferable that the lengths of the bristles 110b and 112b of the roller brushes 110 and 112 are 5 to 25 mm. In a case where the lengths of the bristles 110b and 112b of the roller brushes 110 and 112 are 5 to 25 mm, the leading end leader 37 and the trailing end leader 38 for transport can be passed through, a brush force becomes strong so that independent small dot performance is obtained, and a development speed thereof also increases.

A material for the bristles of the roller brushes 110 and 112 is not particularly limited, and for example, a known material used for the development of the flexographic printing plate precursor 70, such as nylon 6,6, nylon 610, polybutylene terephthalate (PBT), and polyethylene terephthalate (PET), can be used as appropriate.

In order to maintain the development speeds of the roller brushes 110 and 112, it is preferable that the bristles 110b and 112b are provided in regions of 30% or more of the substrates 110a and 112a. The fact that the bristles 110b and 112b are provided in areas of 30% or more of the substrates 110a and 112a of the roller brushes 110 and 112 means that the areas of the bristles are 30%.

It is preferable that the lengths of the bristles 110b and 112b of the roller brushes 110 and 112 are 5 to 25 mm. In a case where the lengths of the bristles 110b and 112b of the roller brushes 110 and 112 are 5 to 25 mm, the leading end leader 37 and the trailing end leader 38 for transport can be passed through, a brush force becomes strong so that independent small dot performance is obtained, and a development speed thereof also increases.

In Fig. 33, the roller brush 110 is disposed on an inlet Di side of the transport path Dp, and the brush 41 is disposed on an outlet De side of the transport path Dp. The roller brush 112 is disposed on the outlet De side of the transport path Dp from the brush 41.

The inlet Di side of the transport path Dp is a side where the leading end leader first reaches the liquid level Qs of the washing solution Q in a case where the leading end leader 37 is transported in the transport direction D along the transport path Dp in a state shown in Fig. 33. The outlet De side of the transport path Dp is a downstream side of the inlet Di of the transport path Dp in the transport direction D.

In Fig. 33, three types of brushes including the roller brush 110, the brush 41, and the roller brush 112 are provided. By separating functions of the brushes, both productivity and quality can be achieved in terms of development. The roller brush 112 is unlikely to cause development unevenness, but has a slow development speed. Even in a case where the development speed of the roller brush 112 is slow, the brush 41, which is a cup brush, can supplement the development speed. In this manner, the development speed can be increased, and development can be performed with high quality.

In addition, as in the developing unit 40 shown in Fig. 34, a flat brush 114 may be disposed instead of the roller brush 110 of the developing unit 40 of Fig. 33. In Fig. 34, the flat brush 114 is disposed on the inlet Di side of the transport path Dp, the brush 41 is disposed on the outlet De side of the transport path Dp, and the roller brush 112 is disposed on the outlet De side of the transport path Dp.

In Fig. 34, all of the flat brush 114, the brush 41, and the roller brush 112 are disposed in a state of being immersed in the liquid level Qs of the washing solution Q. The roller brush 112 is used in finishing the development. Having the roller brush 112 is preferable since on-plate residues or the like are removed, but it is not always necessary to provide the roller brush.

The flat brush 114 is obtained, for example, by bundling bristles 114b perpendicular to a substrate 114a. The bristles 114b of the flat brush 114 are substantially perpendicular to the front surface 70a of the flexographic printing plate precursor 70. The configuration of the flat brush 114 is not particularly limited to the configuration described above. In addition, a material for the bristles 114b of the flat brush 114 is not particularly limited, and the same material as the roller brush 110 can be used.

In order to maintain the development speed of the flat brush 114, it is preferable that the bristles 114b are provided in a region of 30% or more of the substrate 114a. The fact that the bristles 114b are provided in an area of 30% or more of the substrate 114a of the flat brush 114 means that the area of the bristles is 30%.

It is preferable that the length of the bristles 114b of the flat brush 114 is 5 to 25 mm. In a case where the length of the bristles 114b of the flat brush 114 is 5 to 25 mm, the leading end leader 37 and the trailing end leader 38 for transport can be passed through, a brush force becomes strong so that independent small dot performance is obtained, and a development speed thereof also increases.

In Fig. 34, three types of brushes including the flat brush 114, the brush 41, and the roller brush 112 are provided. By separating functions of the brushes, both productivity and quality can be achieved in terms of development. Since the flat brush 114 has a large contact area, the development speed is high, and the development progresses quickly first. Even in a case where development unevenness has occurred due to the flat brush 114, the brush 41, which is a cup brush, can prevent development unevenness. Accordingly, compared to a combination of the roller brush 112 and the brush 41, the development speed can be increased, and development can be performed with high quality.

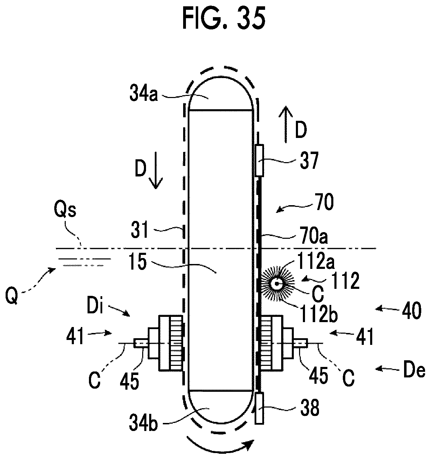

In addition, as in the developing unit 40 shown in Fig. 35, the brush 41 may be disposed instead of the roller brush 110 of the developing unit 40 of Fig. 33. In Fig. 35, the brush 41 is disposed on the inlet Di side of the transport path Dp, the brush 41 is disposed on the outlet De side of the transport path Dp, and the roller brush 112 is disposed on the outlet De side of the transport path Dp. In addition, in Fig. 35, all of the brushes 41 and the roller brush 112 are disposed in a state of being immersed in the liquid level Qs of the washing solution Q. The roller brush 112 is used in finishing the development. Having the roller brush 112 is preferable since on-plate residues or the like are removed, but it is not always necessary to provide the roller brush.

In Fig. 35, two types of brushes including the brushes 41 having different disposed positions and the roller brush 112 are provided. The brushes 41 are disposed at different positions. The brush 41 on the inlet Di side of the transport path Dp and the brush 41 on the outlet De side of the transport path Dp change at least one of a density at which the bristles 41b are planted or the thickness of the bristles 41b. For example, the progress of the development is accelerated by making the configuration of the brush 41 on the inlet Di side of the transport path Dp such that the area of the bristles is increased or the bristles are thickened. In addition, for example, development treatment quality is made excellent by decreasing the area of the bristles of the brush 41 on the outlet De side of the transport path Dp. Accordingly, compared to a combination of the roller brush 112 and the brushes 41, the development speed can be increased, and development can be performed with high quality.

Herein, in the developing step, the flat brush or the roller brush is generally used. Since the flat brush has a large contact area, the development speed is high, on-plate brush trails (hereinafter, brush marks) are unlikely to be left as well. However, since the flat brush requires high brush costs or requires high provision accuracy, in-plane uniformity is low, and development unevenness is likely to occur. In addition, since the flat brush has a structure in which development residues are unlikely to be discharged from the brush, there is a problem of on-plate development residues.

On the other hand, the roller brush has high dischargeability of development residues as the brush rotates about the shaft, and has low brush costs. In addition, since the roller brush does not require provision accuracy, in-plane uniformity is excellent, and development unevenness is unlikely to occur. However, since the roller brush is circular, the contact area is small, and the development speed is slow. In order to supplement this, in the roller brush, the density of bristles is increased, or the diameter of each of the bristles of the brush is increased in some cases. In this case, independent dots of a printed material are likely to disappear, causing actual printing damage and further generating brush marks.

For example, as in JP2015-114558A, the flat brush and the roller brush are used in combination with a cleaning brush in some cases. By using the brushes in combination, attempts to solve problems of a development speed, development residues, costs, development unevenness, and independent small dot performance are made. However, as the roller brush is in a final step, brush marks are left on the plate, and solving all the problems is impossible. Due to the described disposition of the brushes shown in Figs. 33 to 35, high quality, low costs, and high productivity can be realized for development, and problems of a development speed, development residues, costs, development unevenness, independent small dot performance, and brush marks, which are described above, can be solved.

### (Other Configurations of Washout Processor)

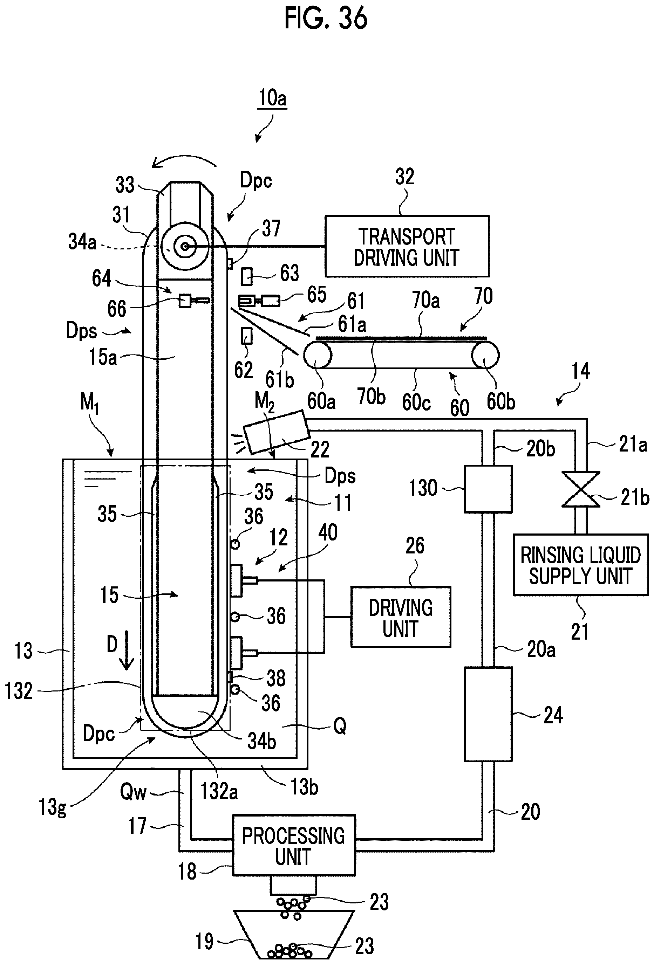

Fig. 36 is a schematic side view showing another example of the washout processor according to the embodiment of the present invention. In Fig. 36, the same components as the washout processor 10 shown in Figs. 1 to 3 will be assigned with the same reference numerals, and detailed description thereof will be omitted.

A washout processor 10a shown in Fig. 36 is different from the washout processor 10 shown in Fig. 1 in that the washout processor 10a has a heater 130 and a partition member 132, and the other configurations are the same as the configurations of the washout processor 10 shown in Fig. 1.

The heater 130 is connected to a pipe 20a and a pipe 20b. The heater 130 adjusts the temperature of the washing solution Q supplied into the developing tank 13 to a determined temperature, for example, a range of 40°C to 50°C. The configuration of the heater 130 is not particularly limited, and a known configuration is usable as appropriate.

The heater 130 can adjust the temperature of the fatiqued developer Qw processed by the processing unit 18 to a constant temperature in a range of 40°C to 50°C and supply to the front surface 70a of the flexographic printing plate precursor 70.

The washout processor 10a is provided with the partition member 132 along the frame 15, in the developing tank 13. With the partition member 132, a space 13g between a bottom surface 13b of the developing tank 13 and an end part 132a of the partition member 132 is divided into a side where the flexographic printing plate precursor 70 enters the washing solution Q and a side where the flexographic printing plate precursor 70 is discharged from the washing solution Q. That is, the developing tank 13 is configured such that the first tank portion M₁ and a second tank portion M₂ communicate with each other in the space 13g due to the partition member 132. For this reason, in the developing tank 13, solid contents floating on the liquid level of the first tank portion M₁, which is the side where the flexographic printing plate precursor 70 enters the washing solution Q, are prevented from moving to the liquid level of the second tank portion M₂, which is the side where the flexographic printing plate precursor 70 is discharged from the washing solution Q. Accordingly, the second tank portion M₂ can maintain a state where the amount of solid contents is relatively small compared to the first tank portion M₁. The washing solution Q can pass through the space 13g of the developing tank 13 as described above.

A material for the partition member 132 is not particularly limited, and examples thereof include a vinyl chloride resin block, a polyethylene resin block, a polypropylene resin block, and a foamed molded body.

In addition, the supply unit 22 supplies the washing solution Q to the second tank portion M₂. In this case, the washing solution Q stored in the developing tank 13 passes through the space 13g of the developing tank 13, and the washing solution Q is pressed out to a first tank portion M₁ side where the flexographic printing plate precursor 70 enters. Consequently, for example, the washing solution Q overflows. In this case, in a case where the washing solution Q contains solid contents, the solid contents are discharged.

Since the washout processor 10a is provided with the partition member 132, the solid contents are more unlikely to adhere to the front surface 70a of the developed flexographic printing plate precursor 70.

Although a configuration of having the heater 130 and the partition member 132 is adopted, without being limited thereto, a configuration of having any one of the heater 130 or the partition member 132 may be adopted.

### (Example of Heater)

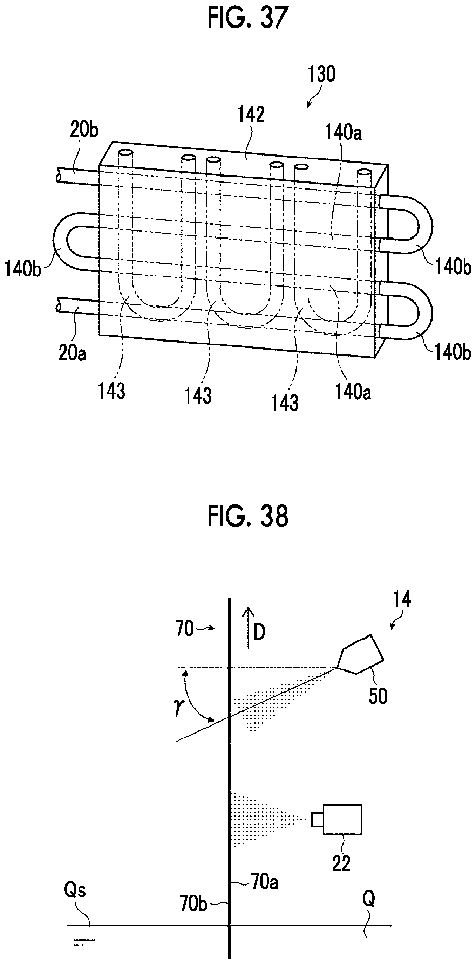

Fig. 37 is a schematic perspective view showing an example of the heater used in the washout processor according to the embodiment of the present invention. In Fig. 37, the same components as the washout processor 10a shown in Fig. 36 will be assigned with the same reference numerals, and detailed description thereof will be omitted.

As shown as Fig. 36, the heater 130 is connected to the separation membrane 24 and the supply unit 22.

As shown in Fig. 37, the heater 130 has a pipe 140, a block 142 in which a part of the pipe 140 is buried, and a heating heater 143 provided in the block 142. The block 142 is formed of a metal material. The metal material forming the block 142 is preferably a metal material excellent in castability and is, for example, copper, a copper alloy, aluminum, or an aluminum alloy.

In the pipe 140, one pipe is seamlessly disposed in the block 142. The pipe has a linear part 140a inside the block 142 and a bending part 140b connecting the linear part 140a inside. The bending part 140b is disposed outside the block 142. In addition, for example, three heating heaters 143 are disposed at intervals in a direction in which the linear part 140a of the pipe 140 extends.

The linear part 140a and the heating heater 143 of the pipe 140 are cast and integrated with the block 142.

A device used as a cast heater is usable as appropriate as the heating heater 143.

An overheat protection device such as a thermostat (not shown) is provided inside the heater 130 and cuts off power in a case where abnormal overheating occurs. In this manner, a treatment liquid including the washing solution can be maintained at a predetermined temperature.

It is preferable that the watt density of the heating heater 143 of the heater 130 is 5 W/cm² or less. In a case where the watt density of the heating heater 143 is set to 5 W/cm² or less, a heat generation temperature of a heat generating body can be relatively kept low, and the life of the heat generating body can be extended. In a case where the heating heater 143 is cast, it is difficult to repair the heating heater 143, so that the failure of the heater 130 can be prevented.

Having low watt density extends the life of the heater, but the heater block becomes large and costs increase in a case where the watt density is 1 W/cm² or less, which is not practical. The watt density of the heating heater 143 is more preferably 3 to 5 W/cm².

As the heater 130 has the configuration described above, the washing solution Q does not come into direct contact with the heating heater 143, and heat is uniformly exchanged in the linear part 140a. Thus, local burning is prevented even in the washing solution Q containing solid contents.

As the washing solution Q passes through the inside of the pipe in the block at a liquid flow rate of 100 cm/sec or higher, burning of the washing solution Q containing solid contents is prevented even in a case where a heating setting temperature of the heater 130 is approximately 100°C and the concentration of solid contents of the washing solution Q is high. For this reason, the flow rate of the washing solution in the heater 130 is preferably 100 cm/sec and more preferably 200 cm/sec or higher. For example, the pump causes the washing solution to flow in the heater 130 at the flow rate described above.

The flow rate of the washing solution in the heater 130 can be measured by various types of commercially available liquid flow meters. In addition, the flow rate of the washing solution in the heater 130 can also be acquired by calculating from a cross-sectional area in the pipe of the heater 130 and a circulation amount of the pump.

The heater 130 shown in Fig. 36 is also called a cast heater. In addition to the description above, a cast heater can be used as the heater. In addition to the cast heater, for example, a metal block heater in which a heater and a pipe through which a liquid is passed are press-fitted into a metal block, a heater in which a cartridge heater or a sheathed heater and a metal pipe are set in a mold and a metal is injected, or the like can be used.

### (Another Example of Rinsing Unit)

The configuration of the rinsing unit is not limited to the configuration shown in Fig. 1, and for example, the rinsing unit 14 having a configuration to be described below can be used.

Figs. 38 to 45 are schematic views showing a first example to an eighth example of the rinsing unit of the washout processor according to the embodiment of the present invention. In Figs. 38 to 45, the same components as the washout processor 10 shown in Fig. 1 will be assigned with the same reference numerals, and detailed description thereof will be omitted. In Figs. 38 to 45, the showing of the processing unit 18, the pipe 20, the separation membrane 24, the rinsing liquid supply unit 21, the supply pipe 21a, and the valve 21b is partially omitted.

For example, as shown in Fig. 38, above the liquid level Qs of the washing solution Q, the rinsing unit 14 has the supply unit 22 disposed to face the front surface 70a of the flexographic printing plate precursor 70 and a liquid drain nozzle 50 provided on a downstream side from the supply unit 22 in the traveling direction of the flexographic printing plate precursor 70, that is, the downstream side in the transport direction D.

As described above, the supply unit 22 is a nozzle that is for supplying at least the washing solution Q to the front surface 70a of the flexographic printing plate precursor 70, from which the non-exposed portion of the flexographic printing plate precursor 70 is removed.

The liquid drain nozzle 50 removes the washing solution Q supplied to the flexographic printing plate precursor 70 by the supply unit 22 by jetting a gas or removes the washing solution by sucking a gas. Insofar as the jetting of a gas or the sucking of a gas can be performed, the configuration of the liquid drain nozzle 50 is not particularly limited, and various pumps can be used.

As shown in Fig. 38, by providing the supply unit 22 and the liquid drain nozzle 50, the liquid drain nozzle 50 entrains the washing solution Q from the supply unit 22, and the supply amount of the washing solution Q from the supply unit 22 spreads to at least the front surface 70a of the flexographic printing plate precursor 70. Thus, the non-exposed portion described above can be removed. Accordingly, the amount of the washing solution Q necessary for removing residues such as latex components and rubber components remaining on the front surface 70a of the developed flexographic printing plate precursor 70 can be decreased.

It is preferable to drive the supply unit 22 and the liquid drain nozzle 50 simultaneously. By driving the supply unit 22 and the liquid drain nozzle 50 simultaneously, the effect of entrainment of the washing solution Q described above is further obtained.

A nozzle angle γ of the liquid drain nozzle 50 is preferably 0° to 85° and more preferably 0° to 45°.

In a case where a ventilation port for a gas of the liquid drain nozzle 50 is on a line (hereinafter, referred to as a reference line) of 90° with respect to the front surface 70a of the flexographic printing plate precursor 70, the nozzle angle γ is set to 0°.

An angle formed by a line that is extended from the front surface 70a of the flexographic printing plate precursor 70 and passes through the ventilation port of the liquid drain nozzle 50 and the reference line is the nozzle angle γ.

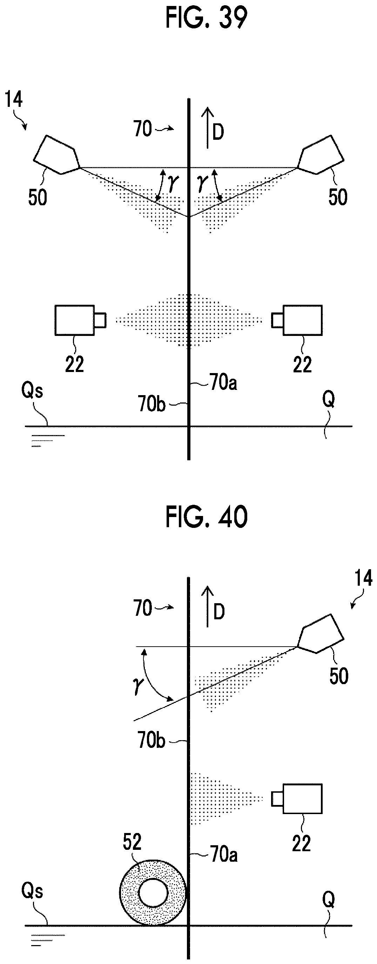

As shown in Fig. 39, the rinsing unit 14 may be configured such that the supply unit 22 and the liquid drain nozzle 50 are provided to face the back surface 70b at symmetrical positions with the flexographic printing plate precursor 70 interposed. Accordingly, residues such as latex components and rubber components that have remained during development can be removed from both surfaces of the flexographic printing plate precursor 70.

As shown in Fig. 40, the rinsing unit 14 may be configured to be provided with a brush 52 or a squeegee plate brought into contact with the back surface 70b of the flexographic printing plate precursor 70 in addition to the configuration shown in Fig. 38. For example, the brush 52 is a roller-shaped brush obtained by bundling bristles radially with respect to a shaft. Accordingly, in a case where the flexographic printing plate precursor 70 is transported, the brush 52 rotates in a state of being brought into contact with the back surface 70b, and residues such as latex components and rubber components remaining on the back surface 70b of the flexographic printing plate precursor 70 can be removed.

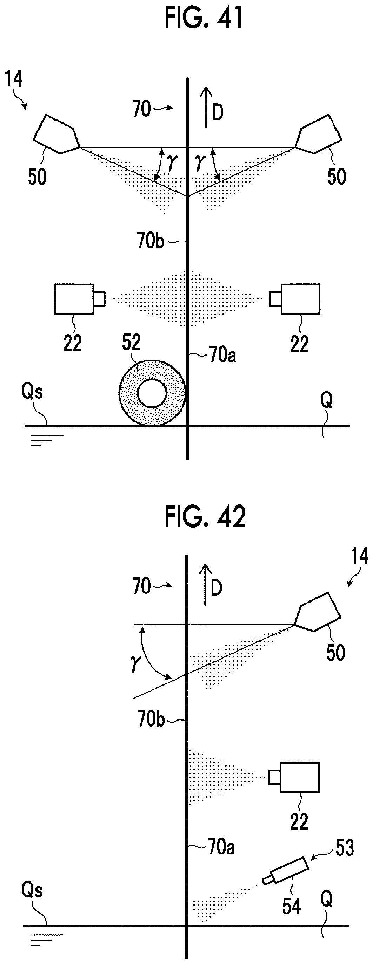

As shown in Fig. 41, the rinsing unit 14 may be configured to be provided with the brush 52 brought into contact with the back surface 70b of the flexographic printing plate precursor 70 in addition to the configuration shown in Fig. 39. Accordingly, in a case where the flexographic printing plate precursor 70 is transported, the brush 52 rotates in a state of being brought into contact with the back surface 70b, and residues such as latex components and rubber components remaining on the back surface 70b of the flexographic printing plate precursor 70 can be removed. Further, the residues that are not completely removed by the brush 52 can also be removed by the supply unit 22 and the liquid drain nozzle 50.

Although the brush 52 is disposed to be brought into contact with the liquid level Qs of the washing solution Q in Figs. 40 and 41, without being limited thereto, the brush 52 may be disposed in a state of being immersed in the washing solution Q.

### (Prerinsing Unit)

A configuration where a prerinsing unit 53 that supplies the washing solution Q to the developed flexographic printing plate precursor 70 is further included between the rinsing unit 14 and the developing portion 12 may be adopted. For example, the prerinsing unit 53 has a prerinsing nozzle 54. For example, as shown in Fig. 42, a configuration where the prerinsing nozzle 54 that is provided to face the front surface 70a of the flexographic printing plate precursor 70 is provided may be adopted in addition to the configuration shown in Fig. 38. The prerinsing nozzle 54 supplies the washing solution Q to the developed flexographic printing plate precursor 70 before the rinsing unit 14. Specifically, the prerinsing nozzle 54 sprays the washing solution Q in order to prevent foreign substances from adhering to the flexographic printing plate precursor 70 at the surface of the washing solution Q in the developing tank 13.

A step of supplying the washing solution Q to the developed flexographic printing plate precursor 70, between the developing step and the rinsing step is called a prerinsing step. The prerinsing step is performed using the prerinsing unit 53 described above.

It is preferable that the washing solution Q is supplied from the prerinsing nozzle 54 at a flow rate that disturbs the liquid level Qs of the washing solution Q in the developing tank 13.

In the developing tank 13, residues generated through development float on the liquid level Qs of the washing solution Q in the developing tank 13. In a case where the residues adhere to the front surface 70a and the back surface 70b of the flexographic printing plate precursor 70, a defect is caused. There are also residues which are too small to be removed by the supply unit 22, and a defect is caused in a case where the residues adhere. By providing the prerinsing nozzle 54, the small residues are prevented from adhering, and the cleanliness of the front surface 70a of the flexographic printing plate precursor 70 can be increased.

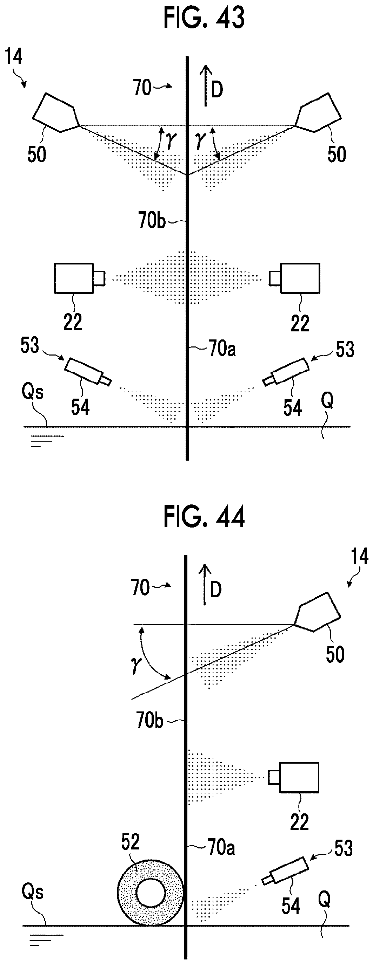

In addition, as shown in Fig. 43, a configuration where the supply units 22, the liquid drain nozzles 50, and the prerinsing nozzles 54 are provided at symmetrical positions with the flexographic printing plate precursor 70 interposed therebetween may be adopted. Accordingly, the small residues can be prevented from adhering to both surfaces of the flexographic printing plate precursor 70, and the cleanliness of both surfaces of the flexographic printing plate precursor 70 can be increased. The prerinsing nozzle 54 facing the back surface 70b of the flexographic printing plate precursor 70 may not be provided. The prerinsing step does not necessarily have to be performed.

As the used washing solution supplied from the prerinsing unit 53 flows into the developing tank 13, a total waste liquid amount can be reduced. In particular, in a case where the transport path is in the up-down direction, an effect of reducing the waste liquid amount is large. For this reason, it is preferable that the used washing solution flows into the developing tank 13 also in the prerinsing step.

In addition, as shown in Fig. 44, a configuration where the brush 52 brought into contact with the back surface 70b of the flexographic printing plate precursor 70 is provided may be adopted in addition to the configuration shown in Fig. 42. Accordingly, in a case where the flexographic printing plate precursor 70 is transported, the brush 52 rotates in a state of being brought into contact with the back surface 70b, and residues such as latex components and rubber components remaining on the back surface 70b of the flexographic printing plate precursor 70 can be removed. Further, the residues that are not completely removed by the brush 52 can also be removed by the supply unit 22 and the liquid drain nozzle 50.

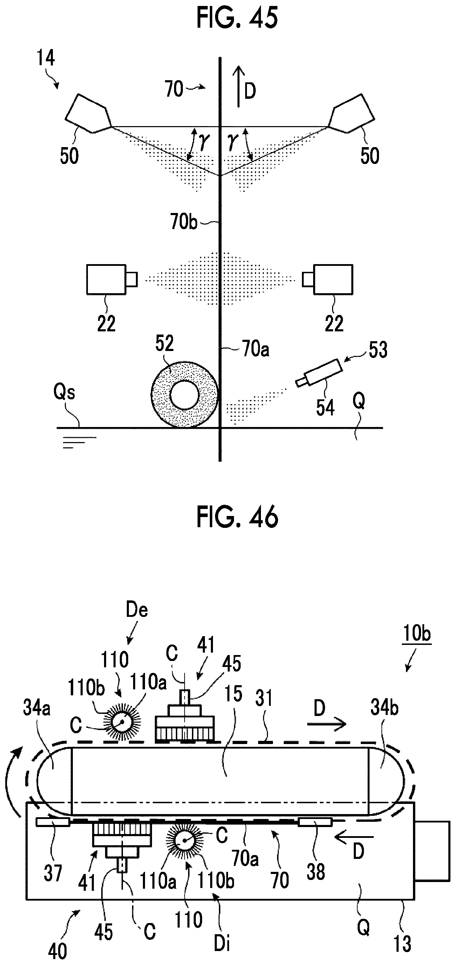

In addition, as shown in Fig. 45, a configuration where the brush 52 brought into contact with the back surface 70b of the flexographic printing plate precursor 70 is provided and the supply unit 22 and the liquid drain nozzle 50 are provided to face the back surface 70b at symmetrical positions with the flexographic printing plate precursor 70 interposed may be adopted in addition to the configuration shown in Fig. 42. Accordingly, in a case where the flexographic printing plate precursor 70 is transported, the brush 52 rotates in a state of being brought into contact with the back surface 70b, and residues such as latex components and rubber components remaining on the back surface 70b of the flexographic printing plate precursor 70 can be removed. Further, the residues that are not completely removed by the brush 52 can also be removed by the supply unit 22 and the liquid drain nozzle 50.

Although the brush 52 is disposed to be brought into contact with the liquid level Qs of the washing solution Q in Figs. 44 and 45, without being limited thereto, the brush 52 may be disposed in a state of being immersed in the washing solution Q.

In addition, the liquid drain nozzle 50 is inclined with respect to the transport direction D of the flexographic printing plate precursor 70, but in addition thereto, may be disposed to be inclined, for example, with respect to the direction DL (see Fig. 3). By making the liquid drain nozzle 50 inclined with respect to the direction DL, the washing solution Q can be collected on one side and be drained out. That is, the washing solution Q can be collectively removed on one side.

### (Other Configurations of Washout Processor)

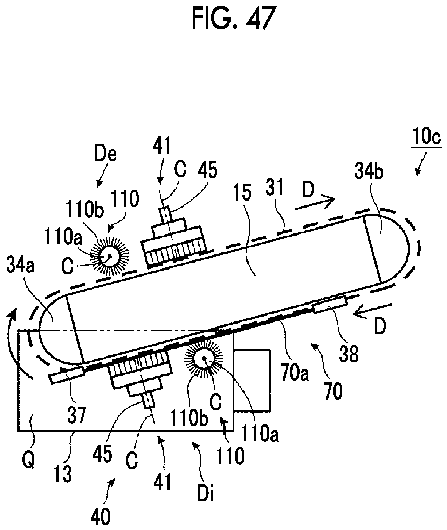

Figs. 46 and 47 are schematic side views showing still another example of the washout processor according to the embodiment of the present invention. In Figs. 46 and 47, the same components as the washout processor 10 shown in Figs. 1 to 3 will be assigned with the same reference numerals, and detailed description thereof will be omitted. In addition, Figs. 46 and 47 simplify washout processors 10b and 10c, respectively.

The washout processor 10b shown in Fig. 46 is different from the washout processor 10 shown in Fig. 1 in terms of a transporting form and disposition of brushes, and the other configurations are the same as the configurations of the washout processor 10 shown in Fig. 1.

The washout processor 10b is in a state where the frame 15 is rotated 90° from the state shown in Fig. 1. In addition, in the washout processor 10b, the roller brush 110 and the brush 41 are disposed on the inlet Di side of the transport path Dp. The roller brush 110 and the brush 41 are disposed on the outlet De side of the transport path Dp. The roller brush 110 is disposed on the downstream side in the transport direction D.

The brush 41 is configured such that the plurality of brushes 41, for example, the four brushes 41 are arranged in a line in the direction DL as shown in Fig. 32.

The roller brush 110 has the same configuration as the roller brush 110 of the developing unit 40 shown in Fig. 33.

The developing tank 13 is disposed on the inlet Di side of the transport path Dp, and the flexographic printing plate precursor 70 is immersed. On the inlet Di side of the transport path Dp, the flexographic printing plate precursor 70 is developed in a state of being immersed in the washing solution Q.

In addition, on the outlet De side of the transport path Dp, the roller brush 110 and the brush 41 are disposed outside the developing tank 13. On the outlet De side of the transport path Dp, for example, the washing solution Q is supplied to the flexographic printing plate precursor 70 so that the flexographic printing plate precursor 70 is developed or the washing solution Q is supplied to the roller brush 110 and the brush 41 so that the flexographic printing plate precursor 70 is developed.

In a state where the frame 15 is rotated 90° from the state shown in Fig. 1, transporting the flexographic printing plate precursor 70 is called horizontal transport.

In addition, the washout processor 10c shown in Fig. 47 is in a state where the frame 15 is inclined from the state shown in Fig. 1. The degree of inclination is approximately 70°. In the washout processor 10c, the inclination of the frame 15 is small compared to the washout processor 10b in which the frame is rotated 90°. The washout processor 10c can make the developing tank 13 small compared to the washout processor 10a. The degree of the inclination of the washout processor 10c in which the frame 15 is inclined from the state shown in Fig. 1 is not particularly limited to approximately 70° as described above unless the washout processor 10 shown in Fig. 1 and the washout processor 10b shown in Fig. 46 are used.

Even in a form other than vertical transport such as the washout processors 10b and 10c, the volumes of the washout processors 10b and 10c are small, and the device configuration is small, so that the space can be saved. Further, the washout processors 10b and 10c can obtain the same effects as in the washout processor 10, which is described above and is shown in Fig. 1.

In the washout processors 10b and 10c, the configuration of the brush of the developing unit 40 is not limited to the configuration shown in Figs. 46 and 47, and the configuration of the brush of the developing unit 40, which is described above and is shown in Figs. 33 to 35, can also be adopted.

### (Transporting Unit)

Although the transporting unit 11 described above, which adopts a winding transmission method in which the gear 30 and the transport chain 31 are used, is described as an example, the transporting unit 11 is not limited thereto. For example, the gear 30 may be changed to a pulley, and the transport chain 31 may be changed to a transport belt. The flexographic printing plate precursor is transported by using a pair of transport belts and fixing each transport belt to the leaders.

In a case of using the transport belts, the transport belts hang parallel to each other. The transport belts are also not particularly limited, and flat belts, V-belts, rib belts, round belts, and toothed belts can be used.

In addition to the above, the transporting unit 11 can use, for example, a winding method of winding a traction member provided at the leader.

In a case of the winding method described above, for example, the traction member (not shown) for transporting the flexographic printing plate precursor 70 is attached to the leader for the flexographic printing plate precursor 70, and the flexographic printing plate precursor 70 is transported along the transport path Dp described above by winding the traction member. The traction member may be a string or may be a strip-shaped member.

### (Flexographic Printing Plate Precursor)

The flexographic printing plate precursor 70 forms a flexographic printing plate used in flexographic printing, and the configuration thereof is not particularly limited. The flexographic printing plate precursor 70 is as thin as several millimeters and has flexibility. Having flexibility means returning from a bent state caused by an acting force to the original state after unloading the force. The size of the flexographic printing plate precursor 70 is, for example, 800 mm × 1,200 mm, and 1,050 mm × 1,500 mm. Since development is performed by moving the brush 41, it is also possible to respond to the large flexographic printing plate precursor 70.

It is preferable that the flexographic printing plate precursor 70 is a flexographic printing plate precursor that can be developed with an aqueous developer of which a main component is water and a flexographic printing plate precursor that is called a water-developing type flexographic printing plate precursor. In this case, the washing solution is the aqueous developer.

A known flexographic printing plate precursor that can be developed with the aqueous developer is usable as the flexographic printing plate precursor 70, and a flexographic plate material for computer to plate (CTP) having a surface to which a black layer is applied may be used as the flexographic printing plate precursor 70.

### Hereinafter, the washing solution will be described.

### <Washing Solution>

The washing solution is preferably a water-based washing solution, may be a solution consisting of only water, and may be an aqueous solution which contains 50% by mass or more of water and to which a water soluble compound is added. Examples of the water soluble compound include surfactants, acids, and alkalis. The water-based washing solution described above corresponds to the aqueous developer.

Examples of the surfactant include anionic surfactants, nonionic surfactants, cationic surfactants, and amphoteric surfactants, and among the surfactants, anionic surfactants are preferable.

Specific examples of the anionic surfactant include aliphatic carboxylates such as sodium laurate and sodium oleate; higher alcohol sulfate ester salts such as sodium lauryl sulfate, sodium cetyl sulfate, and sodium oleyl sulfate; polyoxyethylene alkyl ether sulfates such as sodium polyoxyethylene lauryl ether sulfate; polyoxyethylene alkyl allyl ether sulfates such as sodium polyoxyethylene octylphenyl ether sulfate and sodium polyoxyethylene nonylphenyl ether sulfate; alkyl sulfonates such as alkyldiphenyl ether disulfonate, sodium dodecyl sulfonate, and sodium dialkyl sulfosuccinate; alkyl allyl sulfonates such as alkyl disulfonate, sodium dodecylbenzene sulfonate, sodium dibutylnaphthalene sulfonate, and sodium triisopropylnaphthalene sulfonate; higher alcohol phosphate ester salts such as lauryl phosphate monoester disodium and sodium lauryl phosphate diester; polyoxyethylene alkyl ether phosphoric acid ester salts such as polyoxyethylene lauryl ether phosphoric acid monoester disodium and polyoxyethylene lauryl ether phosphoric acid diester sodium. These may be used alone or may be used in combination of two or more types. Although a sodium salt is given as a specific example, it is not particularly limited to the sodium salt, and the same effect can be obtained with a calcium salt, an ammonia salt, or the like.

Specific examples of the nonionic surfactant include polyoxyethylene alkyl ethers such as polyoxyethylene oleyl ether and polyoxyethylene lauryl ether, polyoxyethylene polyoxypropylene glycols including polyoxyethylene alkyl phenyl ethers such as polyoxyethylene nonylphenyl ether and polyoxyethylene octylphenyl ether, mono and diesters of polyethylene glycol and fatty acids such as polyethylene glycol monostearate, polyethylene glycol monooleate, and polyethylene glycol dilaurate, fatty acids and sorbitan esters such as sorbitan monolaurate and sorbitan monooleate, esters of sorbitan polyoxyethylene adducts and fatty acids such as polyoxyethylene sorbitan monolaurate, polyoxyethylene sorbitan monostearate, and polyoxyethylene sorbitan trilaurate, esters fatty acids and sorbitol such as sorbitol monopalmitate and sorbitol dilaurate, esters of sorbitol polyoxyethylene adducts and fatty acids such as polyoxyethylene sorbitol monostearate and polyoxyethylene sorbitol diolate, esters of fatty acids and pentaerythritol such as pentaerythritol monostearate, esters of fatty acids and glycerin such as glycerin monolaurate, fatty acid alkanolamides such as lauric acid diethanolamide and lauric acid monoethanolamide, amine oxides such as lauryl dimethylamine oxide, fatty acid alkanolamines such as stearyl diethanolamine, polyoxyethylene alkylamines, triethanolamine fatty acid esters, alkaline salt compounds such as phosphates, carbonates, and silicates. These may be used alone or may be used in combination of two or more types.

Specific examples of the cationic surfactant include primary, secondary and tertiary amine salts such as monostearylammonium chloride, distearylammonium chloride, and tristearylammonium chloride, quaternary ammonium salts such as stearyltrimethylammoum chloride, distearyldimethylammonium chloride, and stearyldimethylbenzylammonium chloride, alkylpyridinium salts such as N-cetylpyridinium chloride and N-stearylpyridinium chloride, N, N dialkyl morpholinium salts, fatty acid amide salts of polyethylene polyamines, acetic acids of urea compounds of amides of aminoethylethanolamine and stearic acid, and 2-alkyl-1-hydroxyethylimidazolinium chloride. These may be used alone or may be used in combination of two or more types.

Specific examples of the amphoteric surfactant include amino acid types such as sodium laurylamine propionate, carboxybetaine types such as lauryldimethylbetaine and lauryldihydroxyethylbetaine, sulfobetaine types such as stearyldimethylsulfoethyleneammonium betaine, imidazolenium betaine types, and lecithin. These may be used alone or may be used in combination of two or more types.

Specific examples of the acid include inorganic acids or organic acids such as hydrochloric acid, sulfuric acid, nitric acid, phosphoric acid, formic acid, acetic acid, oxalic acid, succinic acid, citric acid, malic acid, maleic acid, and paratoluenesulfonic acid.

Specific examples of the alkali include lithium hydroxide, sodium hydroxide, magnesium hydroxide, potassium hydroxide, calcium hydroxide, calcium oxide, sodium carbonate, sodium hydrogencarbonate, and calcium carbonate.

Hereinafter, the fatiqued developer will be described in detail.

### <Fatiqued Developer>

The fatiqued developer is not particularly limited insofar as the fatiqued developer is a washing solution containing solid substances generated by removing the non-exposed portion of the flexographic printing plate precursor due to development using the washing solution described above, that is, a washing solution containing an uncured resin. However, a fatiqued developer containing a known photosensitive resin composition of the related art for forming a general photosensitive resin layer may be included.

The uncured resin removed through development may be a photosensitive resin contained in the photosensitive resin composition.

In addition, since it is preferable to set a fatiqued developer in a case of developing under a laser ablation masking (LAM) method as a processing target, it is preferable that the uncured resin removed through development is the photosensitive resin contained in the photosensitive resin composition.

In addition, since examples of such a photosensitive resin composition include a composition containing a polymerization initiator, a polymerizable compound, a polymerization inhibitor, and a plasticizer, in addition to the photosensitive resin, the fatiqued developer may contain a polymerization initiator, a polymerizable compound, a polymerization inhibitor, a plasticizer, and the like, in addition to the uncured resin.

### <Uncured Resin>

The uncured resin contained in the fatiqued developer is solid substances generated by removing the non-exposed portion. Examples of the uncured resin contained in the fatiqued developer include water-dispersible latex, rubber components, polymer components, and uncrosslinked ethylenically unsaturated compounds (polymers).

Examples of the water-dispersible latex include water-dispersed latex polymers including water-dispersed latex such as polybutadiene latex, natural rubber latex, styrene-butadiene copolymer latex, acrylonitrile-butadiene copolymer latex, polychloroprene latex, polyisoprene latex, polyurethane latex, methyl methacrylate-butadiene copolymer latex, vinyl pyridine copolymer latex, butyl polymer latex, thiocol polymer latex, and acrylate polymer latex and polymers obtained by copolymerizing these polymers with other components such as acrylic acid or methacrylic acid.

Examples of the rubber component include butadiene rubber, isoprene rubber, styrene-butadiene rubber, acrylonitrile rubber, acrylonitrile butadiene rubber, chloroprene rubber, polyurethane rubber, silicon rubber, butyl rubber, ethylene-propylene rubber, and epichlorohydrin rubber.

The polymer component may be hydrophilic or may be hydrophobic, and specific examples thereof include a polyamide resin, an unsaturated polyester resin, an acrylic resin, a polyurethane resin, a polyester resin, and polyvinyl alcohol resin.

The solid substances having a specific gravity lower than the washing solution are, for example, photosensitive resins such as rubber components and latex.

The solid substances having a specific gravity higher than the washing solution are, for example, components of overcoat layers such as carbon.

Examples of the ethylenically unsaturated compound (polymer) include (meth) acrylic modified polymers having an ethylenically unsaturated bond in the molecule.

Examples of the (meth) acrylic modified polymer include (meth) acrylic modified butadiene rubber and (meth) acrylic modified nitrile rubber.

"(Meth) acrylic" is a notation representing acrylic or methacrylic, and "(meth) acrylate" to be described later is a notation representing acrylate or methacrylate.

The uncured resin contained in the fatiqued developer is not particularly limited, but is preferably 70% by mass or less, and more preferably 35% by mass or less.

### <Polymerization Initiator>

The polymerization initiator that may be contained in the fatiqued developer is preferably a photopolymerization initiator.

Examples of the photopolymerization initiator described above include alkylphenones, acetophenones, benzoin ethers, benzophenones, thioxanthones, anthraquinones, benzyls, and biacetyls, and among them, alkylphenones are preferable.

Specific examples of the alkylphenones photopolymerization initiators include 2,2-dimethoxy-1 ,2-diphenylethane-1-one, 1-hydroxy-cyclohexyl-phenyl-ketone, and 2-hydroxy-2-methyl-1-phenyl-propane-1-one.

The concentration of the polymerization initiator that may be contained in the fatiqued developer is not particularly limited, but is preferably 2.0% by mass or less, and more preferably 1.0% by mass or less.

### <Polymerizable Compound>

Examples of the polymerizable compound that may be contained in the fatiqued developer include ethylenically unsaturated compounds that correspond to so-called monomer components other than the ethylenically unsaturated compounds (polymers) described above.

The ethylenically unsaturated compound may be a compound having one ethylenically unsaturated bond or may be a compound having two or more ethylenically unsaturated bonds.

Specific examples of the compound having one ethylenically unsaturated bond include (meth) acrylate having a hydroxyl group such as 2-hydroxyethyl (meth) acrylate, 2-hydroxypropyl (meth) acrylate, 2-hydroxybutyl (meth) acrylate, 3-chloro-2-hydroxypropyl (meth) acrylate, and β-hydroxy-β'-(meth) acryloyloxyethyl phthalate; alkyl (meth) acrylates such as methyl (meth) acrylate, ethyl (meth) acrylate, propyl (meth) acrylate, butyl (meth) acrylate, isoamyl (meth) acrylate, 2-ethylhexyl (meth) acrylate, lauryl (meth) acrylate, and stearyl (meth) acrylate; cycloalkyl (meth) acrylates such as cyclohexyl (meth) acrylate; alkyl halogenated (meth) acrylates such as chloroethyl (meth) acrylate and chloropropyl (meth) acrylate; alkoxyalkyl (meth) acrylates such as methoxyethyl (meth) acrylate, ethoxyethyl (meth) acrylate, and butoxyethyl (meth) acrylate; phenoxyalkyl (meth) acrylates such as phenoxyethyl acrylate and nonylphenoxyethyl (meth) acrylate; alkoxyalkylene glycol (meth) acrylates such as ethoxydiethylene glycol (meth) acrylate, methoxytriethylene glycol (meth) acrylate, and methoxydipropylene glycol (meth) acrylate; 2,2-dimethylaminoethyl (meth) acrylate, 2,2-diethylaminoethyl (meth) acrylate, 2-hydroxyethyl (meth) acrylate, and 3-chloro-2-hydroxypropyl (meth) acrylate.

Specific examples of the ethylenically unsaturated compound having two or more ethylenically unsaturated bonds include alkyldiol di (meth) acrylates such as 1,9-nonane diol di (meth) acrylate; polyethylene glycol di (meth) acrylates such as diethylene glycol di (meth) acrylate; polypropylene glycol di (meth) acrylates such as dipropylene glycol di (meth) acrylate; polyvalent (meth) acrylates obtained by addition reaction of a compound having an ethylenically unsaturated bond, such as unsaturated carboxylic acid and unsaturated alcohol, and active hydrogen with trimethylolpropane tri (meth) acrylate, pentaerythritol tri (meth) acrylate, pentaerythritol tetra (meth) acrylate, glycerol tri (meth) acrylate, and ethylene glycol diglycidyl ether; polyvalent (meth) acrylates obtained by addition reaction of an unsaturated epoxy compound such as glycidyl (meth) acrylate with a compound having active hydrogen such as carboxylic acid and amine; polyvalent (meth) acrylamides such as methylenebis (meth) acrylamide; polyvalent vinyl compounds such as divinylbenzene.

The concentration of the polymerizable compound that may be contained in the fatiqued developer is not particularly limited, but is preferably 30.0% by mass or less, and more preferably 15.0% by mass or less.

### <Polymerization Inhibitor>

Specific examples of the polymerization inhibitor that may be contained in the fatiqued developer include hydroquinone monomethyl ether, p-methoxyphenol, di-t-butyl-p-cresol, pyrogallol, t-butylcatechol, benzoquinone, 4,4'-thiobis (3-methyl-6-t-butylphenol), 2,2'-methylenebis (4-methyl-6-t-butylphenol), and N-nitrosophenylhydroxyamine first cerium salt.

The concentration of the polymerization inhibitor that may be contained in the fatiqued developer is not particularly limited, but is preferably 0.3% by mass or less, and more preferably 0.15% by mass or less.

### <Plasticizer>

Examples of the plasticizer that may be contained in the fatiqued developer include liquid rubber, oil, polyester, and phosphoric acid-based compounds.

Specific examples of the liquid rubber include liquid polybutadiene, liquid polyisoprene, and those modified with maleic acid or an epoxy group.

Specific examples of the oil include paraffin oil, naphthenic oil, and aroma oil.

Specific examples of the polyester include adipic acid-based polyester.

Specific examples of the phosphoric acid-based compound include phosphoric acid ester.

The concentration of the plasticizer that may be contained in the fatiqued developer is not particularly limited, but is preferably 30% by mass or less, and more preferably 15% by mass or less.

The present invention is basically configured as described above. Although the washout processor and the washing method according to the embodiment of the present invention have been described in detail hereinbefore, the present invention is not limited to the embodiment described above, and it is evident that various improvements or changes may be made without departing from the gist of the present invention.

### Examples

Hereinafter, the present invention will be described in further detail with reference to examples. Materials, reagents, amounts used, substance amounts, ratios, the content of processing, processing procedures, and the like shown in the examples below can be changed as appropriate without departing from the spirit of the present invention. Therefore, the scope of the present invention is not to be construed as being limited by specific examples described below.

In the present example, in the washout processor of Examples 1 to 10, on-plate residues, brush marks, independent dots, development unevenness, brush costs, and development speeds are evaluated.

Devices and chemicals used in Examples 1 to 10 are as follows.

### <Imaging Machine>

· CDI Spark 4835 Inline (manufactured by ESKO)

### <Exposure Machine>

. Ultraviolet rays exposure machine Concept 302 ECDLF (product name) (manufactured by Glunz & Jensen)

### <Flexographic Printing Plate Precursor>

· FLENEX FW-L (manufactured by Fujifilm Global Graphic Systems)
· Plate size 800 mm × 1200 mm

### <Washing Solution>

· Aqueous solution (concentration is 0.5% by mass) of Finish Power & Pure Powder SP (manufactured by Lekit·Benquiser Japan)
· Liquid temperature 50°C

### <Imagewise Exposure of Flexographic Printing Plate Precursor>

Back exposure was performed by exposing the flexographic printing plate precursor described above from the back surface of the flexographic printing plate precursor with energy of 80 W for 10 seconds using the ultraviolet rays exposure machine described above. After then, main expose was performed by imaging a mask layer by ablation using the imaging machine described above and exposing from a front surface (a back surface of the back surface) with 80 W for 1,000 seconds. The flexographic printing plate precursor on which main exposure was performed was used as the imagewise exposed flexographic printing plate precursor.

In the imagewise exposed flexographic printing plate precursor, an independent dot pattern corresponding to independent dots having sizes of 100 µm, 120 µm, and 150 µm was exposed.

Hereinafter, on-plate residues, brush marks, independent dots, development unevenness, brush costs, and development speeds will be described.

### [On-plate Residues]

The flexographic printing plate precursor after development treatment was dried and postexposed.

After the drying and the postexposure described above, removal was performed on the flexographic printing plate precursor using tape, and all those which could not be removed were defined as on-plate residues.

The presence or absence of on-plate residues that had a size of 100 µm or more and could not be removed using tape was checked, and the number of on-plate residues per 1 m² was evaluated.

As a result of a visual plate surface inspection of the processed flexographic printing plate precursor, the flexographic printing plate precursor was evaluated as "A" in a case where the number of on-plate residues having a size of 100 µm or more was less than 1 per 1 m², that is, zero.

The flexographic printing plate precursor was evaluated as "B" in a case where the number of on-plate residues having a size of 100 µm or more was 1 to 2 per 1m².

The flexographic printing plate precursor was evaluated as "C" in a case where the number of on-plate residues having a size of 100 µm or more was three or more per 1m².

### [Brush Marks]

The flexographic printing plate precursor after development treatment was dried and postexposed.

After the drying and the postexposure described above, brush marks on the flexographic printing plate precursor were visually checked. The fact that the brush marks could be checked means that printing was performed, and a printed material was visually evaluated.

The flexographic printing plate precursor was evaluated as "A" in a case where no brush marks could be checked.

The flexographic printing plate precursor was evaluated as "B" in a case where brush marks could be checked but no brush marks could be checked on the printed material.

The flexographic printing plate precursor was evaluated as "C" in a case where brush marks could be checked but the brush marks could be checked on the printed material.

### [Independent Dots]

The flexographic printing plate precursor after development treatment was dried and postexposed.

After the drying and the postexposure described above, whether an independent dot pattern corresponding to independent dots having sizes of 100 µm, 120 µm, and 150 µm were formed as independent dots on the flexographic printing plate precursor was checked using an optical microscope.

An independent dot pattern was evaluated as "A" in a case where all of the independent dots having sizes of 100 µm, 120 µm, and 150 µm were checked.

An independent dot pattern was evaluated as "B" in a case where among independent dots having sizes of 100 µm, 120 µm, 150 µm, no independent dot having a size of 100 µm was checked, and independent dots having sizes of 120 µm and 150 µm could be checked.

An independent dot pattern was evaluated as "C" in a case where among independent dots having sizes of 100 µm, 120 µm, 150 µm, no independent dots having sizes of 100 µm and 120 µm were checked, and an independent dot having a size of 150 µm could be checked.

### [Development Unevenness]

The flexographic printing plate precursor after development treatment was dried and postexposed.

Development was performed on a flexographic printing plate precursor having a thickness of 1.7 mm up to a thickness of 1.1 mm (1,100 µm).

An average value of measurement values obtained by measuring eight points corresponding to a floor area thickness of the flexographic printing plate precursor was used. A floor area thickness and an image area height were measured using Dial Thickness Gauge/7321 manufactured by Mitutoyo Corporation.

With respect to the average value of the eight points described above of 1,100 µm, development unevenness within a range of 1,070 µm to 1,130 µm was evaluated as "A".

With respect to the average value of the eight points described above of 1,100 µm, development unevenness that exceeded the range of 1,070 µm to 1,130 µm and was within a range of 1,050 µm to 1,150 µm was evaluated as "B".

With respect to the average value of the eight points described above of 1,100 µm, development unevenness that exceeded the range of 1,050 µm to 1,150 µm and was within a range of 1,070 µm to 1,170 µm was evaluated as "C".

### [Brush Costs]

Brush costs were evaluated based on the costs of brushes used.

Brush costs which were less than 150, 000 yen were evaluated as "A".

Brush costs which were 150, 000 yen or more and less than 300,000 were evaluated as "B".

Brush costs which were 300, 000 yen or more were evaluated as "C".

### [Development Speeds]

Regarding development speeds, development of the flexographic printing plate precursor having a thickness of 1.7 mm up to a thickness of 1.1 mm (1,100 µm) was defined as one-plate development.

Evaluation was made on how many times of the one-plate development described above were possible per hour.

A development speed was evaluated as "A" in a case of 4 plate/hour or more.

A development speed was evaluated as "B" in a case of 2 plate/hour or more and less than 4 plate/hour.

A development speed was evaluated as "C" in a case of less than 2 plate/hour.

Next, Examples 1 to 10 will be described.

### (Example 1)

In Example 1, the washout processor 10 (see Fig. 1) having the developing unit 40 shown in Fig. 33 developed the imagewise exposed flexographic printing plate precursor described above with a configuration where the roller brush 112 was not provided, the roller brush 110 used as Brush 1 on the inlet side, and the brush 41, which was a cup brush, used as Brush 2 on the outlet side.

Brush 1 on the inlet side corresponds to the roller brush 110 disposed at a position on the inlet Di side shown in Fig. 33. Brush 2 on the outlet side corresponds to the brush 41 disposed at a position on the outlet De side shown in Fig. 33.

In Example 1, a brush having an outer diameter of 70 mm, a length of 1,200 mm, and a bristle length of 16 mm was used as the roller brush. Bristles of the roller brush were planted in an area of 80% of a substrate.

Five cup brushes were disposed in a direction orthogonal to the transport direction, that is, a width direction of the flexographic printing plate precursor. A brush having a diameter of 260 mm and a bristle length of 16 mm was used as the cup brush. In the cup brush, bristles were not planted in a region 30 mm from the center, and bristles were planted in an area of 80% of the substrate.

In addition, during development, the cup brush was moved in the width direction of the flexographic printing plate precursor with a swing width of 50 mm. The swing width was approximately 19.3% of the diameter of the brush.

### (Example 2)

Example 2 was the same as Example 1 except that the swing width of the cup brush, which was Brush 2 on the outlet side, was 90 mm compared to Example 1. The swing width was approximately 34.6% of the diameter of the brush.

### (Example 3)

Example 3 was the same as Example 1 except that the swing width of the cup brush, which was Brush 2 on the outlet side, was 130 mm compared to Example 1. The swing width was approximately 50% of the diameter of the brush.

### (Example 4)

Example 4 was the same as Example 1 except that the bristle length of the cup brush, which was Brush 2 on the outlet side, was 3 mm, and the swing width was 130 mm compared to Example 1. The swing width was approximately 50% of the diameter of the brush.

### (Example 5)

Example 5 was the same as Example 1 except that the bristle length of the cup brush, which was Brush 2 on the outlet side, was 26 mm, and the swing width was 130 mm compared to Example 1. The swing width was approximately 50% of the diameter of the brush.

### (Example 6)

Example 6 was the same as Example 1 except that a region where bristles of the cup brush, which was Brush 2 on the outlet side, were not planted was 10 mm from the center, and the swing width was 130 mm compared to Example 1. The swing width was approximately 50% of the diameter of the brush.

### (Example 7)

Example 7 was the same as Example 6 except that the configuration of the washout processor 10 (see Fig. 1) having the developing unit 40 shown in Fig. 33 was adopted, and the roller brush 112 was included as Brush 3 on the outlet side compared to Example 6.

A brush having an outer diameter of 70 mm, a length of 1,200 mm, and a bristle length of 20 mm was used as the roller brush 112, which was Brush 3 on the outlet side. Bristles of the roller brush were planted in an area of 80% of a substrate.

### (Example 8)

In Example 8, the washout processor 10 (see Fig. 1) having the developing unit 40 shown in Fig. 34 developed the imagewise exposed flexographic printing plate precursor described above with a configuration where the roller brush 112 was not provided, the flat brush 114 used as Brush 1 on the inlet side, and the brush 41, which was a cup brush, used as Brush 2 on the outlet side.

A brush having a length of 1,100 mm, a width of 1,100 mm, and a bristle length of 16 mm was used as the flat brush. Bristles of the flat brush were planted in an area of 80% of a substrate.

In addition, during development, the flat brush was moved in the width direction of the flexographic printing plate precursor with a swing width of 60 mm.

The same cup brush as in Example 1 was used, and the swing width was set to 130 mm. The swing width was approximately 50% of the diameter of the brush.

### (Example 9)

In Example 9, the washout processor 10 (see Fig. 1) having the developing unit 40 shown in Fig. 35 developed the imagewise exposed flexographic printing plate precursor described above with a configuration where the roller brush 112 was not provided, the brush 41, which was a cup brush, used as Brush 1 on the inlet side, and the brush 41, which was a cup brush, used as Brush 2 on the outlet side.

The same cup brush of Example 3, which was Brush 2 on the outlet side, was used as the cup brush, which was Brush 1 on the inlet side. The swing width was approximately 50% of the diameter of the brush.

The cup brush, which was Brush 2 on the outlet side, was the same as Brush 2 on the outlet side in Example 3 except that the area of bristles was 50% compared to Brush 2 on the outlet side in Example 3. The swing width was approximately 50% of the diameter of the brush.

### (Example 10)

Example 10 was the same as Example 9 except that the cup brush, which was Brush 1 on the inlet side, and the cup brush, which was Brush 2 on the outlet side, did not have a region where bristles were not planted compared to Example 9.

**[Table 1]**

| | Brush 1 (Inlet side) | | | | | Brush 2 (Outlet side) | | | | | Brash 3 (Outlet side) | | |
|---|---|---|---|---|---|---|---|---|---|---|---|---|---|
| | Shape | Area of bristles (%) | Swing width (mm) | Length of bristles (mm) | Region where there are no bristles | Shape | Area of bristles (%) | Swing width (mm) | Length of bristles (mm) | Region where there are no bristles | Shape | Area of bristles (%) | Length of bristles (mm) |
| Example 1 | Roller | 80 | 0 | 16 | - | Cup | 80 | 50 | 16 | 30 mm from center | - | - | - |
| Example 2 | Roller | 80 | 0 | 16 | - | Cup | 80 | 90 | 16 | 30 mm from center | - | - | - |
| Example 3 | Roller | 80 | 0 | 16 | - | Cup | 80 | 130 | 16 | 30 mm from center | - | - | - |
| Example 4 | Roller | 80 | 0 | 16 | - | Cup | 80 | 130 | 3 | 30 mm from center | - | - | - |
| Example 5 | Roller | 80 | 0 | 16 | - | Cup | 80 | 130 | 26 | 30 mm from center | - | - | - |
| Example 6 | Roller | 80 | 0 | 16 | - | Cup | 80 | 130 | 16 | 30 mm from center | - | - | - |
| Example 7 | Roller | 80 | 0 | 16 | - | Cup | 80 | 130 | 16 | 30 mm from center | Roller | 80 | 20 |
| Example 8 | Flat | 80 | 60 | 16 | - | Cup | 80 | 130 | 16 | 30 mm from center | - | - | - |
| Example 9 | Cup | 80 | 130 | 16 | 30 mm from center | Cup | 50 | 130 | 16 | 30 mm from center | - | - | - |
| Example 10 | Cup | 80 | 130 | 16 | - | Cup | 50 | 130 | 16 | - | - | - | - |

**[Table 2]**

| | Evaluation | | | | | |
|---|---|---|---|---|---|---|
| | On-plate residues | Brush marks | Independent small dots | Development unevenness | Brush costs | Development speed |
| Example 1 | A | A | A | B | A | B |
| Example 2 | A | A | A | A | A | B |
| Example 3 | A | A | A | A | A | B |
| Example 4 | A | A | B | A | A | A |
| Example 5 | A | A | A | A | A | B |
| Example 6 | B | A | B | A | A | B |
| Example 7 | A | A | B | A | A | B |
| Example 8 | A | A | A | A | B | A |
| Example 9 | A | A | A | A | A | A |
| Example 10 | A | A | B | A | A | B |

As shown in Table 2, in Examples 1 to 10, good results were obtained with respect to all of on-plate residues, brush marks, independent dots, development unevenness, brush costs, and development speeds.

From a comparison between Example 6 and Example 7 in which the presence or absence of Brush 3 on the outlet side was different, on-plate residues were more decreased by providing Brush 3 on the outlet side.

From Examples 3 to 5, Example 3 within a range where the bristle length was preferable had good evaluation of independent dots compared to Example 4 in which the bristles were short. In addition, Example 3 within the range where the bristle length was preferable had good evaluation of the development speed compared to Example 5 in which bristles were long.

From a comparison among Examples 1 to 7, Example 8, and Examples 9 and 10, a combination of the roller brush and the cup brush or a combination of the cup brush and the cup brush was even better in terms of brush costs. The best results were obtained with the combination of the cup brush and the cup brush.

### Explanation of References

10, 10a, 10b: washout processor
11: transporting unit
12: developing portion
13: developing tank
14: rinsing unit
15: frame
15a: member
15b: beam member
17: connecting pipe
18: processing unit
19: saucer
20: pipe
21: rinsing liquid supply unit
21a: supply pipe
21b: valve
22: supply unit
23: solid substance
24: separation membrane
26: driving unit
27: driving shaft portion
29, 29b: pulley
29a: transmission belt
30: gear
30a: shaft
31: transport chain
31b: fixing unit
32: transport driving unit
33: tension adjusting unit
34a, 34b: turn bar
35: back plate portion
35c: opening portion
36: nip roller
37: leading end leader
37a, 38a: base
37b, 38b: bending portion
37c, 38c: attaching portion
37d, 38d: pin
37e: base
37f: barb
38: trailing end leader
39: leader mechanism portion
39a: frame material
39b, 88, 89, 94: elastic member
40: developing unit
41, 52: brush
41a: substrate
41b: bristle
41c: distal end surface
42: guide roller
45: rotation shaft portion
45a: rotation shaft portion
46: supply unit
47: supply pipe
50: liquid drain nozzle
53: prerinsing unit
54: prerinsing nozzle
60: feeding device
60a: drive roller
60b:driven roller
60c: conveyor belt
61: guide
61a, 61b: guide plate
62, 63: sensor
64: attachment and detachment unit
65: plate attachment portion
66: plate detachment portion
70: flexographic printing plate precursor
70a: front surface
70b: back surface
70c: leading end
70d: trailing end
80, 81: shaft joint portion
82: first member
84: second member
85: ball
86: first flange
87: second flange
90: pressing unit
92: case
95: fixing wall
100: driving unit
102: pushing portion
103: concave portion
104: driving unit
105: extrusion portion
110, 112: roller brush
110a, 112a, 114a: substrate
110b, 112b, 114b: bristle
114: flat brush
114a: substrate
114b: bristle
130: heater
132: partition member
132a: end part
140: pipe
140a: linear part
140b: bending part
142: block
143: heating heater
C: rotation axis
D: transport direction
D₁: first moving direction
D₂: second moving direction
DB: diameter
d_{B}: radius
Dc: drive shaft
De: outlet
Di: inlet
DL: direction
Dp: transport path
Dpc: curved transport passage
Dps: linear transport passage
Eₘ: attachment and detachment station
Hₘ: operator
Mb: swing width
Q: washing solution
Qs: liquid level
Qw: fatiqued developer
r: rotation direction
γ: nozzle angle
θ: angle

## Claims

1. A washout processor that performs development using a washing solution while transporting an imagewise exposed flexographic printing plate precursor, the washout processor comprising:
a leader that fixes both of a leading end and a trailing end of the flexographic printing plate precursor; and
a tension applying unit that applies tension to the flexographic printing plate precursor.

2. The washout processor according to claim 1, further comprising:
a developing portion that performs the development by removing a non-exposed portion of the flexographic printing plate precursor using the washing solution,
wherein the developing portion has
at least one cup brush that is used in the development, and
a driving unit that moves the cup brush in a width direction of the flexographic printing plate precursor with respect to a transport direction of the flexographic printing plate precursor.

3. The washout processor according to claim 2,
wherein the developing portion has at least two types of brushes used in the development, and
among the at least two types of brushes, one type is a brush disposed in a direction perpendicular to a rotation axis with respect to the flexographic printing plate precursor.

4. The washout processor according to claim 2 or 3,
wherein the driving unit moves the cup brush in the width direction of the flexographic printing plate precursor by a distance of one third or more of a diameter of the cup brush.

5. The washout processor according to any one of claims 2 to 4,
wherein bristles of the cup brush are bundled on a substrate, and
the bristles are provided in a region other than a region where a radius is within 10 mm with respect to a center of the substrate.

6. The washout processor according to claim 5,
wherein the bristles of the cup brush are provided in a region of 30% or more of the substrate.

7. The washout processor according to any one of claims 2 to 6,
wherein a length of the bristles of the cup brush or the brush is 5 to 25 mm.

8. The washout processor according to any one of claims 2 to 7, further comprising:
a rinsing unit that supplies a rinsing liquid to the developed flexographic printing plate precursor taken out from the developing portion,
wherein the rinsing unit is provided on a downstream side of the developing portion in a traveling direction of the flexographic printing plate precursor.

9. The washout processor according to claim 8, further comprising:
a prerinsing unit that supplies the washing solution to the developed flexographic printing plate precursor, between the rinsing unit and the developing portion.

10. The washout processor according to claim 8 or 9,
wherein the rinsing unit has a jetting type spray nozzle that supplies the rinsing liquid to the developed flexographic printing plate precursor, and
the jetting type spray nozzle has a rinsing liquid supply amount of 0.3 to 7 kg/m² per unit area of the developed flexographic printing plate precursor to which the rinsing liquid is supplied.

11. The washout processor according to any one of claims 8 to 10,
wherein the developing portion performs development using the washing solution stored in a developing tank, and
the rinsing liquid supplied from the rinsing unit to the developed flexographic printing plate precursor flows into the developing tank of the developing portion.

12. The washout processor according to claim 9 or 10,
wherein the developing portion performs development using the washing solution stored in a developing tank, and
the rinsing liquid supplied from the rinsing unit to the developed flexographic printing plate precursor and the washing solution supplied from the prerinsing unit to the developed flexographic printing plate precursor flow into the developing tank of the developing portion.

13. The washout processor according to claim 1, further comprising:
a developing portion that performs the development by removing a non-exposed portion of the flexographic printing plate precursor using the washing solution; and
a rinsing unit that supplies a rinsing liquid to the developed flexographic printing plate precursor taken out from the developing portion,
wherein the rinsing unit is provided on a downstream side of the developing portion in a traveling direction of the flexographic printing plate precursor.

14. The washout processor according to claim 13, further comprising:
a prerinsing unit that supplies the washing solution to the developed flexographic printing plate precursor, between the rinsing unit and the developing portion.

15. The washout processor according to claim 13 or 14,
wherein the rinsing unit has a jetting type spray nozzle that supplies the rinsing liquid to the developed flexographic printing plate precursor, and
the jetting type spray nozzle has a rinsing liquid supply amount of 0.3 to 7 kg/m² per unit area of the developed flexographic printing plate precursor to which the rinsing liquid is supplied.

16. The washout processor according to any one of claims 13 to 15,
wherein the developing portion performs development using the washing solution stored in a developing tank, and
the rinsing liquid supplied from the rinsing unit to the developed flexographic printing plate precursor flows into the developing tank of the developing portion.

17. The washout processor according to claim 14 or 15,
wherein the developing portion performs development using the washing solution stored in a developing tank, and
the rinsing liquid supplied from the rinsing unit to the developed flexographic printing plate precursor and the washing solution supplied from the prerinsing unit to the developed flexographic printing plate precursor flow into the developing tank of the developing portion.

18. The washout processor according to any one of claims 1 to 17,
wherein the tension applying unit makes tension applied to the flexographic printing plate precursor after fixing the flexographic printing plate precursor to the leader higher than tension applied to the flexographic printing plate precursor in a case of fixing the flexographic printing plate precursor.

19. The washout processor according to any one of claims 1 to 18, further comprising:
a curved transport passage through which the flexographic printing plate precursor is transported,
wherein a turn bar that comes into contact with the flexographic printing plate precursor is provided at a bending part composed of the curved transport passage.

20. The washout processor according to any one of claims 1 to 19, further comprising:
an attachment and detachment unit that fixes both of the leading end and the trailing end of the flexographic printing plate precursor to the leader and releases the fixing of the flexographic printing plate precursor by the leader.

21. The washout processor according to claim 19,
wherein the turn bar provided at the curved transport passage moves forward and backward with respect to the curved transport passage.

22. The washout processor according to any one of claims 1 to 21,
wherein the flexographic printing plate precursor is developed by being immersed in the washing solution.

23. The washout processor according to any one of claims 1 to 22, further comprising:
a transport path for the flexographic printing plate precursor that includes the curved transport passage and a linear transport passage,
wherein a transport direction of the flexographic printing plate precursor includes an upward direction and a downward direction.

24. The washout processor according to any one of claims 1 to 23,
wherein the flexographic printing plate precursor is fixed to the leader using a pin.

25. The washout processor according to claim 20,
wherein the flexographic printing plate precursor is fixed using a plurality of pins, and
the attachment and detachment unit has an extrusion portion that removes the pins by pressing a space between the pins of the flexographic printing plate precursor and removes the flexographic printing plate precursor.

26. The washout processor according to claim 24 or 25,
wherein the pin has a barb.

27. The washout processor according to any one of claims 24 to 26,
wherein in the pin, a surface brought into contact with the flexographic printing plate precursor has a resin layer, a plating layer, or a diamond-like carbon layer or a plurality of uneven portions are formed in the surface in contact with the flexographic printing plate precursor.

28. The washout processor according to claim 20,
wherein a back plate portion is provided on a back surface side of the flexographic printing plate precursor, and
in a state where the back plate portion is disposed on the back surface side of the flexographic printing plate precursor, the leading end and the trailing end of the flexographic printing plate precursor are fixed to the leader by the attachment and detachment unit.

29. The washout processor according to any one of claims 1 to 28, further comprising:
a sensor that detects the leader,
wherein the leader is positioned based on detection of the leader by the sensor.

30. A washing method of performing development using a washing solution while transporting an imagewise exposed flexographic printing plate precursor, the washing method comprising:
performing the development by fixing both of a leading end and a trailing end of the flexographic printing plate precursor and applying tension to the flexographic printing plate precursor.

31. The washing method according to claim 30,
wherein tension applied to the flexographic printing plate precursor after fixing the flexographic printing plate precursor is made higher than tension applied to the flexographic printing plate precursor in a case of fixing the flexographic printing plate precursor.

32. The washing method according to claim 30 or 31,
wherein the flexographic printing plate precursor is transported through a transport path including a curved transport passage and a linear transport passage, and a transport direction of the flexographic printing plate precursor includes an upward direction and a downward direction.

33. The washing method according to any one of claims 30 to 32,
wherein the flexographic printing plate precursor is developed by being immersed in the washing solution.

34. The washing method according to any one of claims 30 to 33,
wherein the flexographic printing plate precursor is fixed to the leader using a pin.

35. The washing method according to any one of claims 30 to 34, further comprising:
a rinsing step of supplying a rinsing liquid to the developed flexographic printing plate precursor after a developing step of performing the development.

36. The washing method according to claim 35, further comprising:
a prerinsing step of supplying the washing solution to the developed flexographic printing plate precursor, between the developing step and the rinsing step.

37. The washing method according to claim 35 or 36,
wherein the rinsing step is a step of supplying the rinsing liquid to the developed flexographic printing plate precursor using a jetting type spray nozzle, and
the jetting type spray nozzle has a rinsing liquid supply amount of 0.3 to 7 kg/m² per unit area of the developed flexographic printing plate precursor to which the rinsing liquid is supplied.

38. The washing method according to any one of claims 35 to 37,
wherein in the developing step, the washing solution stored in a developing tank is used, and
in the rinsing step, the rinsing liquid supplied to the developed flexographic printing plate precursor flows into the developing tank.

39. The washing method according to claim 36,
wherein in the developing step, the washing solution stored in a developing tank is used, and
the rinsing liquid supplied to the developed flexographic printing plate precursor in the rinsing step and the washing solution supplied to the developed flexographic printing plate precursor in the prerinsing step flow into the developing tank.
